# EUROPEAN PATENT APPLICATION

(11) **EP 4 679 176 A1**
(43) Date of publication of application: **14.01.2026**
(21) Application number: 24767109.2
(22) Date of filing: 04.03.2024
(51) Int. Cl.: G03F 7/11, C08G 10/02, G03F 7/004, G03F 7/26

(54) **RESIST UNDERLAYER FILM-FORMING COMPOSITION**

(30) Priority: 08.03.2023 JP 2023035490
(71) Applicant: Nissan Chemical Corporation, Tokyo 103-6119 (JP)
(72) Inventor: TOKUNAGA Hikaru, Toyama-shi, Toyama 939-2792 (JP); MITSUTAKE Yuki, Toyama-shi, Toyama 939-2792 (JP)
(74) Representative: Hoffmann Eitle
(86) International application number: PCT/JP2024/008027
(87) International publication number: WO 2024/185741

(57) **Abstract**

Provided is a resist underlayer film-forming composition that, in addition to exhibiting etching resistance and heat resistance, also exhibits various other properties such as curability, amount of sublimate generated, in-plane uniformity of film thickness, planarization, and embeddability. The resist underlayer film-forming composition contains a Novolac resin and a solvent, wherein the Novolac resin contains a structural unit A having an aromatic ring, and the structural unit A contains a unit structure derived from a compound of formula (A0). Also provided are a method for forming a resist pattern and a method for manufacturing a semiconductor device that use said composition. In formula (A0): Ar is a specific aromatic ring moiety constituting a fused ring; n is 1 or 2; Z is a monovalent organic group when n is 1 and a divalent organic group when n is 2; R¹¹ is a hydrogen atom or a specific organic group; and X⁰ represents a single bond, -0-, -S-, -NR¹²-, or -CR¹³R¹⁴-.

## Description

### Technical Field

The present invention relates to a resist underlayer film-forming composition suitable for lithography in semiconductor substrate processing, a resist underlayer film obtained from this composition, a method for forming a resist pattern using this composition, and a method for manufacturing a semiconductor device using this composition.

### Background Art

In the recent years, the semiconductor manufacturing process has been drastically advancing, and improvements of quality and properties of a resist underlayer film have been strongly demanded with the advance (Patent Literatures 1 to 6). In particular, there is a strong demand for etching resistance in resist underlayer films, which are known as high-carbon materials. However, it is extremely difficult to create a material that satisfies both the properties such as curability, in-plane uniformity of film thickness, and planarization, as well as etching resistance, and there is still room for improvement as the material.

### Citation List

### Patent Literature

Patent Literature 1: US 2016/311975 A1
Patent Literature 2: WO 2018/198960 A1
Patent Literature 3: JP 2021-81686 A
Patent Literature 4: JP 2020-105513 A
Patent Literature 5: WO 2013/146670 A1
Patent Literature 6: JP 2016-151024 A

### Summary of Invention

### Technical Problem

Accordingly, an object to be achieved by the present invention is to provide a resist underlayer film-forming composition, which satisfies both the properties such as curability, in-plane uniformity of film thickness, and planarization, as well as etching resistance, a method for forming a resist pattern using this composition, and a method for manufacturing a semiconductor device using this composition.

### Solution to Problem

The present invention includes the following aspects.
[1] A resist underlayer film-forming composition comprising:
   a novolac resin and a solvent,
   the novolac resin comprises a unit structure A having an aromatic ring,
   the unit structure A comprises a unit structure derived from a compound represented by the following formula (A0): 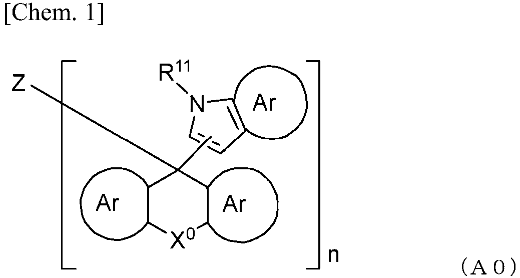
   in the formula (A0),
   R¹¹ each independently represent:
      (i) a hydrogen atom or a methylol group;
      (ii) an aryl group having 6 to 30 carbon atoms; or
      (iii) a linear, branched, or cyclic alkoxymethyl group having 2 to 20 carbon atoms; a linear, branched, or cyclic alkyl group having 1 to 20 carbon atoms; an alkenyl group having 2 to 10 carbon atoms; or an alkynyl group having 2 to 10 carbon atoms,
   provided in the (ii) and (iii), a hydrogen atom in these groups is optionally further substituted with an oxygen-atom-containing substituent, a sulfur-atom-containing substituent, a nitrogen-atom-containing substituent, an aryl group, or a halo group, and in the (iii), a hydrocarbon chain moiety is optionally further interrupted by an oxygen-atom-containing substituent, a sulfur-atom-containing substituent, a nitrogen-atom-containing substituent, or an arylene group,
   Ar is an aromatic ring moiety constituting a condensed ring, each of which is independently the same or different and comprises 1 to 3 benzene rings in the basic skeleton of the aromatic ring moiety, and may optionally have a substituent,
   X⁰ represents a single bond, -O-, -S-, -NR¹²- or -CR¹³R¹⁴-, R¹² is the same as or different from R¹¹, and is the same as the definition of R¹¹, and R¹³ and R¹⁴ each independently represent a hydrogen atom, or a hydrocarbon group having 1 to 6 carbon atoms,
   n is 1 or 2,
   when n is 1, Z represents a monovalent organic group, and when n is 2, Z represents a divalent organic group.
[2] The resist underlayer film-forming composition according to the [1], wherein the formula (A0) is represented by the following formula (A01): 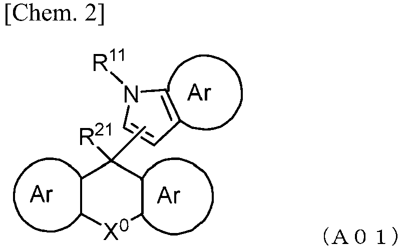 in the formula (A01), R¹¹, Ar and X⁰ are the same as defined in claim 1,
   R²¹ is an aryl group having 6 to 30 carbon atoms; an alkenyl group having 2 to 10 carbon atoms; or an alkynyl group having 2 to 10 carbon atoms.
[3] The resist underlayer film-forming composition according to the [1] or [2], wherein the Ar and the pyrrole ring moiety in the formula (A0) is optionally substituted with:
   (iv) a hydroxy group, a nitro group, a cyano group, a carboxyl group, a trifluoromethyl group, an amino group, a monosubstituted amino group, a disubstituted amino group, or a halo group;
   (v) an aryloxy group having 6 to 15 carbon atoms; an arylalkoxy carbonyl group having 8 to 15 carbon atoms; an aryloxycarbonyl group having 7 to 15 carbon atoms; or an aryl group having 6 to 30 carbon atoms, or
   (vi) an acyl group having 1 to 15 carbon atoms; an alkoxy group having 1 to 15 carbon atoms; an arylalkoxy group having 7 to 15 carbon atoms; an alkoxycarbonyl group having 1 to 15 carbon atoms; a linear, branched, or cyclic alkyl group having 1 to 10 carbon atoms; an alkenyl group having 2 to 20 carbon atoms; or an alkynyl group having 2 to 10 carbon atoms,
   provided in the (v) and (vi), a hydrogen atom in these groups is optionally further substituted with an oxygen-atom-containing substituent, a sulfur-atom-containing substituent, a nitrogen-atom-containing substituent, an aryl group, or a halo group, and in the (vi), a hydrocarbon chain moiety is optionally further interrupted by an oxygen-atom-containing substituent, a sulfur-atom-containing substituent, a nitrogen-atom-containing substituent, or an arylene group.
[4] The resist underlayer film-forming composition according to any one of the [1] to [3], wherein the novolac resin has a composite unit structure A-B represented by the following formula (AB): 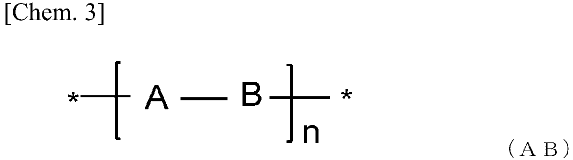 in the formula (AB),
   "n" represents a number of the composite unit structure A-B,
   a unit structure A has a unit structure derived from a compound represented by the formula (A0) defined in claim 1,
   a unit structure B has one or more unit structures having a structure represented by the following formula (B1), (B2), or (B3), and
   "*" represents a bonding site, 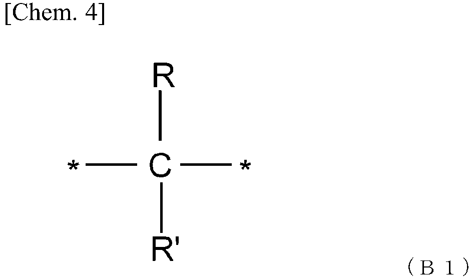
   in the formula (B1),
   R and R' each independently represent a hydrogen atom, an aromatic ring residue having 6 to 30 carbon atoms and optionally having a substituent; a heteroring residue having 3 to 30 carbon atoms and optionally having a substituent; or a linear, branched, or cyclic alkyl group having 10 or less carbon atoms and optionally having a substituent and
   "*" represents a bonding site, 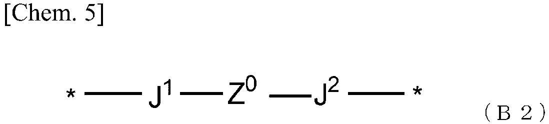
   in the formula (B2),
   Z⁰ represents an aromatic ring residue or an aliphatic ring residue having 6 to 30 carbon atoms and optionally having a substituent; or an organic group in which two aromatic ring residues or aliphatic ring residues are linked via a single bond,
   J¹ and J² each independently represent a direct bond or a divalent organic group optionally having a substituent, and
   "*" represents a bonding site, 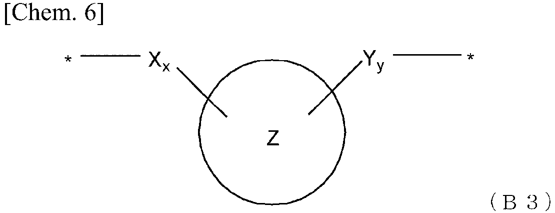
   in the formula (B3),
   Z represents a single ring or a bicyclic, tricyclic, or tetracyclic condensed ring having 4 to 25 carbon atoms and optionally having a substituent, the single ring being a non-aromatic single ring; at least one single ring constituting the bicyclic, tricyclic, or tetracyclic rings is a non-aromatic single ring while the other single ring or rings may be an aromatic single ring or a non-aromatic single ring; the single ring or the bicyclic, tricyclic, or tetracyclic condensed ring may further form a condensed ring with one or more aromatic rings to form a penta- or higher-cyclic condensed ring,
   X and Y are the same or different from each other and represent a -CR³¹R³²-group, R³¹ and R³² are the same or different from each other and represent a hydrogen atom or a hydrocarbon group having 1 to 6 carbon atoms, and
   "x" and "y" respectively represent numbers of X and Y, and each independently represent 0 or 1, 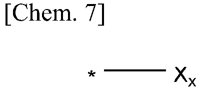
   is bonded to any one carbon atom of the non-aromatic single ring of Z (when x=1), which is referred to as a "carbon atom 1", or extends from the carbon atom 1 (when x=0),

      [Chem. 8] Y_{y}-*
   is bonded to any one carbon atom of the non-aromatic single ring of Z (when y=1), which is referred to as a "carbon atom 2", or extends from the carbon atom 2 (when y=0),
   the carbon atom 1 and the carbon atom 2 may be identical or different from each other, and when the carbon atom 1 and the carbon atom 2 are different, the carbon atom 1 and the carbon atom 2 may be contained in an identical non-aromatic single ring or may be contained in different non-aromatic single rings, and
   "*" represents a bonding site.
[5] The resist underlayer film-forming composition according to any one of the [1] to [4], wherein when all the X⁰ are a single bond, -O-, -S- or -CR¹³R¹⁴-, at least a part of R¹¹; and when at least one X⁰ is -NR¹²-, at least a part of R¹¹ and R¹²; is the following alkynyl group: 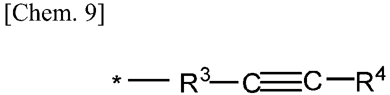 wherein "*" represents a bonding site,
   R³ represents a single bond or a divalent organic group having 1 to 20 carbon atoms, and
   R⁴ represents a hydrogen atom or a monovalent organic group having 1 to 20 carbon atoms.
[6] The resist underlayer film-forming composition according to any one of the [1] to [5], wherein the solvent contains a solvent having a boiling point of 160°C or higher.
[7] The resist underlayer film-forming composition according to any one of the [1] to [6], further comprising an acid and/or a salt thereof, and/or an acid generator.
[8] The resist underlayer film-forming composition according to any one of the [1] to [7], further comprising a crosslinker.
[9] The resist underlayer film-forming composition according to [8], wherein the crosslinker is an aminoplast crosslinker or a phenoplast crosslinker.
[10] The resist underlayer film-forming composition according to any one of the [1] to [9], further comprising a surfactant.
[11] A resist underlayer film on a semiconductor substrate, wherein the resist underlayer film is a baked product of a coating film comprising the resist underlayer film-forming composition according to any one of the [1] to [10].
[12] A method for forming a resist pattern used for manufacturing a semiconductor, the method comprising: a step of applying the resist underlayer film- forming composition according to any one of the [1] to [10] onto a semiconductor substrate; and a step of then baking the composition to form a resist underlayer film.
[13] A method for manufacturing a semiconductor device, the method comprising:
   a step of forming a resist underlayer film from the resist underlayer film-forming composition according to any one of the [1] to [10] on a semiconductor substrate;
   a step of forming a resist film on the resist underlayer film;
   a step of forming a resist pattern in the resist film by irradiation with light or electron beam and development;
   a step of etching the resist underlayer film through the resist pattern; and
   a step of processing the semiconductor substrate through the patterned resist underlayer film.
[14] A method for manufacturing a semiconductor device, the method comprising:
   a step of forming a resist underlayer film from the resist underlayer film-forming composition according to any one of the [1] to [10] on a semiconductor substrate;
   a step of forming a hard mask on the resist underlayer film;
   a step of forming a resist film on the hard mask;
   a step of forming a resist pattern in the resist film by irradiation with light or electron beam and development;
   a step of etching the hard mask through the resist pattern;
   a step of etching the resist underlayer film through the patterned hard mask; and
   a step of processing the semiconductor substrate through the patterned resist underlayer film.
[15] A method for manufacturing a semiconductor device, the method comprising:
   a step of forming a resist underlayer film from the resist underlayer film-forming composition according to any one of the [1] to [10] on a semiconductor substrate;
   a step of forming a hard mask on the resist underlayer film;
   a step of forming a resist film on the hard mask;
   a step of forming a resist pattern in the resist film by irradiation with light or electron beam and development;
   a step of etching the hard mask through the resist pattern;
   a step of etching the resist underlayer film through the patterned hard mask;
   a step of removing the hard mask; and
   a step of processing the semiconductor substrate through the patterned resist underlayer film.
[16] A method for manufacturing a semiconductor device, the method comprising:
   a step of forming a resist underlayer film from the resist underlayer film-forming composition according to any one of the [1] to [10] on a semiconductor substrate;
   a step of forming a hard mask on the resist underlayer film;
   a step of forming a resist film on the hard mask;
   a step of forming a resist pattern in the resist film by irradiation with light or electron beam and development;
   a step of etching the hard mask through the resist pattern;
   a step of etching the resist underlayer film through the patterned hard mask;
   a step of removing the hard mask;
   a step of forming a deposited film (a spacer) on the resist underlayer film cleaned of the hard mask;
   a step of processing the deposited film (the spacer) by etching;
   a step of removing the resist underlayer film having been patterned while leaving the deposited film (the spacer) having been patterned; and
   a step of processing the semiconductor substrate through the deposited film (the spacer) having been patterned.
[17] The method for manufacturing a semiconductor device according to any one of the [14] to [16], wherein the hard mask is formed by applying a composition comprising an inorganic substance or by depositing an inorganic substance.
[18] The method for manufacturing a semiconductor device according to any one of the [13] to [16], wherein the step of forming a resist pattern in the resist film is performed by a nanoimprinting method or a directed self-assembly method.
[19] The method for manufacturing a semiconductor device according to the [15] or [16], wherein the hard mask is removed by etching or with an alkaline chemical solution.

### Advantageous Effects of Invention

Novolak resins containing a unit structure derived from a compound of the formula (A0) have higher etching resistance and better curability as compared to conventional resins. They also have excellent heat resistance due to their extremely high in-plane uniformity during high temperature baking and low amount of sublimate. They also have good planarization and gap-filling properties due to their good coating properties on various deposition substrates.

In addition, as a preferred embodiment, the addition of a different kind of monomer makes it possible to adjust the optical constant appropriately for suppressing reflection during exposure and to adjust the etching resistance.

Further, as a preferred embodiment, when a propargyl group is introduced into a novolak resin containing a unit structure derived from a compound of the formula (A0), it is possible to obtain self-crosslinking properties capable of curing without including a crosslinking agent or an acid catalyst in addition to the above, and thereby, sufficient curability can be obtained not only in an air atmosphere but also in a nitrogen atmosphere.

### Description of Embodiments

### [I. Definitions of Terms]

Definitions of major terms herein about the novolac resin in one aspect of the present invention will be described below. Unless otherwise specifically noticed, the following definitions of terms are applied to the novolac resin.

### (I-1) "Novolac Resin"

The "novolac resin" is used not only in a narrow sense to mean a phenolformaldehyde resin (namely, a novolac-type phenol resin) and an aniline-formaldehyde resin (namely, a novolac-type aniline resin), but also in a broad sense to widely encompass a polymerized polymer typically formed through formation of a covalent bond (such as a substitution reaction, an addition reaction, a condensation reaction, or an addition-condensation reaction) between: an organic compound having a functional group that enables a covalent bond to an aromatic ring [for example, an aldehyde group, a ketone group, an acetal group, a ketal group; a hydroxy group or an alkoxy group bonded to a secondary or a tertiary carbon; a hydroxy group, an alkoxy group, or a halo group bonded to a carbon atom at an α-position of an alkylaryl group (such as a carbon atom at a benzyl position); a carbon-carbon unsaturated bond of divinylbenzene, dicyclopentadiene, or the like]; and an aromatic ring in a compound having an aromatic ring (preferably having a substituent including a heteroatom such as an oxygen atom, a nitrogen atom, and a sulfur atom on the aromatic ring), in the presence of an acid catalyst or under a reaction condition equivalent thereto.

Therefore, the novolac resin referred to herein is a polymer formed in the following manner: the organic compound having a carbon atom derived from the above-described functional group (which may be referred to as "linkage carbon atom") forms a covalent bond, via the linkage carbon atom, to an aromatic ring in the compound having an aromatic ring so that a plurality of the compounds having an aromatic ring are linked.

Terms "unit structure A", "unit structure B", and "unit structure C" are used herein for unit structures to constitute the "novolac resin". The unit structure A is a unit structure derived from the compound having an aromatic ring. The unit structure B is a unit structure derived from the compound having the functional group that can form a covalent bond to the aromatic ring in the unit structure A. The unit structure C is a single unit structure having a bonding pattern equivalent to that of a composite unit structure A-B, and is a unit structure derived from a compound having an aromatic ring and also having the functional group that can form a covalent bond to the aromatic ring in the unit structure A. Since the bonding pattern is the same, the unit structure C may be replaced for the composite unit structure A-B.

### (I-2) "Residue"

The "residue" refers to an organic group in which a hydrogen atom bonded to a carbon atom or a heteroatom (such as a nitrogen atom, an oxygen atom, or a sulfur atom) is replaced for a bonding site. The organic group may be a monovalent group or a polyvalent group. For example, replacement of one hydrogen atom for one bonding site forms a monovalent organic group, and replacement of two hydrogen atoms for bonding sites forms a divalent organic group.

### (I-3) "Aromatic Ring" (Aromatic Group, Aryl Group, and Arylene Group)

The "aromatic ring" is a concept encompassing an aromatic hydrocarbon ring, an aromatic heteroring, and a residue thereof [which may be referred to as "aromatic group", "aryl group" (in a case of a monovalent group), or "arylene group" (in a case of a divalent group)], and encompasses not only a monocyclic ring (an aromatic single ring) but also a polycyclic ring (aromatic multiple rings). In the case of the polycyclic ring, at least one single ring is the aromatic single ring, but the other single ring(s) forming a condensed ring with the aromatic single ring may be a monocyclic heterocyclic ring (a hetero single ring) or may be a monocyclic alicyclic hydrocarbon (an alicyclic single ring).

Examples of the aromatic ring include, but not limited to, an aromatic hydrocarbon ring such as benzene, indene, naphthalene, azulene, styrene, toluene, xylene, mesitylene, cumene, anthracene, phenanthrene, triphenylene, benzoanthracene, pyrene, chrysene, fluorene, biphenyl, corannulene, perylene, fluoranthene, benzo[k]fluoranthene, benzo[b]fluoranthene, benzo[ghi]perylene, coronene, dibenzo[g,p]chrysene, acenaphthylene, acenaphthene, naphthacene, pentacene, and cyclooctatetraene, more typically, an aromatic hydrocarbon ring such as benzene, naphthalene, anthracene, and pyrene; and an aromatic heteroring such as furan, pyran, pyridine, pyrimidine, pyrazine, thiophene, pyrrole, an N-alkylpyrrole, an N-arylpyrrole, imidazole, pyridine, pyrimidine, pyrazine, triazine, thiazole, indole, phenylindole, bisindolefluorene, bisindolebenzofluorene, bisindoledibenzofluorene, purine, quinoline, isoquinoline, chromene, thianthrene, phenothiazine, phenoxazine, xanthene, acridine, phenazine, carbazole, and indolocarbazole, more typically, furan, thiophene, pyrrole, indole, phenylindole, bisindolefluorene, phenothiazine, carbazole, and indolocarbazole.

The aromatic ring (for example, a benzene ring and a naphthalene ring) optionally has a substituent. Examples of the substituent include: a halogen atom, a saturated or unsaturated linear, branched, or cyclic hydrocarbon group (-R) (which may be interrupted once or more by an oxygen atom at a middle of the hydrocarbon chain, and which encompasses an alkyl group, an alkenyl group, an alkynyl group, a propargyl group, and the like), an alkoxy group or an aryloxy group (-OR, wherein R represents the hydrocarbon group -R), an alkylamino group [-NHR, or -NR₂ in which two R may be the same or different from each other; wherein R represents the hydrocarbon group - R and encompasses an alkyl group, an alkenyl group, an alkynyl group, a propargyl group and the like optionally interrupted once or more by an oxygen atom at a middle of the hydrocarbon chain], a hydroxy group, an amino group (-NH₂), a carboxyl group, a cyano group, a nitro group, an ester group (-CO₂R or -OCOR, wherein R represents the hydrocarbon group -R), an amide group (-NHCOR, -CONHR, or -NRCOR in which two R may be the same or different from each other, or -CONR₂ in which two R may be the same or different from each other; wherein R represents the hydrocarbon group -R), a sulfonyl-containing group (-SO₂R, wherein R represents the hydrocarbon group -R or a hydroxy group -OH), a thiol group (-SH), a sulfide-containing group (-SR, wherein R represents the hydrocarbon group -R); an organic group having an ether bond [a residue of an ether compound represented by R¹¹-O-R¹¹, wherein R¹¹ each independently represents an alkyl group having 1 to 6 carbon atoms such as a methyl group and an ethyl group, and an aryl group such as a phenyl group, a naphthyl group, an anthranyl group, and a pyrenyl group; for example, an organic group having an ether bond, including a methoxy group, an ethoxy group, or a phenoxy group], and an aryl group.

The aromatic group further includes an organic group having a condensed ring between: one or more aromatic rings (such as benzene, naphthalene, anthracene, and pyrene); and one or more aliphatic rings or heterorings. Examples of the aliphatic ring herein include cyclobutane, cyclobutene, cyclopentane, cyclopentene, cyclohexane, cyclohexene, methylcyclohexane, methylcyclohexene, cycloheptane, and cycloheptene. Examples of the heteroring include furan, thiophene, pyrrole, imidazole, pyran, pyridine, pyrimidine, pyrazine, pyrrolidine, piperidine, piperazine, and morpholine.

The aromatic group may be an organic group having a structure in which two or more aromatic rings are linked via a divalent linking group such as an alkylene group.

### (I-4) "Heteroring"

The "heteroring" is a concept encompassing both of an aliphatic heteroring and an aromatic heteroring, and encompassing not only a monocyclic ring (a hetero single ring) but also a polycyclic ring (hetero multiple rings). In the case of the polycyclic ring, at least one single ring is a hetero single ring, but the other single ring(s) may be an aromatic hydrocarbon single ring or an alicyclic single ring. As for the aromatic heteroring, the examples in the (I-3) may be referred to. The heteroring may have a substituent, as with the aromatic ring in the (I-3).

### (I-5) "Non-Aromatic Ring" (Aliphatic Ring)

The "non-aromatic single ring" refers to a monocyclic hydrocarbon not belonging to aromatics, and is typically a single ring of an alicyclic compound. The non-aromatic single ring may also be referred to as an aliphatic single ring (which may encompass an aliphatic hetero single ring, and may have an unsaturated bond unless the aliphatic single ring belongs to an aromatic compound). The non-aromatic single ring may have a substituent, as with the aromatic ring in the (I-3).

Examples of the non-aromatic single ring (the aliphatic ring or the aliphatic single ring) include cyclopropane, cyclobutane, cyclobutene, cyclopentane, cyclopentene, cyclohexane, methylcyclohexane, cyclohexene, methylcyclohexene, cycloheptane, and cycloheptene.

The "non-aromatic multiple ring" refers to a polycyclic hydrocarbon not belonging to aromatics, and is typically a multiple ring of an alicyclic compound. The non-aromatic multiple ring may be referred to as an aliphatic multiple ring [which may encompass an aliphatic hetero multiple ring, in which at least one single ring constituting the multiple rings is the aliphatic heteroring, and which may have an unsaturated bond unless the aliphatic multiple ring belongs to an aromatic compound]. The non-aromatic multiple ring encompasses a non-aromatic double ring, a non-aromatic triple ring, and a non-aromatic quadruple ring.

The "non-aromatic double ring" refers to a condensed ring composed of two monocyclic hydrocarbons not belonging to aromatics, and is typically a condensed ring of two alicyclic compounds. The non-aromatic double ring herein may be referred to as an aliphatic double ring (which may encompass an aliphatic hetero double ring and may have an unsaturated bond unless the aliphatic double ring belongs to an aromatic compound). Examples of the non-aromatic double ring include bicyclopentane, bicyclooctane, and bicycloheptene.

The "non-aromatic triple ring" refers to a condensed ring composed of three monocyclic hydrocarbons not belonging to aromatics, and is typically a condensed ring of three alicyclic compounds (each of which may be a heteroring and may have an unsaturated bond unless the aliphatic triple ring belongs to an aromatic compound). Examples of the non-aromatic triple ring include tricyclooctane, tricyclononane, and tricyclodecane.

The "non-aromatic quadruple ring" refers to a condensed ring composed of four monocyclic hydrocarbons not belonging to aromatics, and is typically a condensed ring of four alicyclic compounds (each of which may be a heteroring, and may have an unsaturated bond unless the aliphatic quadruple ring belongs to an aromatic compound). Examples of the non-aromatic quadruple ring include hexadecahydropyrene.

(1-6)
The "carbon atom constituting a ring (portion)" means a carbon atom constituting a hydrocarbon ring (any one of an aromatic ring, an aliphatic ring, and a heteroring) with no substituent.

(I-7)
The "hydrocarbon group" refers to a group formed by removing one or more hydrogen atoms from a hydrocarbon. The hydrocarbon includes a saturated or unsaturated aliphatic hydrocarbon, a saturated or unsaturated alicyclic hydrocarbon, and an aromatic hydrocarbon.

(1-8)
In chemical structural formulae that represent unit structures of the novolac resin herein, a bonding site (represented by "*") may be shown for convenience. This bonding site may be on any possible bonding position in the unit structure unless otherwise noticed, and the bonding position in the unit structure is not limited at all.

### [II. Resist Underlayer Film-forming composition]

The resist underlayer film-forming composition of one aspect of the present invention includes a specific novolac resin and a solvent.

### (IIA) Novolac resin

(IIA-1)
The specific novolac resin included in the resist underlayer film-forming composition of one aspect of the present invention comprises a unit structure A having an aromatic ring, and the unit structure A comprises a unit structure derived from a compound of the following formula (A0):

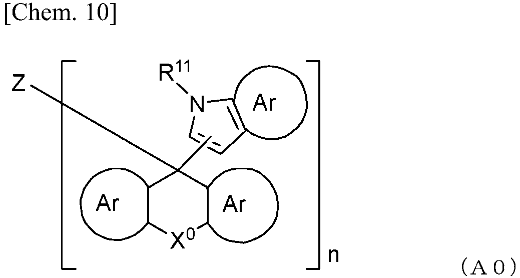

An aromatic ring included in these compounds, i.e., any one of the aromatic ring moiety Ar and the pyrrole ring moiety in the condensed rings is bounded to a linkage carbon atom in a unit structure B or C [see the (I-1)] to form the novolac resin.

(IIA-1-1)
In the formula (A0),
R¹¹ each independently represent:
   (i) a hydrogen atom or a methylol group;
   (ii) an aryl group having 6 to 30 carbon atoms; or
   (iii) a linear, branched, or cyclic alkoxymethyl group having 2 to 20 carbon atoms; a linear, branched, or cyclic alkyl group having 1 to 20 carbon atoms; an alkenyl group having 2 to 10 carbon atoms; or an alkynyl group having 2 to 10 carbon atoms.

Provided in the (ii) and (iii), a hydrogen atom in these substituents may be further substituted with an oxygen-atom-containing substituent, such as a hydroxy group, an alkoxy group, an aryloxy group, a carboxyl group, and a carbonyl group; a sulfur-atom-containing substituent, such as a sulfonic acid group, a sulfide-containing group, and a sulfonyl-containing group; a nitrogen-atom-containing substituent, such as an amino group, a substituted amino group (such as a monosubstituted or disubstituted amino group such as a monoalkylamine and a dialkylamine), an amide group, a nitro group, and a cyano group; an aryl group, preferably an aryl group having 6 to 15 carbon atoms such as a phenyl group; or a halo group. In the (iii), the hydrocarbon chain moiety may be further interrupted by an oxygen-atom-containing substituent, such as - O-, -C(O)-, -C(O)O-, and -OC(O)-; a sulfur-atom-containing substituent, such as -S-; a nitrogen-atom-containing substituent, such as -N(R)C(O)-, -C(O)N(R)-, -OC(O)N(R)-, - N(R)C(O)O-, -N(R)C(O)N(R)-, and -NR-; or an arylene group, such as a phenylene group. In the substituent used for the interruption, R is the same or different from each other, and each independently represents a hydrogen atom or a hydrocarbon group having 1 to 30 carbon atoms.

(IIA-1-2)
In the formula (A0),
X⁰ represents a single bond, -O-, -S-, -NR¹²- or -CR¹³R¹⁴-, preferably a single bond or -CR¹³R¹⁴-, and more preferably a single bond. The monocyclic moiety containing X⁰ forming a condensed ring with the aromatic ring moiety Ar constitutes a cyclopentane ring when X⁰ is a single bond; constitutes a tetrahydropyran ring when X⁰ is -O-; constitutes a piperidine ring when X⁰ is -NR¹²-; and constitutes a cyclohexane ring when X⁰ is -CR¹³R¹⁴-.
R¹² is the same as or different from R¹¹, and is the same as the definition of R¹¹ (see the (IIA-1-1)).
R¹³ and R¹⁴ each independently represent a hydrogen atom, or a hydrocarbon group having 1 to 6 carbon atoms, and preferably a hydrogen atom.

In view of self-crosslinking properties, when all the X⁰ are a single bond, -O-, - S- or -CR¹³R¹⁴-, at least a part of R¹¹; and when at least one X⁰ is -NR¹²-, at least a part of R¹¹ and R¹²; is preferably the following alkynyl group:

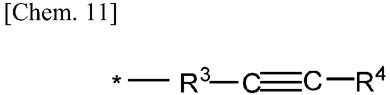

Regarding the "at least a part", it is preferable that an introducing rate of the alkynyl groups into nitrogen atoms in the compound of the formula (A0) is 5 to 100%. The introducing rate of the alkynyl groups can be calculated by, for example, ¹H-NMR measurement or ¹³C-NMR. The introducing rate may also be calculated by using an internal standard or the like as necessary.

Here, R³ represents a single bond or a divalent organic group having 1 to 20 carbon atoms, preferably an alkylene group, and more preferably a methylene group; R⁴ represents a hydrogen atom or a monovalent organic group having 1 to 20 carbon atoms, preferably a hydrogen atom or an alkyl group, and more preferably a hydrogen atom. "*" represents a bonding site.

Here, the organic group means a residue of an organic compound.

(IIA-1-3)
In the formula (A0), n is 1 or 2; when n is 1, Z represents a monovalent organic group, and when n is 2, Z represents a divalent organic group.

The monovalent organic group Z is preferably R²¹, and the divalent organic group Z is preferably R²²-L-R²². Here, R²¹ represents an aryl group having 6 to 30 carbon atoms; an alkenyl group having 2 to 10 carbon atoms; or an alkynyl group having 2 to 10 carbon atoms, each of which may have a substituent. R²² represents an arylene group having 6 to 30 carbon atoms; an alkenylene group having 2 to 10 carbon atoms; or an alkynylene group having 2 to 10 carbon atoms, each of which may have a substituent. L represents a single bond or a divalent linking group.

The divalent linking group L is preferably selected from the group consisting of -O-, -S-, -SO₂-, -CO-, -CONH-, -COO-, -NR-, -(CR¹R²)ₘ₁-, -(Ar)ₘ₂-, -CH₂-(Ar)ₘ₂-CH₂-, and -(cyclo-R)-. In view of high carbon content, L is preferably -(CR¹R²)ₘ₁-, - (Ar)ₘ₂-, -CH₂-(Ar)ₘ₂-CH₂-, or -(cyclo-R)-.

Here, R, R¹ and R² are the same or different from each other, and each independently represent: a hydrogen atom, a hydrocarbon group having 1 to 5 carbon atoms; or an aryl group having 6 to 30 carbon atoms; and m1 represents an integer of 1 to 10. Ar represents an arylene group having 6 to 30 carbon atoms; and m2 represents the number of aromatic rings bonded to each other via a single bond, and is an integer of 1 to 3. Examples of the Ar include a divalent benzene ring, a divalent naphthalene ring, a divalent anthracene ring, a divalent pyrene ring, a divalent biphenyl ring, or a divalent terphenyl ring. The hydrocarbon group having 1 to 5 carbon atoms is preferably a linear, branched, or cyclic aliphatic hydrocarbon group.
cyclo-R represents a five to eight-membered, preferably six to eight-membered, divalent alicyclic hydrocarbon group which may form a condensed ring with one or two benzene rings or naphthalene rings. The two bonding sites in cyclo-R mean bonding sites each extending from a carbon atom constituting a ring of the alicyclic hydrocarbon group (the carbon atoms for the two bonding sites are preferably identical, and excludes carbon atoms belonging to an optionally contained condensed benzene ring or a condensed naphthalene ring). The alicyclic hydrocarbon group may be a divalent monocyclic hydrocarbon group derived from cyclohexane, cyclopentane, or the like, or may be a divalent polycyclic hydrocarbon group derived from dicyclopentadiene or the like. Examples of the alicyclic hydrocarbon group forming the condensed ring with a benzene ring or a naphthalene ring include a divalent hydrocarbon group derived from tetralin, 9,10-dihydroanthracene, 9,10-dihydrophenanthrene, indan, fluorene, benzocyclobutene, benzofluorene, dibenzofluorene, and acenaphthene.

(IIA-1-4)
In the formula (A0), Ar is an aromatic ring moiety. Each of Ar is independently the same or different, and a benzene ring or a condensed ring composed of 2 to 3 benzene rings. Ar may optionally have a substituent.

Examples of the condensed ring composed of 2 to 3 benzene rings include a naphthalene ring, an anthracene ring, a phenanthrene ring, a biphenyl ring and a terphenyl ring. Ar is preferably a benzene ring or a naphthalene ring, and all the Ar are more preferably benzene rings.

The aromatic ring moiety may optionally form a condensed ring with a non-aromatic ring.

In the formula (A0), the aromatic ring moiety and the pyrrole ring moiety may optionally have a substituent. The optional substituents are described in the (I-3), and more particular examples thereof include the following (iv) to (vi). In view of high carbon content, it is preferable that the aromatic ring moiety or the pyrrole ring moiety has no substituent, or is substituted with a hydrocarbon group.

Examples includes:
(iv) a hydroxy group, a nitro group, a cyano group, a carboxyl group, a trifluoromethyl group, an amino group, a monosubstituted amino group, a disubstituted amino group, or a halo group;
(v) an aryloxy group (-OAr) having 6 to 15 carbon atoms; an arylalkoxy carbonyl group (-COO-R-Ar) having 8 to 15 carbon atoms; an aryloxycarbonyl group (-COOAr) having 7 to 15 carbon atoms; or an aryl group (-Ar) having 6 to 30 carbon atoms, or
(vi) an acyl group (-COR) having 1 to 15, preferably 2 to 15 carbon atoms; an alkoxy group (-OR) having 1 to 15 carbon atoms; an arylalkoxy group (-O-R-Ar) having 7 to 15 carbon atoms; an alkoxycarbonyl group (-COOR) having 1 to 15, preferably 2 to 15 carbon atoms; a linear, branched, or cyclic alkyl group having 1 to 10 carbon atoms; an alkenyl group having 2 to 20 carbon atoms; or an alkynyl group having 2 to 10 carbon atoms.

Provided in the (v) and (vi), a hydrogen atom in these groups is optionally further substituted with an oxygen-atom-containing substituent, a sulfur-atom-containing substituent, a nitrogen-atom-containing substituent, an aryl group, or a halo group, similarly to the (ii) and (iii) in the (IIA-1-1). In the (vi), a hydrocarbon chain moiety is optionally further interrupted by an oxygen-atom-containing substituent, a sulfur-atom-containing substituent, a nitrogen-atom-containing substituent, or an arylene group (such as a phenylene group), similarly to the (iii) in the (IIA-1-1).

Examples of benzene rings having a substituent include a biphenyl (a benzene ring substituted with a phenyl group) and a terphenyl (a benzene ring substituted with a biphenyl group).

(II-1-5)
The aromatic ring moiety Ar may optionally form a condensed ring with a non-aromatic ring, and for example, the condensed ring may be the following formula (AR01):

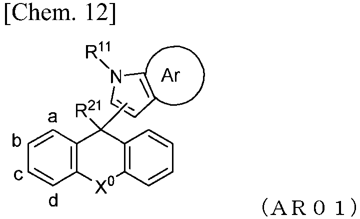

In the formula (AR01), two carbon atoms "a" and "b", "b" and "c", or "c" and "d" forms a condensed ring with the monocyclic moiety containing X⁰.

Here, the condensed ring containing X⁰ represents a condensed ring of the basic skeleton of the following formula (AP01) in the formula (A0)

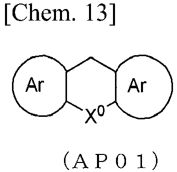

The monocyclic moiety containing X⁰ represents a single ring of the basic skeleton of the following formula (AP011) in the formula (AP01)

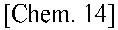

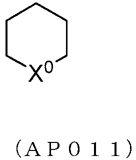

Here, R¹¹, X⁰ and Ar independently have the same definition as in the (IIA-1-1) to (IIA-1-4), respectively and may be the same as or different from R¹¹, X⁰ and Ar in the formula (A0). R²¹ has the same definition as in the (IIA-1-3), and may be the same as or different from Z in the formula (A0).

"a" to "d" are symbols given to carbon atoms for convenience of explanation.

Among the formula (A0), the particular examples, in which two carbon atoms "a" and "b", "b" and "c", or "c" and "d" of the formula (AR01) form a condensed ring with the monocyclic moiety containing X⁰, include the following (A11) to (A14).

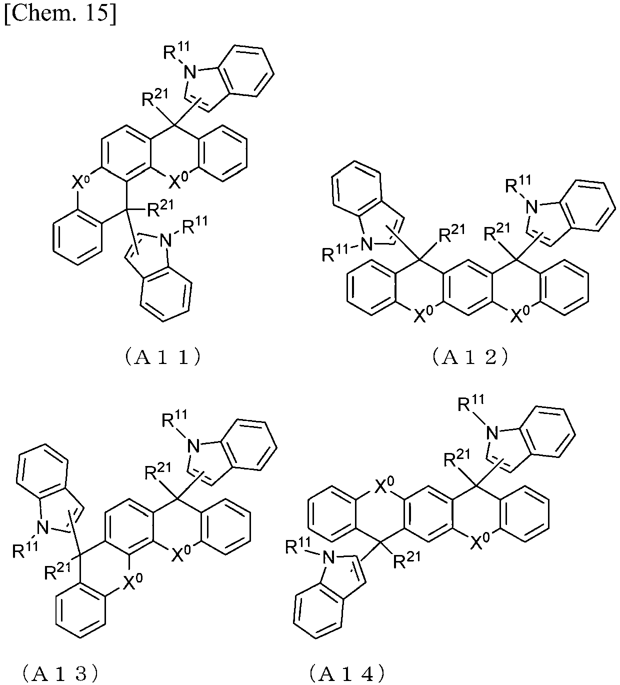

The particular examples, in which at least one of Ar's of the formula (A0) is a naphthalene ring, include the following (A15) to (A27).

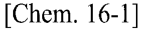

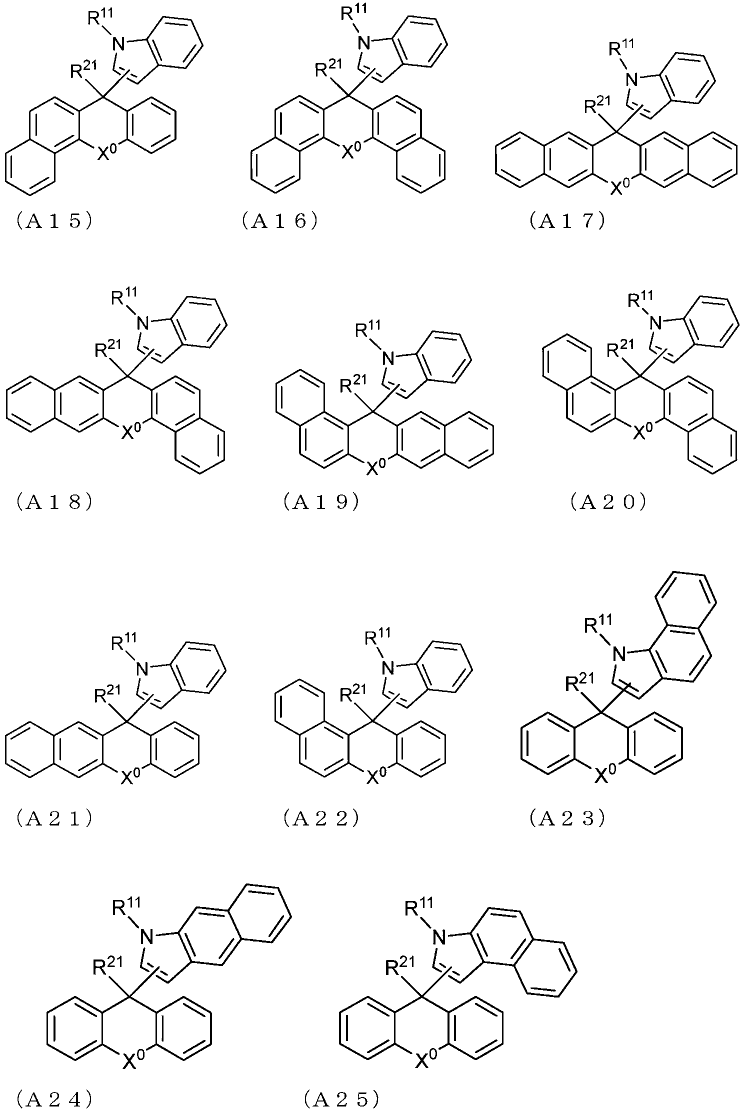

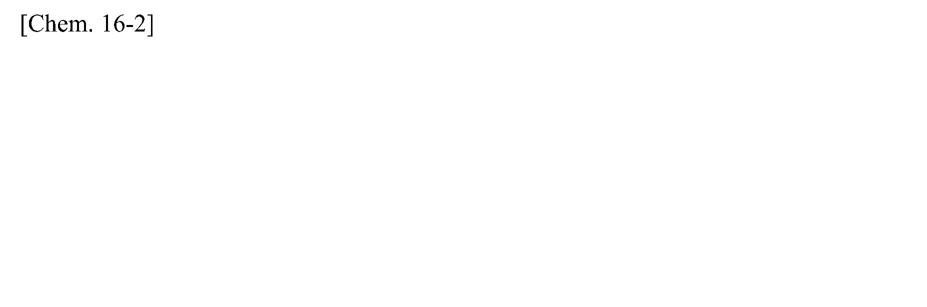

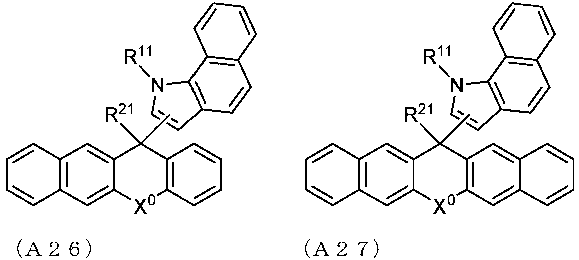

In addition, Ar may optionally have a substituent, and examples thereof similarly include the substituents (iv) to (vi) described in the (IIA-1-4). In view of high carbon content, it is preferable that Ar has only the least heteroatom-containing substituents possible, has no substituent, or has hydrocarbon substituents.

(IIA-1-6)
Particularly, among the formula (A0), the following formulae (A01) to (A03) are preferable, and the formula (A01) is more preferable.

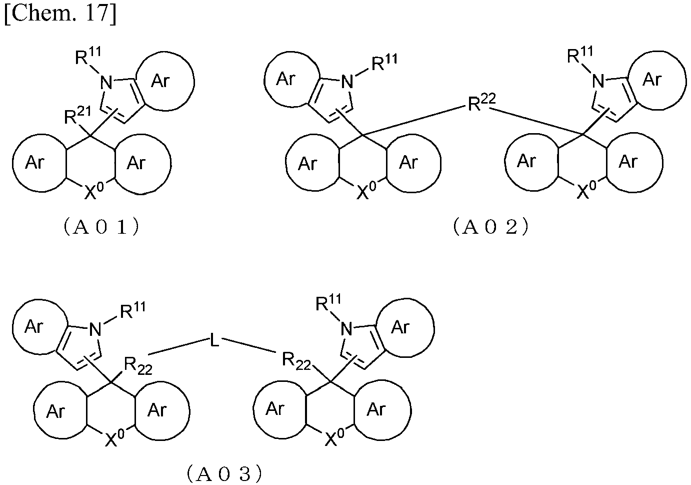

The formulae (A01) to (A03) are more preferable the following formulae (A04) to (A06), respectively.

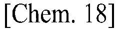

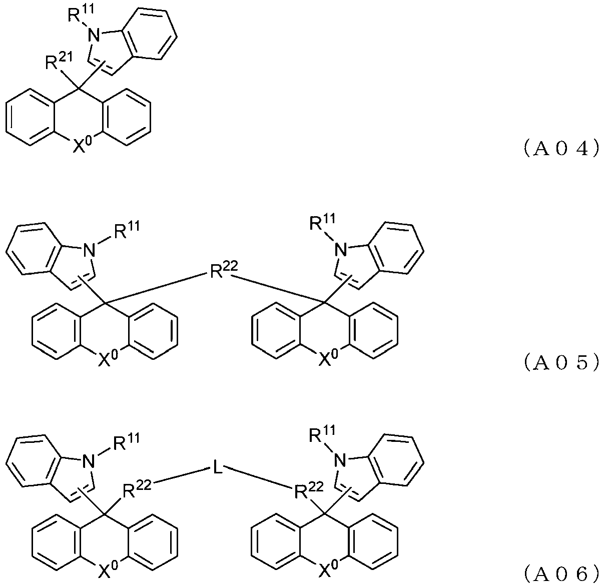

Here, in the formulae (A01) to (A06), Ar, X⁰, R¹¹, R²¹, R²² and L have the same definition as in the (IIA-1-1) to (IIA-1-4), respectively. In the formulae (A02) to (A03) and (A05) to (A06), a plurality of Ar, X⁰, R¹¹ and R²² may be the same or different.

(IIA-1-7)
The unit structure A derived from the compound of the formula (A0) has both the condensed ring (typically an indole ring, which contributes to polymerization reactivity) composed of the pyrrole ring moiety and the aromatic ring Ar moiety, and Z which is a monovalent or divalent organic group (which contributes to etching resistance due to its high carbon content) in the basic skeleton represented by the formula (AP01) [see the (IIA-1-5)], and therefore can moderately satisfy the two requirements of good polymerization reactivity and high carbon content.

In the case of a material with a high carbon content, it is difficult for the crosslinking agent to react effectively, which generally results in poor curing properties, leading to problems such as in-plane uniformity of film thickness, an increase in the amount of sublimate, and insufficient heat resistance. However, the present invention has the condensed ring composed of the pyrrole ring portion such as an indole ring and the aromatic ring Ar moiety in a high carbon skeleton, thereby exhibiting curing properties and solving the above problems.

In view of high carbon content, in the formula (A0), it is preferable that the number of heteroatoms is minimized.

(IIA-1-8)
Some representative specific examples of the unit structure A derived from the compound represented by the formula (A0) are listed below.

The bonding sites from the unit structure are omitted in the following specific examples. In addition, regarding R¹¹ bonded to the nitrogen atom of the pyrrole ring moiety in the formula (A0), or R¹² when X⁰ is -NR¹²-, a bonded hydrogen atom is given as a representative example, but at least a part of them may be replaced with the substituents (i) to (iii) exemplified in the (IIA-1-1), so long as the effect of the present invention is not impaired. In addition, the aromatic ring may optionally have the substituents (iv) to (vi) exemplified in the (IIA-1-4), so long as the effect of the present invention is not impaired.

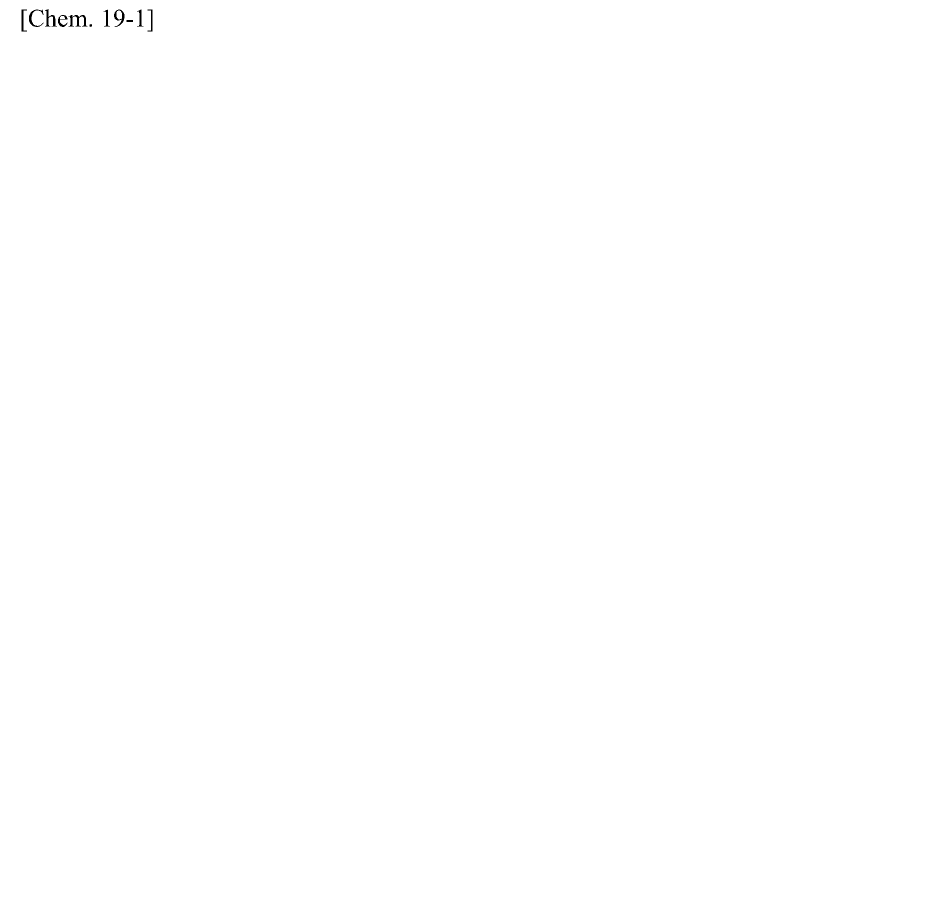

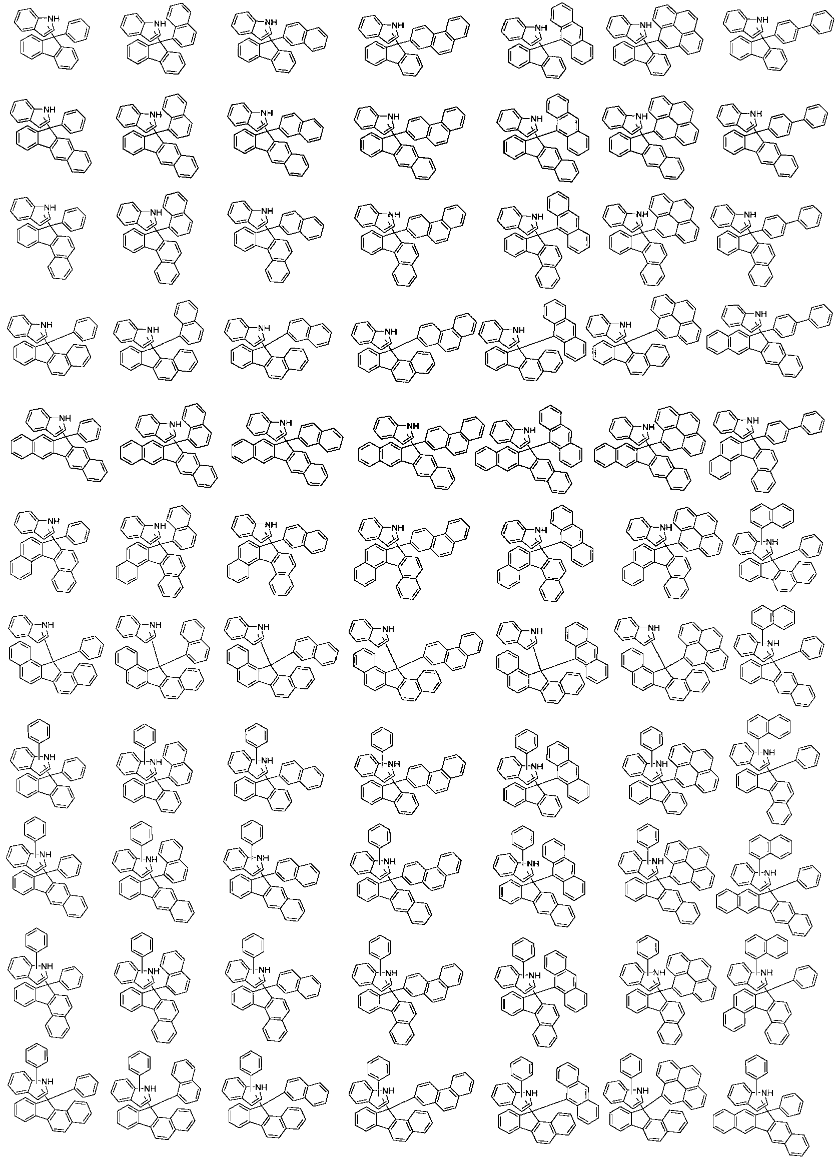

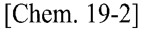

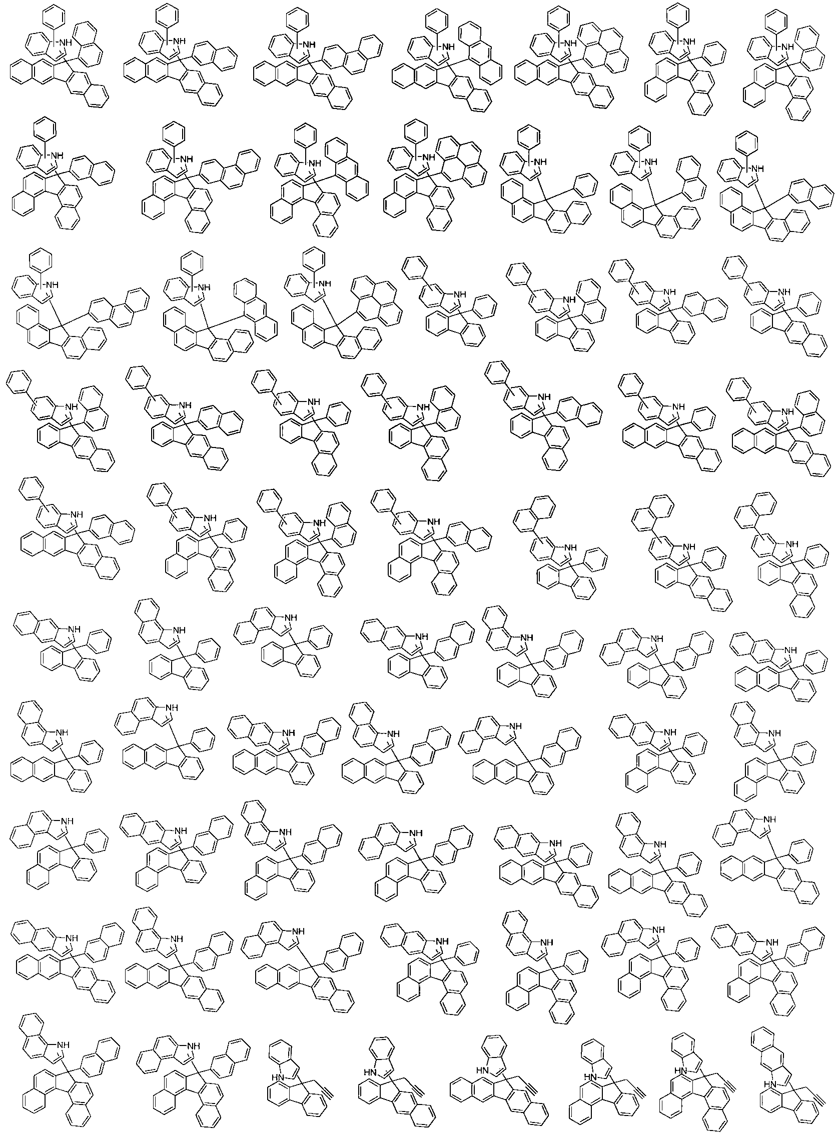

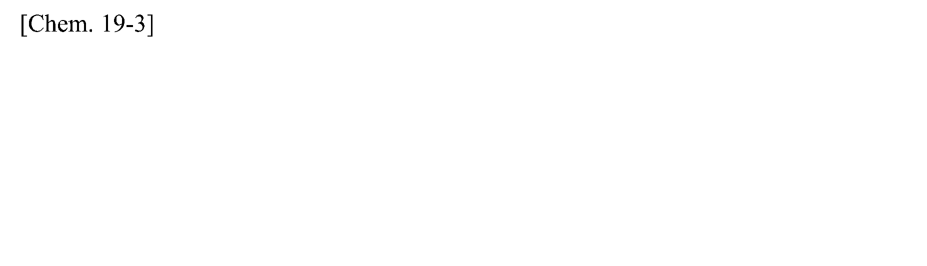

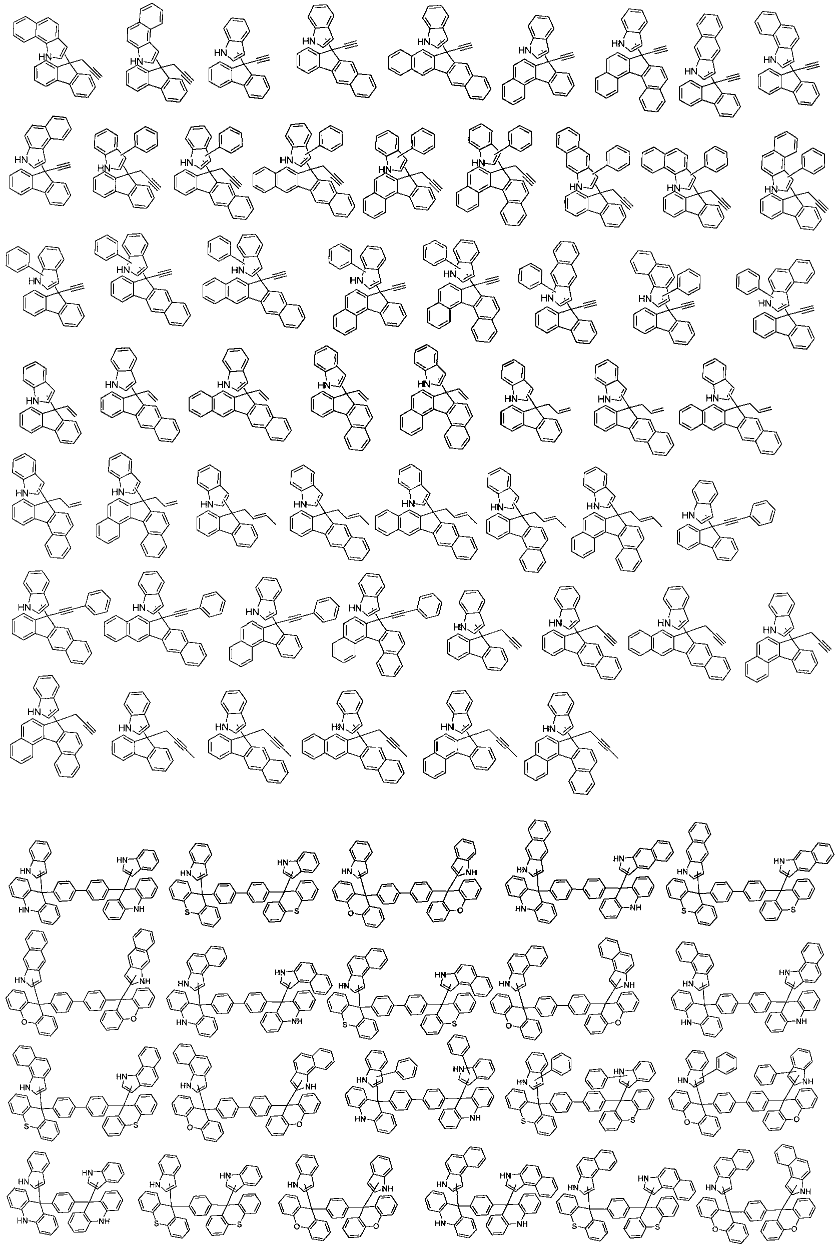

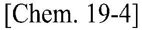

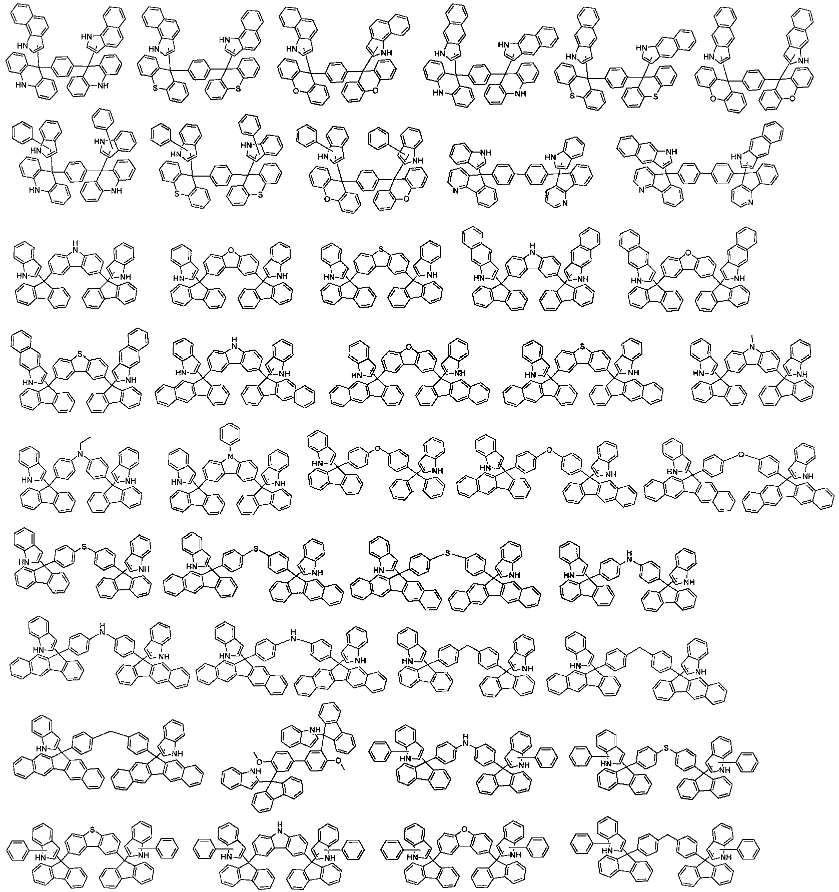

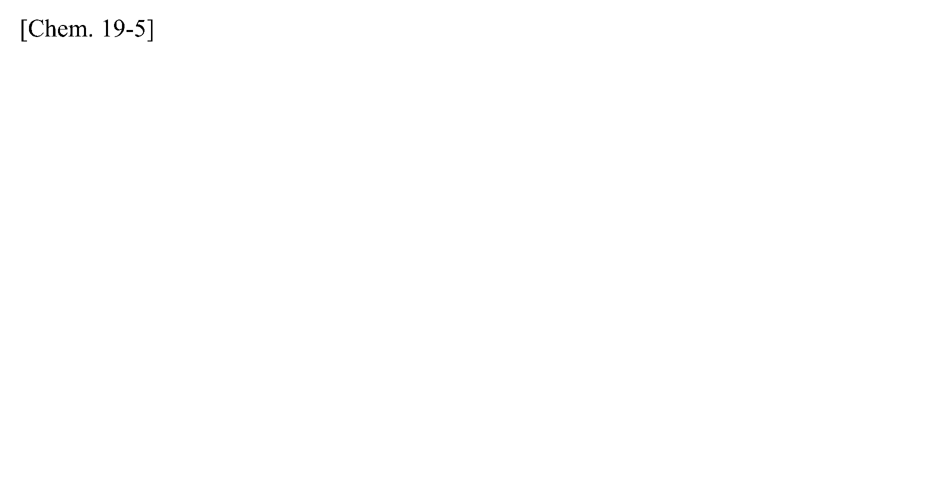

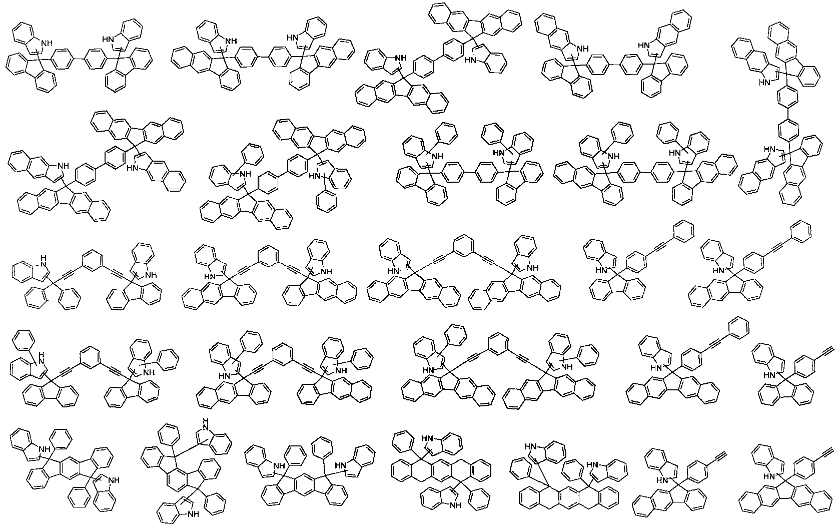

(IIA-1-9)
The compounds represented by the formula (A0), from which the unit structure A is derived can be synthesized by any known method. For example, the compounds can be synthesized using scandium trifluoromethanesulfonate, as shown in references [Zhou. Chen. Hu. et al Organic & Biomolecular Chemistry (2019), 17(44), 9615-9619, and CN 110078653 B]. In addition, a catalyst that exhibits a similar dehydrating effect to the above may be used instead. Examples of the catalysts includes Lewis acids formed from metals such as boron, aluminum, scandium, titanium, iron, zinc, arsenic, zirconium, niobium, cadmium, indium, tin, antimony, hafnium, mercury, and lanthanides, and electron-withdrawing groups; and organic and inorganic acids such as oxalic acid, acetic acid, hydrochloric acid, sulfuric acid, paratoluenesulfonic acid, methanesulfonic acid, and trifluoromethanesulfonic acid.

(IIA-1-10)
The unit structure A may have one or more unit structures having an aromatic ring other than the formula (A0) of the (IIA-1), so long as the effect of the present invention is not impaired.

Such aromatic rings preferably have 6 to 30 carbon atoms, and more preferably 6 to 24 carbon atoms.

Such aromatic rings are preferably one or more benzene rings, naphthalene rings, anthracene rings, pyrene rings; or condensed rings of a benzene ring, a naphthalene ring, an anthracene ring, or a pyrene ring with a heterocycle or an aliphatic ring (such as a fluorene ring, a benzofluorene ring, a dibenzofluorene ring, an indole ring, a carbazole ring, or an indolocarbazole ring).

The aromatic rings may optionally have a substituent. In view of polymerization reactivity, the substituents may have the least heteroatoms possible. In addition, in the aromatic ring, two or more aromatic rings may be linked via a linking group, and the linking group may have the least heteroatoms possible. Examples of the heteroatom include an oxygen atom, a nitrogen atom, and a sulfur atom.

The "aromatic ring" is preferably an organic group which may have at least one heteroatom selected from N, S, and O on the ring, in the ring, or between the rings, and which has 6 to 30 or 6 to 24 carbon atoms.

As the heteroatom which may be included on the ring, examples thereof include: a nitrogen atom included in an amino group (for example, a propargylamino group), a cyano group, or the like; an oxygen atom included in a formyl group, an hydroxyl group, a carboxyl group, an alkoxy group (for example, a propargyloxy group), or the like, which are an oxygen-containing substituent; and a nitrogen atom and an oxygen atom included in a nitro group, which is an oxygen-containing substituent and also a nitrogen-containing substituent. Examples of the heteroatom which may be included in the ring include an oxygen atom included in xanthene; and a nitrogen atom included in carbazole. Examples of the heteroatom which may be included in the linking group between two or more aromatic rings include a nitrogen atom, an oxygen atom, and a sulfur atom included in an -NH- bond, an -NHCO- bond, an -O- bond, a - COO- bond, a -CO- bond, an -S- bond, an -SS-bond, an -SO₂- bond, and the like. In view of polymerization reactivity, the one or more unit structures A having an aromatic ring other than the formula (A0) is preferably a unit structure having an aromatic ring having the aforementioned oxygen-containing substituent, a unit structure having two or more aromatic rings linked via -NH-, or a unit structure having a condensed ring between one or more aromatic hydrocarbon rings and one or more heterorings.

Examples of the skeleton used in the unit structure A other than the formula (A0) include the following skeletons.

### (Examples of amine skeletons)

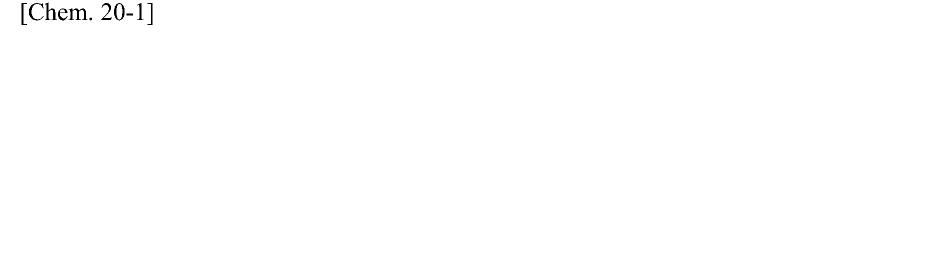

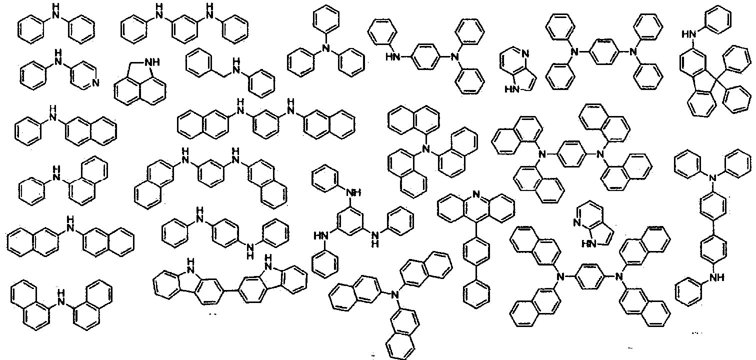

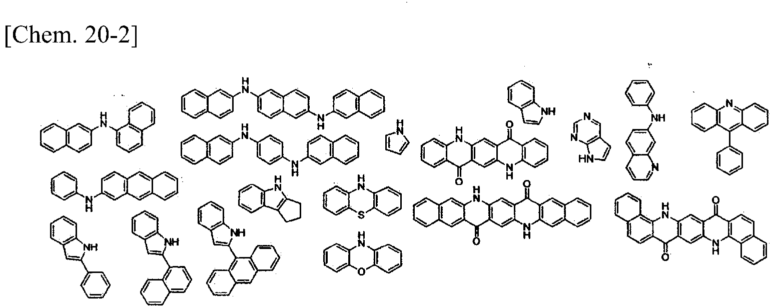

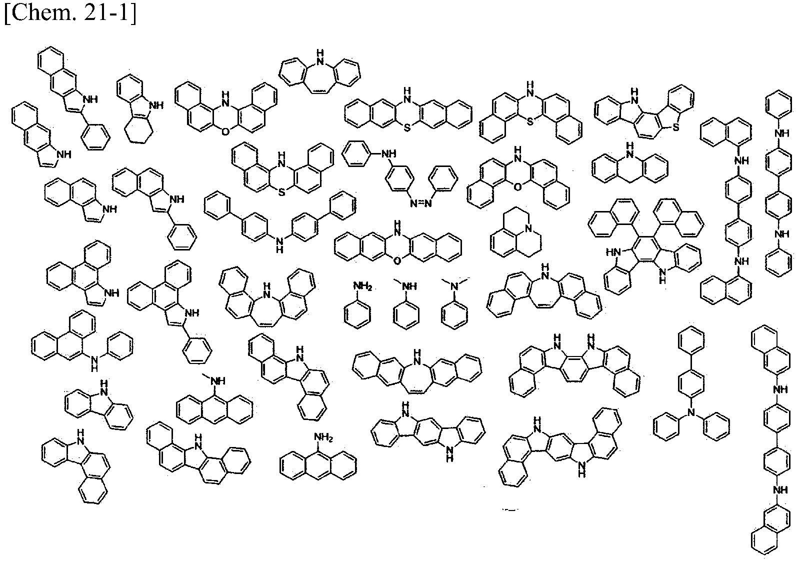

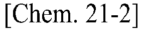

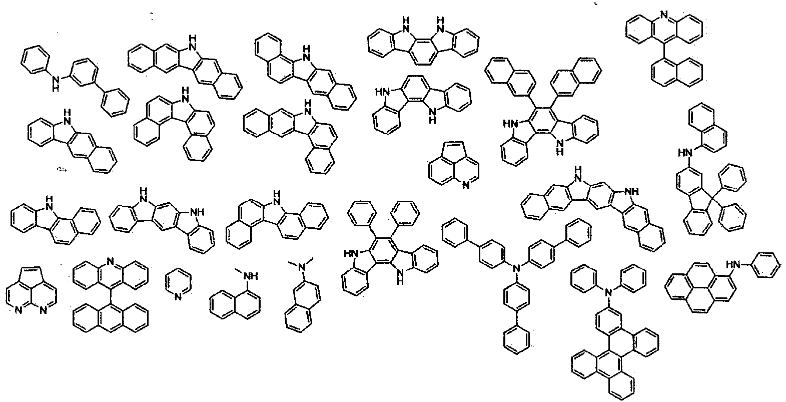

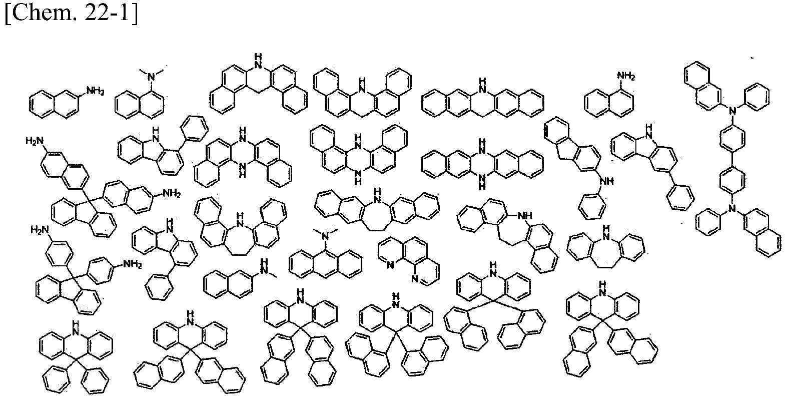

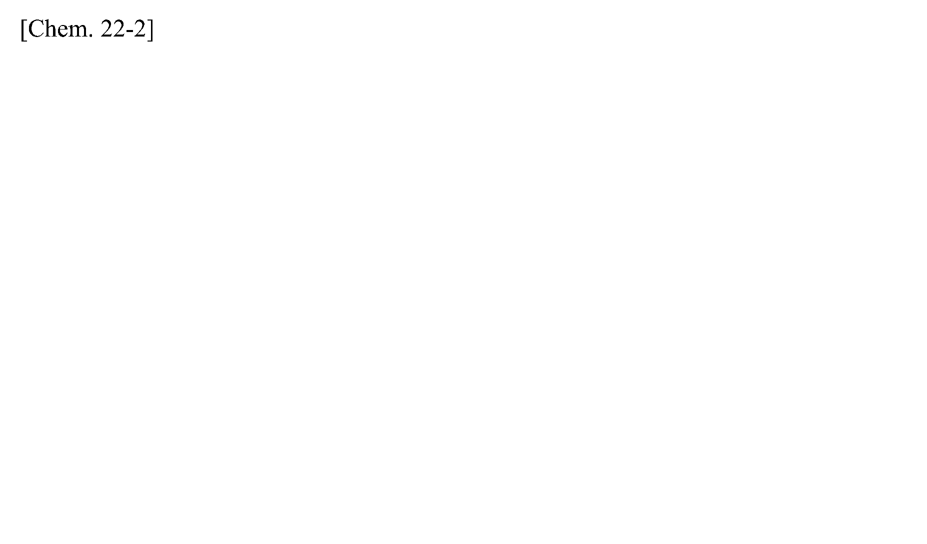

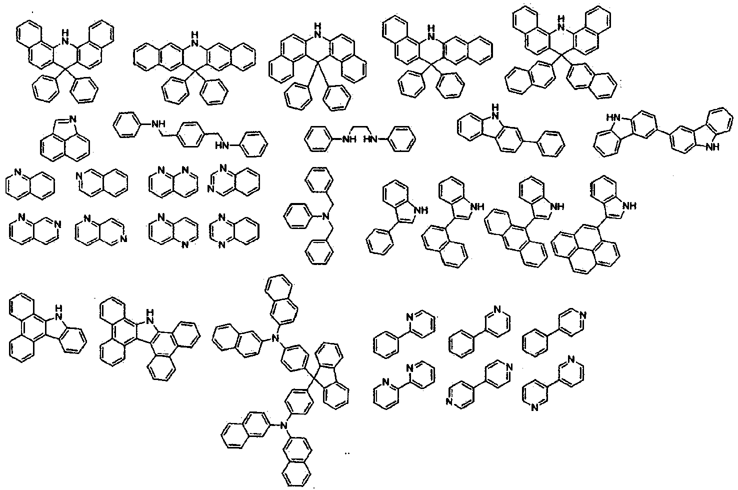

### (Examples of phenol skeletons)

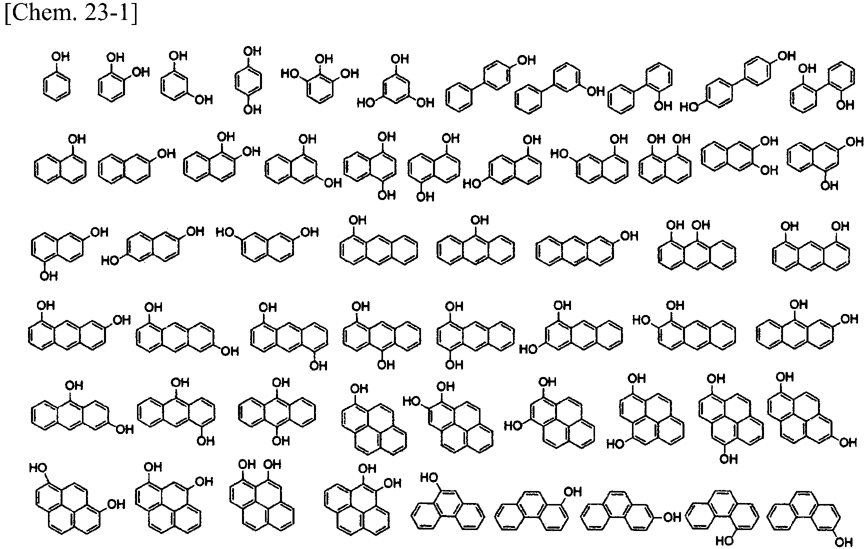

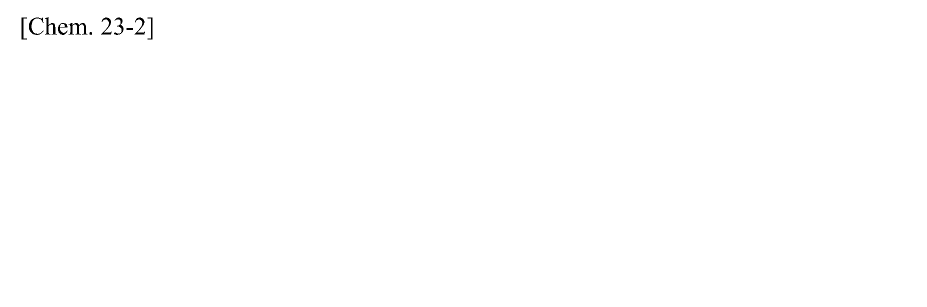

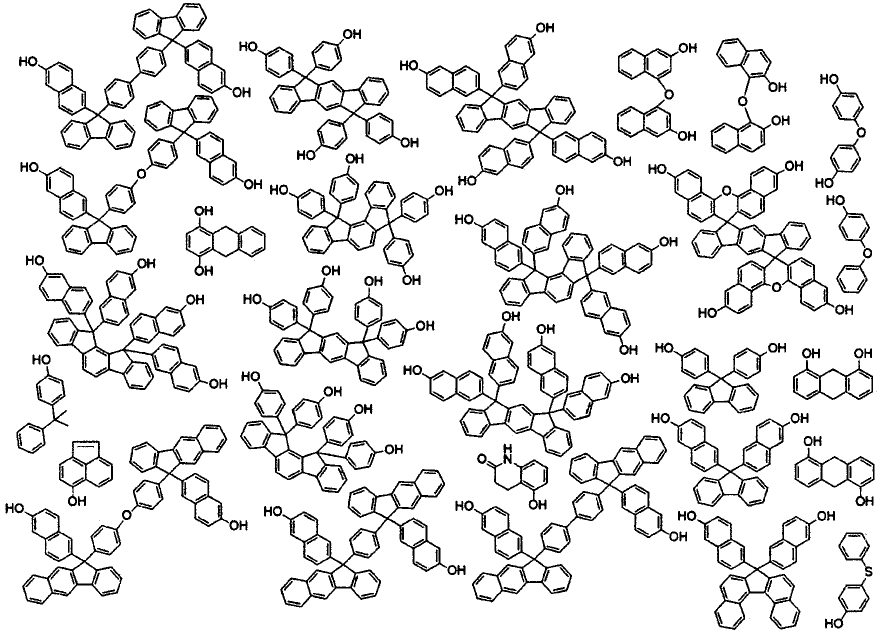

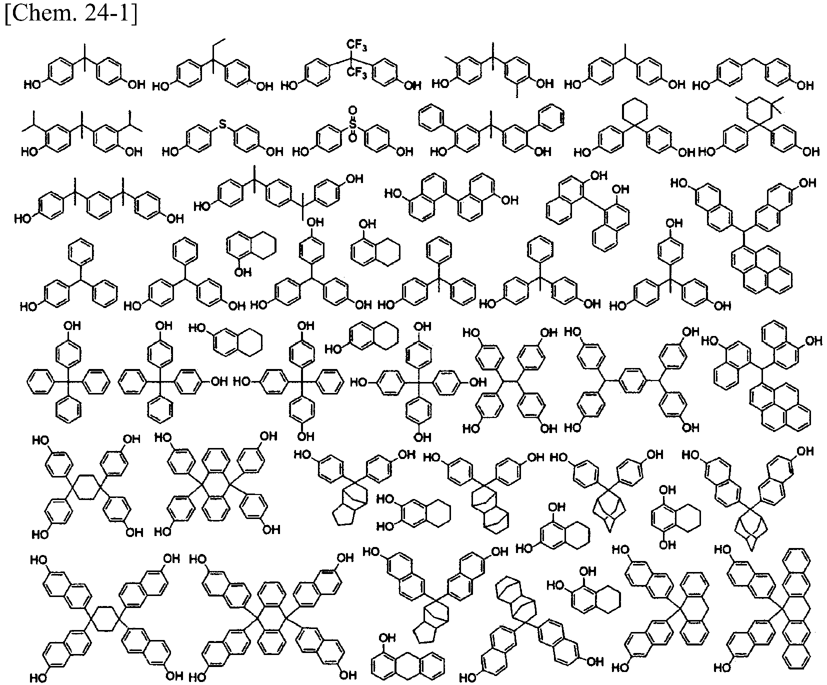

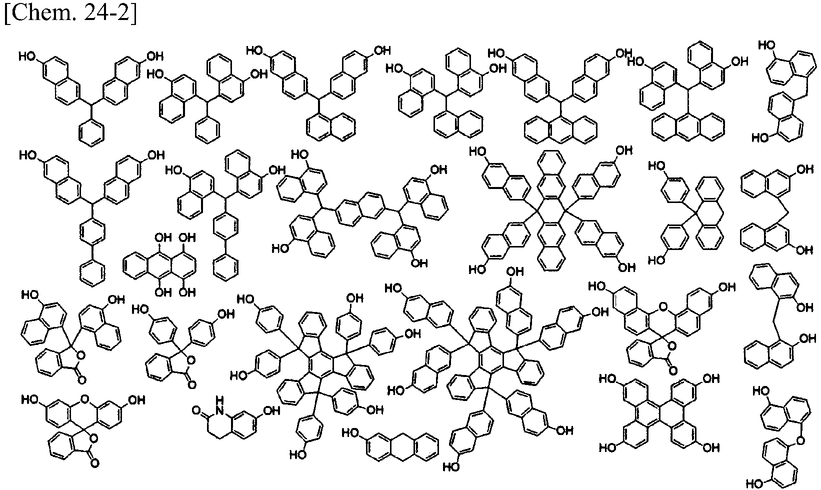

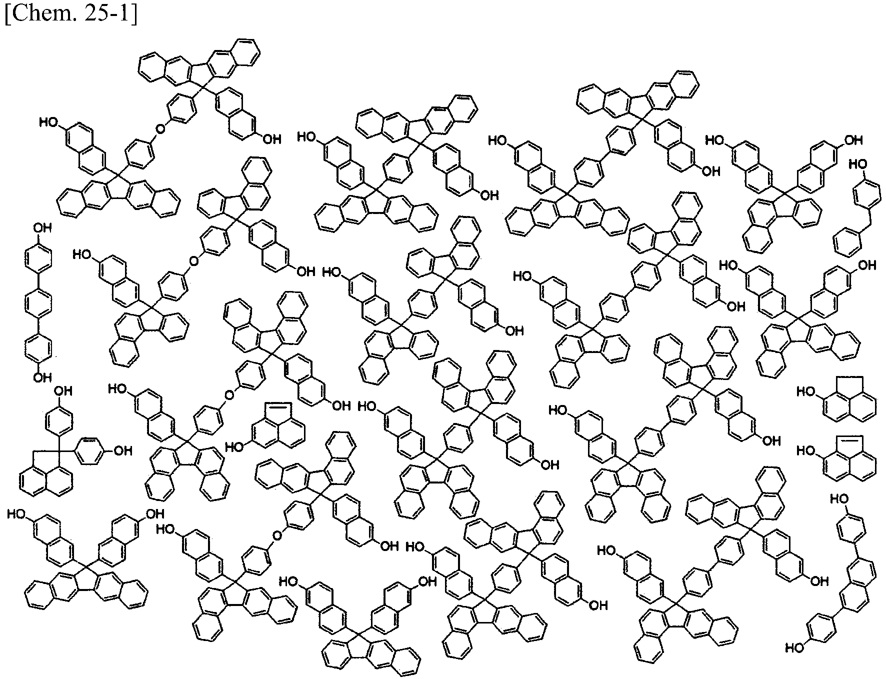

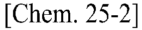

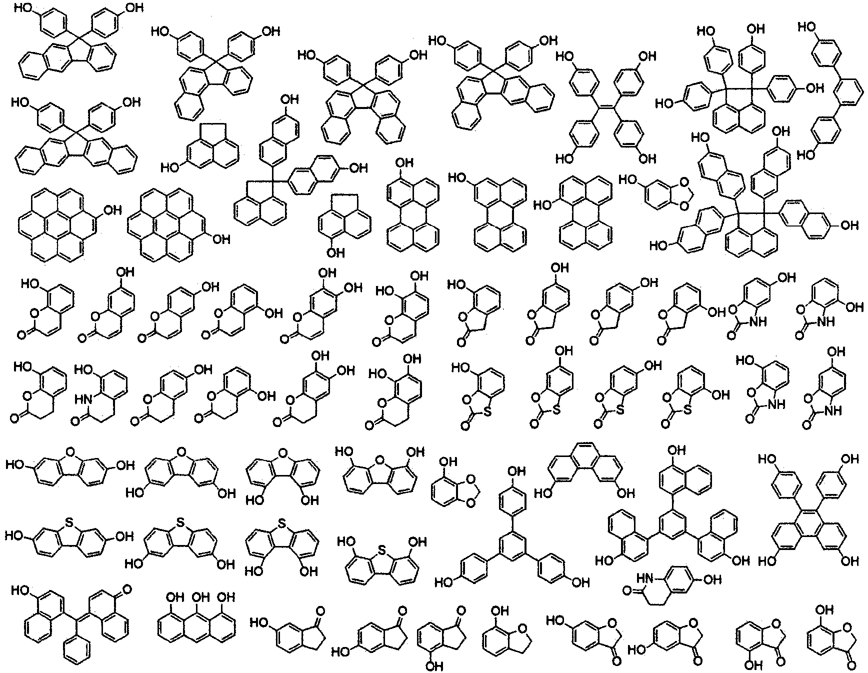

The H of the NH of the amine skeleton and the H of the OH of the phenol skeleton may be replaced with the following substituents.

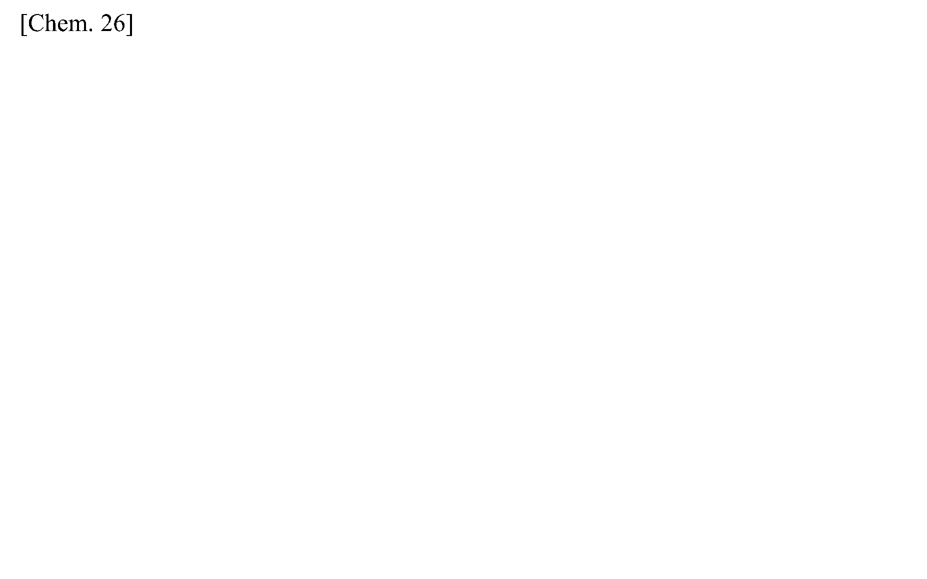

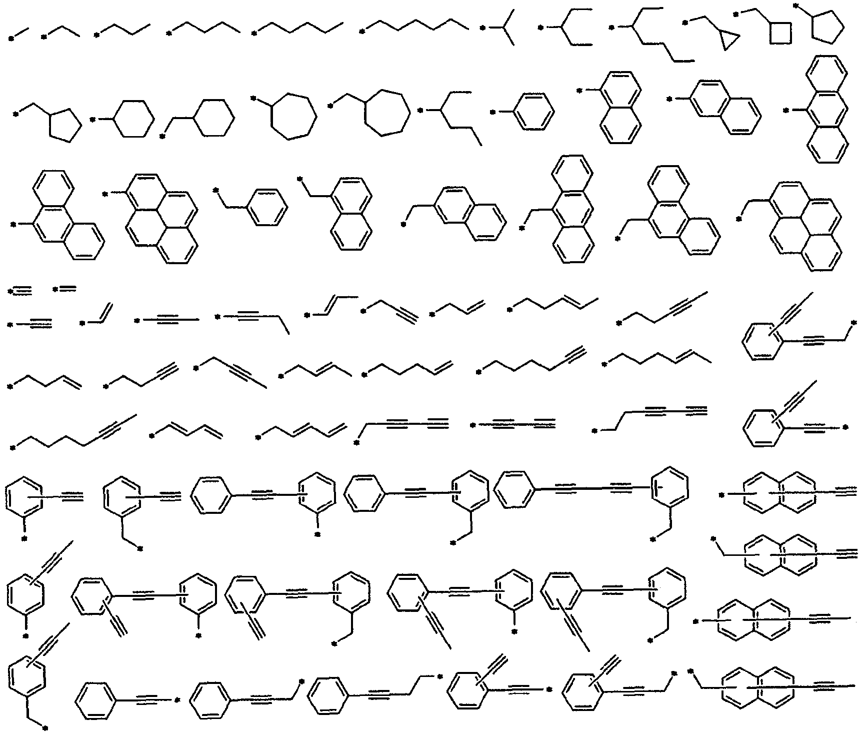

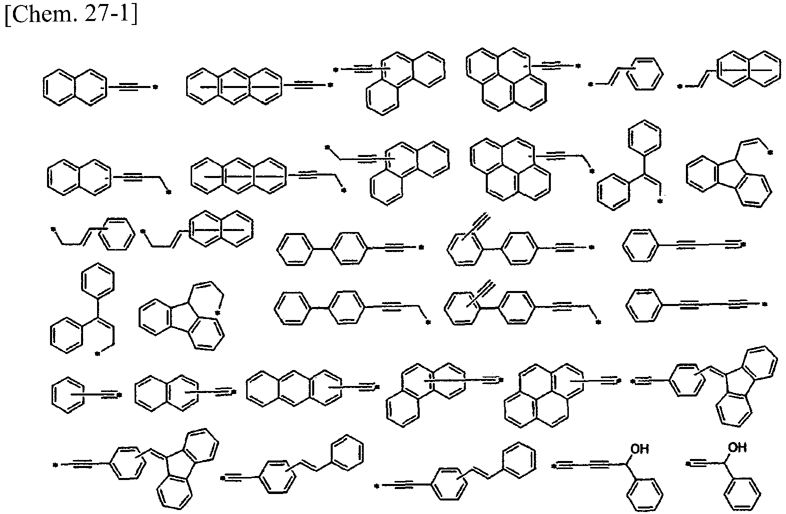

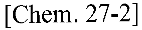

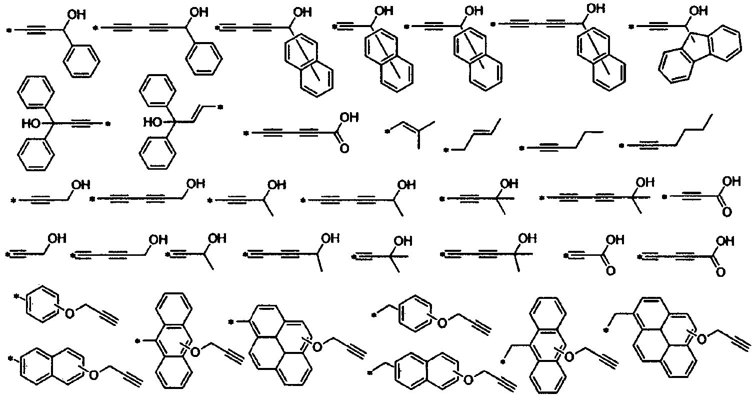

The unit structure A other than that of the formula (A0) is preferably at least one selected from the following. Note that the positions of the two bonding sites shown in each unit structure described below are shown merely for convenience, and each bond may extend from any possible carbon atom, and the positions are not limited thereto.

### (Examples of unit structures derived from heterorings)

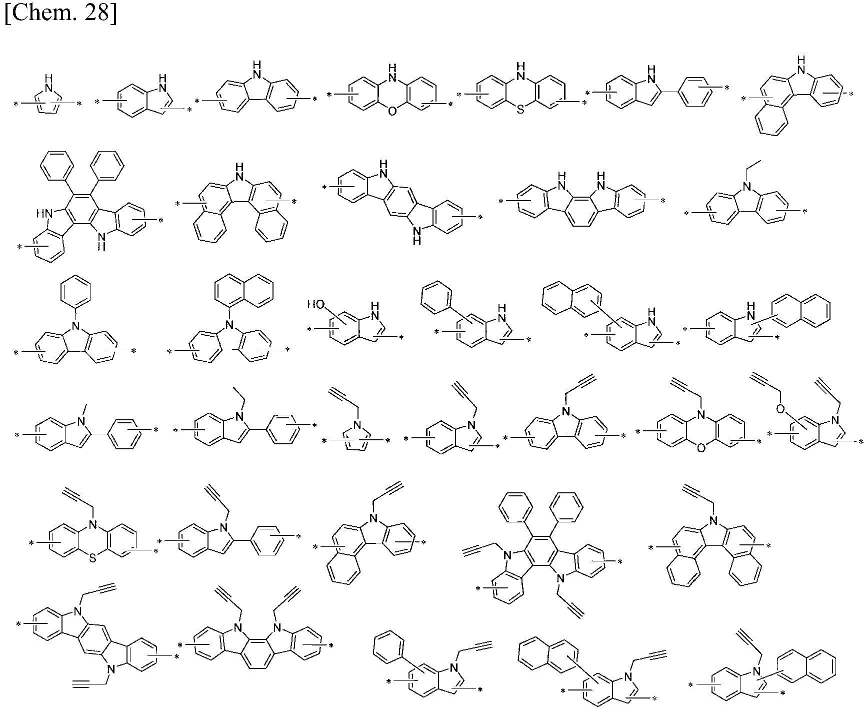

### (Examples of unit structures derived from aromatic hydrocarbons having an oxygen-containing substituent)

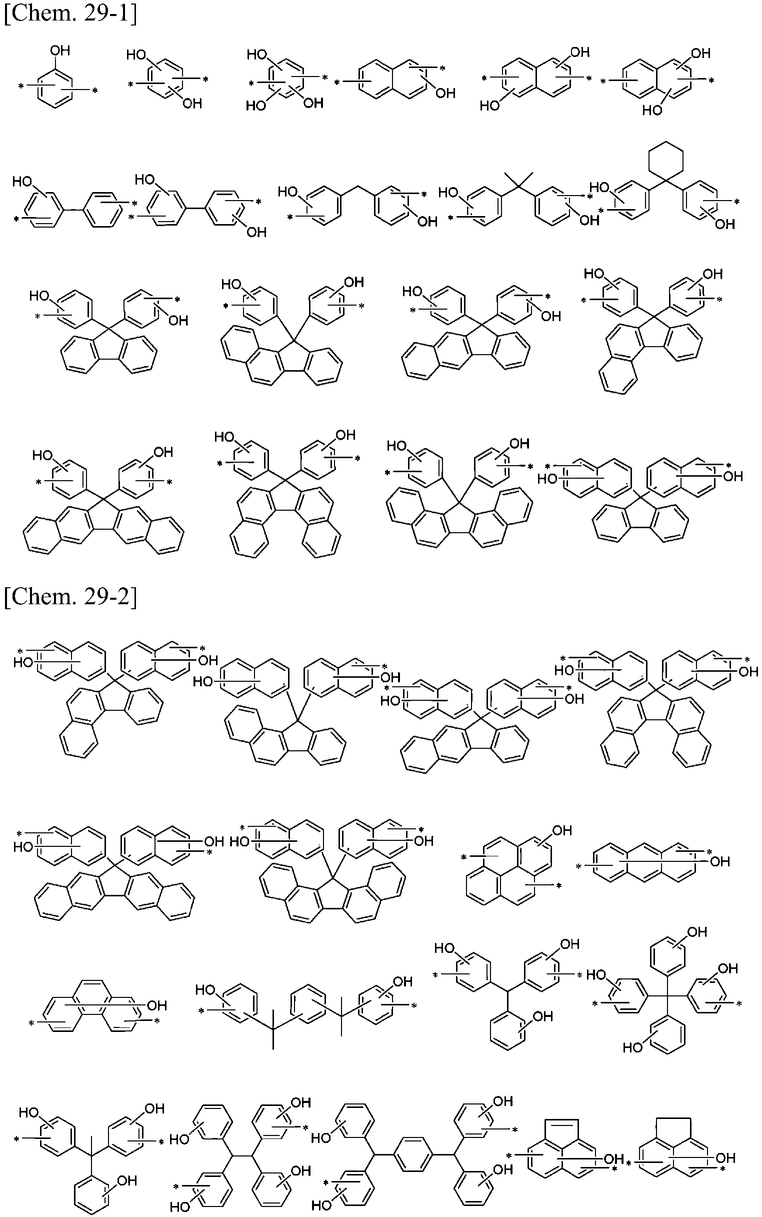

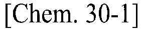

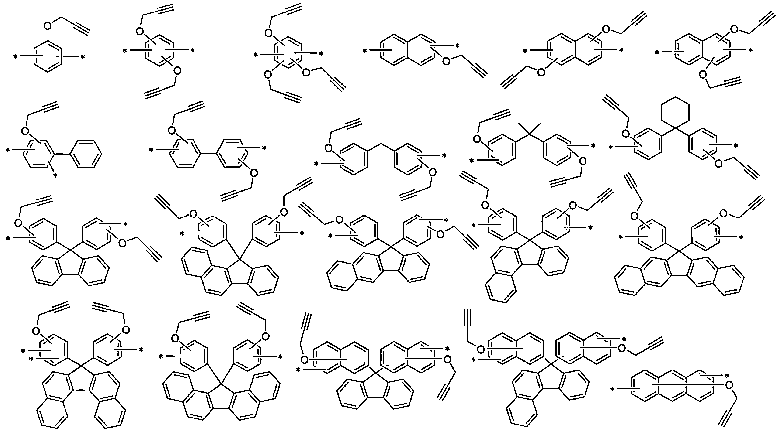

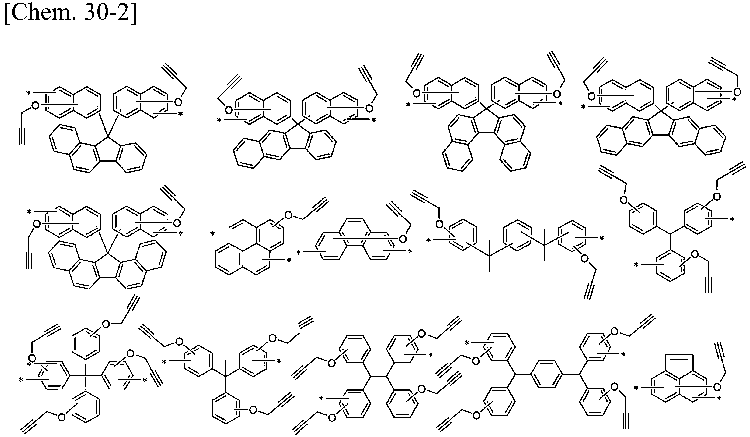

### (Examples of unit structures derived from aromatic hydrocarbons linked via - NH-)

Note that -NH- may be a structure in which a hydrogen atom on N thereof is replaced.

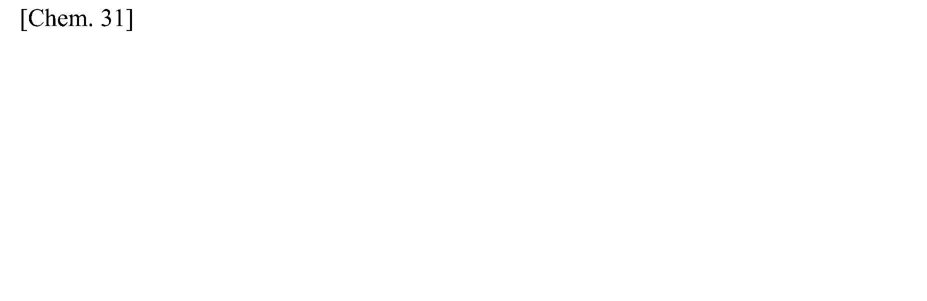

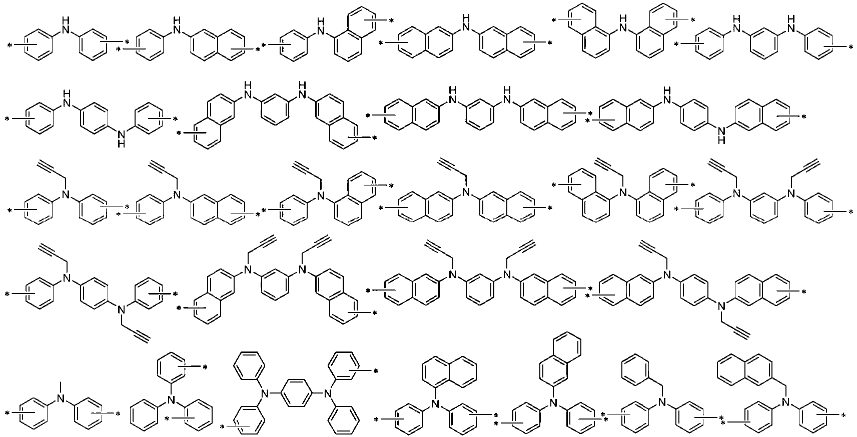

(IIA-2)
The novolac resin preferably has a composite unit structure A-B represented by the following formula (AB):

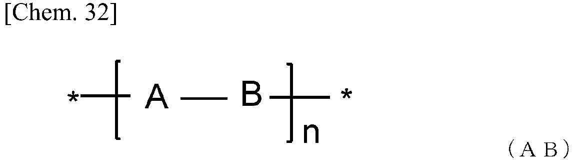

In the formula (AB), "n" represents the number of composite unit structures A-B, and the unit structure A includes a unit structure derived from the compound represented by the formula (A0) described in the (IIA-1).

### (IIA-2-1) Unit Structure B

The unit structure B is one or more types of unit structure having a linkage carbon atom bonded to the aromatic ring in the unit structure A [see the (I-1)], and preferably has a structure represented by formula (B1), (B2), or (B3) described later in (IIA-2-2) to (IIA-2-4). The unit structure B can link the two unit structures A via covalent bonds each to a carbon atom on the aromatic ring in the unit structure A.

At least one of the composite unit structures A-B may be replaced with one or more types of unit structure C, which is one unit structure equivalent thereto and has a structure represented by formulae (C1), (C2), and (C3) described in (IIA-2-2-3), (IIA-2-3-2), and (IIA-2-4-3) respectively later.

### (IIA-2-2) Formula (B1)

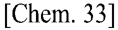

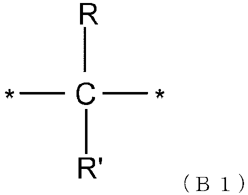

In the formula (B1),
R and R' each independently represent: a hydrogen atom, an aromatic ring residue having 6 to 30 carbon atoms and optionally having a substituent; a heteroring residue having 3 to 30 carbon atoms and optionally having a substituent; or a linear, branched, or cyclic alkyl group having 10 or less carbon atoms and optionally having a substituent.

Two bonding sites in the formula (B1) each can be covalently bonded to the aromatic ring in the unit structure A.

(IIA-2-2-1)
For "aromatic ring" and "heteroring" in the definitions of R and R' in the formula (B1), the (I-3) and (I-4) may be referred to.

In the definitions of R and R' in the formula (B1), examples of the "alkyl group" include a methyl group, an ethyl group, an n-propyl group, an i-propyl group, a cyclopropyl group, an n-butyl group, an i-butyl group, an s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group, an n-heptyl group, an n-octyl group, an n-nonyl group, and an n-decyl group.

R and R' each independently preferably represent phenyl, naphthalenyl, anthracenyl, phenanthrenyl, naphthacenyl, or pyrenyl.

(IIA-2-2-2)
The unit structure having the structure represented by the formula (B1) may have, for example, a structure in which two or three of the structures of the formula (B1) that are the same or different from each other are bonded to a divalent or trivalent linking group to form a dimer or trimer structure. In this case, one of the two bonding sites in each structure of the formula (B1) is bonded to the linking group, as shown in the following formula (B11).

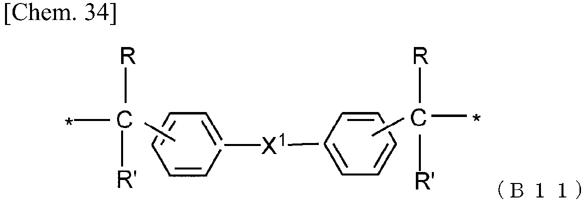

Examples of the linking group include a linking group having two or three aromatic rings (corresponding to the unit structure A). Specific examples of the divalent or trivalent linking group include: the following divalent linking group (L1), which is exemplified in the formula (B11): 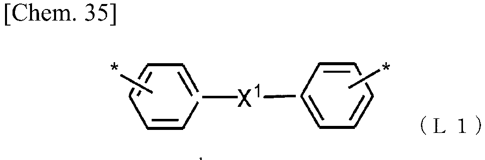 wherein X¹ represents a single bond, a methylene group, an oxygen atom, a sulfur atom, or -N(R⁵)-, and R⁵ represents a hydrogen atom or a hydrocarbon group having 1 to 20 carbon atoms, which encompasses a chain hydrocarbon and a cyclic hydrocarbon that may be an aromatic or non-aromatic.

Other examples include a divalent or trivalent linking group of the following formulae (L2) and (L3): 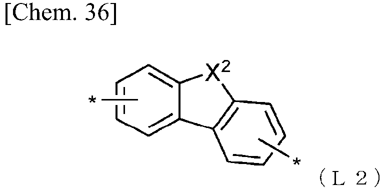 wherein X² represents a methylene group, an oxygen atom, or -N(R⁶)-, R⁶ represents a hydrogen atom, an aliphatic hydrocarbon group having 1 to 10 carbon atoms, or an aromatic hydrocarbon group having 5 to 20 carbon atoms; and

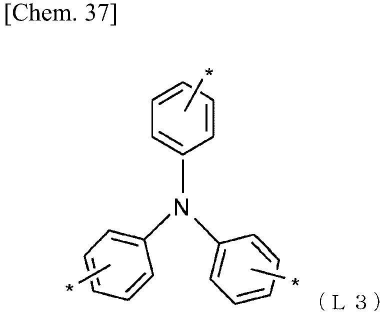

Still another example is a divalent linking group as of the following formula (L4), which can form a covalent bond to a linkage carbon atom through an addition reaction between an acetylide and a ketone.

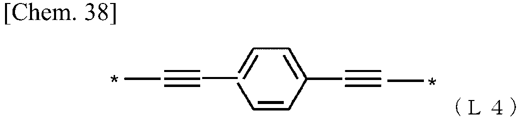

(IIA-2-2-3)
When at least one of R and R' in the formula (B1) represents an aromatic ring residue, the aromatic ring [see Ar in the following formula (B12), for example] may be additionally bonded to another unit structure B.

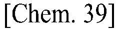

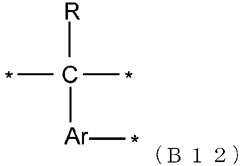

In this case, as in the following formula (C1): 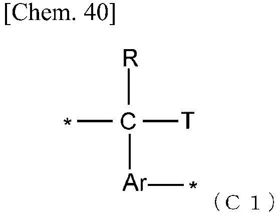 when one bonding site of the linkage carbon atom is bonded to a polymer terminal T (such as a hydrogen atom; various functional groups such as a hydroxy group and an unsaturated aliphatic hydrocarbon group; a terminal unit structure A; and the unit structure A in another polymer chain), the structure may be considered a unit structure C equivalent to the composite unit structure A-B and can replace at least one composite unit structure A-B. Specifically, the polymer chain may be extended by bonding between the aromatic ring in the formula (C1) [Ar in the formula (C1)] and the other unit structure B and also by bonding to the aromatic ring in the unit structure A via a bonding site from the remaining linkage carbon atom shown in the formula (C1).

(IIA-2-2-4)
Some specific examples of the unit structure B having the structure represented by the formula (B1) include the followings. "*" basically represents a bonding site to the unit structure A. Needless to say, the unit structure may be a structure having the exemplified structure as a part of the entirety.

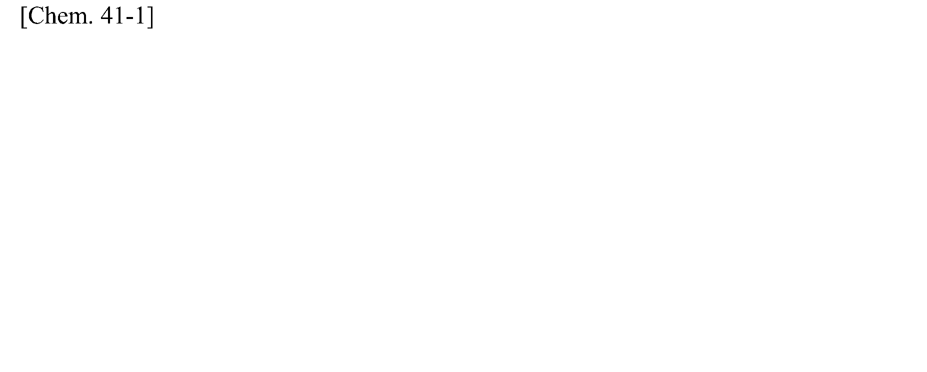

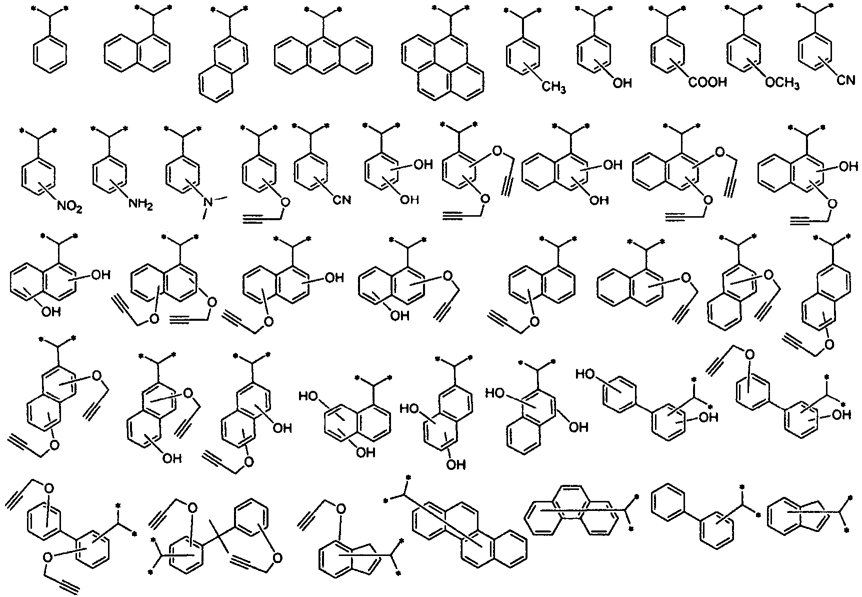

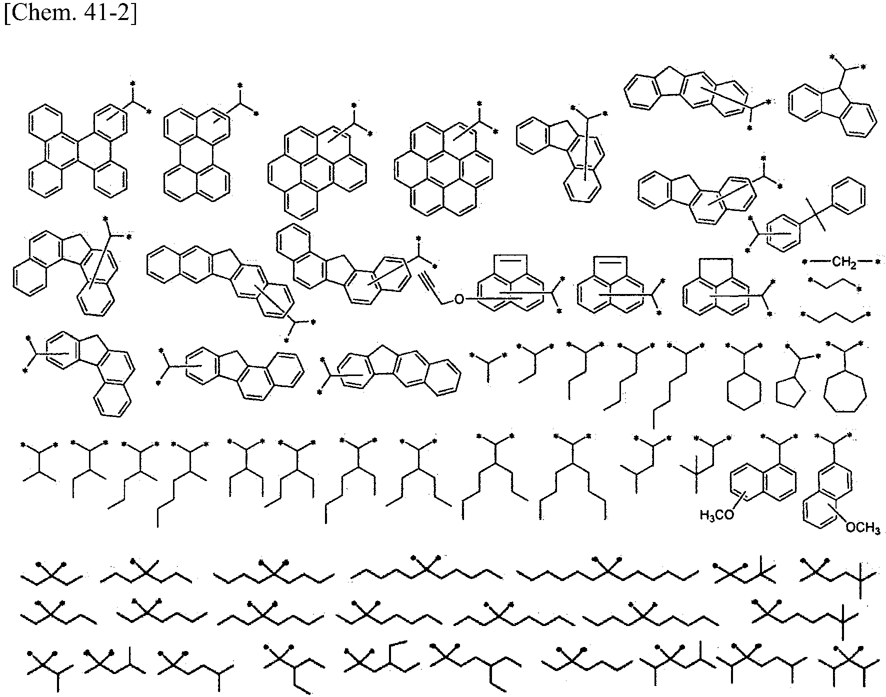

(IIA-2-3) Formula (B2)
[Chem. 42]

*-J¹-Z⁰-J²-* (B2)

In the formula (B2),
Z⁰ represents an aromatic ring residue or an aliphatic ring residue having 6 to 30 carbon atoms and optionally having a substituent; or an organic group in which two aromatic ring residues or aliphatic ring residues are linked via a single bond. Examples of the organic group in which two aromatic ring residues or aliphatic ring residues are linked via a single bond include a divalent residue such as biphenyl, cyclohexylphenyl, and bicyclohexyl.

J¹ and J² each independently represent a direct bond or a divalent organic group optionally having a substituent. The divalent organic group is preferably a linear or branched alkylene group having 1 to 6 carbon atoms and optionally substituted with a hydroxyl group, an aryl group (such as a phenyl group and a substituted phenyl group), or a halo group (for example, fluorine), as a substituent. Examples of the linear alkylene group include a methylene group, an ethylene group, a propylene group, a butylene group, a pentylene group, and a hexylene group.

### (IIA-2-3-1)

The unit structure having the structure represented by the formula (B2) may have a structure in which two or three of the structures of the formula (B2) that are the same or different from each other are bonded to a divalent or trivalent linking group to form a dimer or trimer structure, as with the (IIA-2-2-2) about the formula (B1).

### (IIA-2-3-2)

Since the formula (B2) encompasses an aspect having an aromatic ring [Z⁰ in the formula (B2)], the aromatic ring [for example, an aromatic ring in Z⁰_{Ar} in the following formula (B21)] may be additionally bonded to another unit structure B [a vertical bonding site in the formula (B21)], as with (IIA-2-2-3) of the formula (B1).

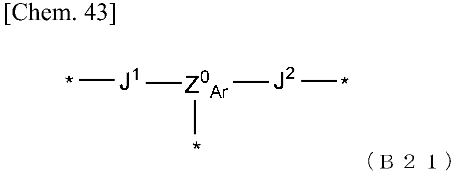

In the formula (B21),
Z⁰_{Ar} represents an aromatic ring residue having 6 to 30 carbon atoms and optionally having a substituent; or an organic group in which two aromatic ring residues or aliphatic ring residues are linked via a single bond, and which has at least one aromatic ring; and a bonding site extending downward from Z⁰_{Ar} extends from an aromatic ring in Z⁰_{Ar}, and
J¹ and J² have the same definitions as in the formula (B2).

In this case, as in the following (C2): 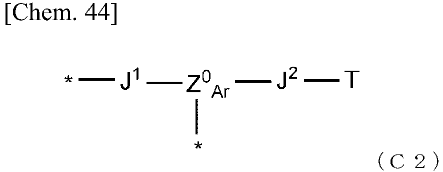 in the formula (C2),
Z⁰_{Ar}, J¹, and J² have the same definitions as in the formula (B21), and

T represents a polymer terminal,
when one bonding site of the linkage carbon atom is bonded to the polymer terminal T (such as a hydrogen atom; various functional groups such as a hydroxy group and an unsaturated aliphatic hydrocarbon group; a terminal unit structure A; and the unit structure A in another polymer chain), the structure may be considered a unit structure C equivalent to the composite unit structure A-B and can replace at least one composite unit structure A-B. Specifically, the polymer chain may be extended by bonding between the aromatic ring in the formula (C2) [the aromatic ring in Z⁰_{Ar} in the formula (C2)] and the other unit structure B and also by bonding to the aromatic ring in the unit structure A via a bonding site from the remaining linkage carbon atom shown in the formula (C2).

(IIA-2-3-3)
Some specific examples of the unit structure having the structure represented by the formula (B2) include the followings. "*" represents a bonding site to the unit structure A. Needless to say, the unit structure may be a unit structure having the exemplified structure as a part of the entirety.

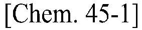

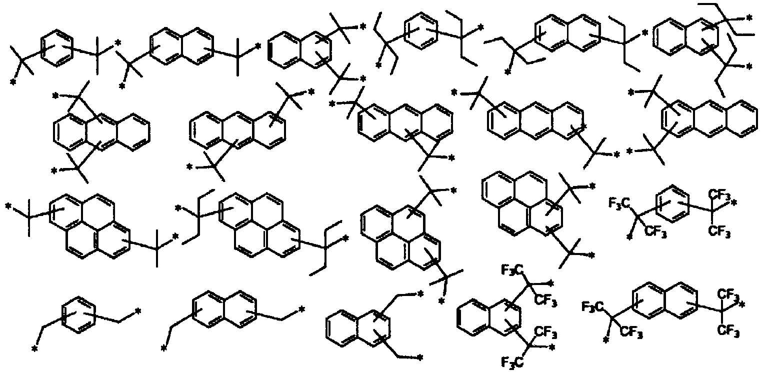

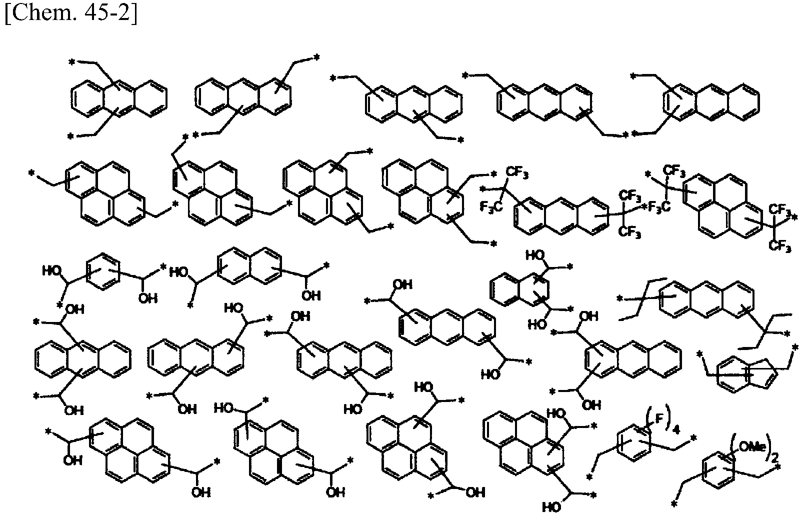

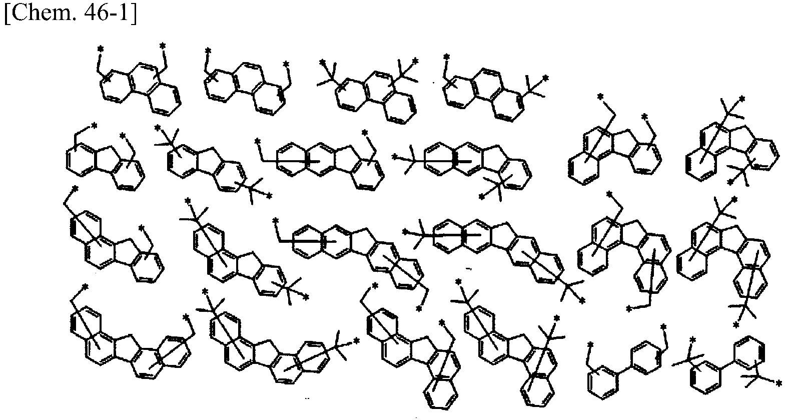

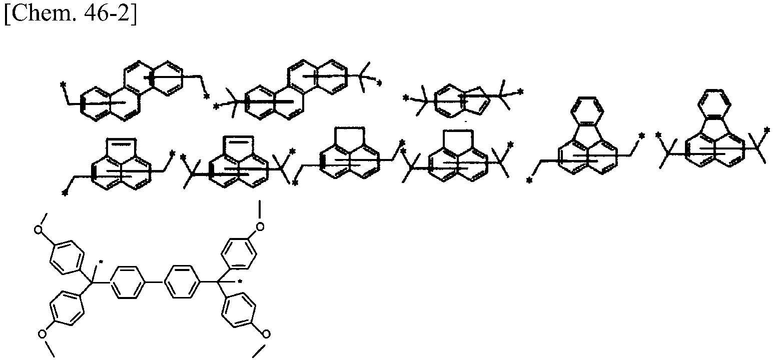

(IIA-2-4) Formula (B3)

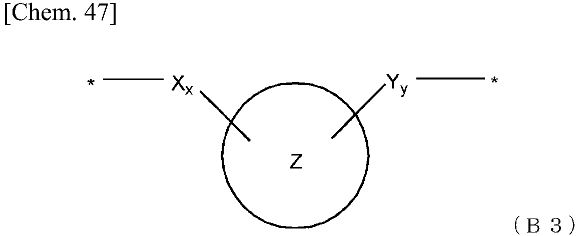

In the formula (B3),
Z represents a single ring or a bicyclic, tricyclic, or tetracyclic condensed ring having 4 to 25 carbon atoms and optionally having a substituent. The number of carbon atoms here means only the number of carbon atoms constituting a cyclic skeleton of the single ring or the bicyclic, tricyclic, or tetracyclic condensed ring excluding a substituent, and when the single ring or the condensed ring is a heteroring, the number of carbon atoms does not include the number of heteroatoms constituting the heteroring.

The single ring is a non-aromatic single ring; at least one single ring constituting the bicyclic, tricyclic, or tetracyclic ring is a non-aromatic single ring, and the other single ring(s) may be an aromatic single ring or a non-aromatic single ring.

The single ring or the bicyclic, tricyclic, or tetracyclic condensed ring may further form a condensed ring with one or more aromatic rings, and specifically form a penta- or higher-cyclic condensed ring. The number of carbon atoms in the penta- or higher-cyclic condensed ring is preferably 40 or less. The number of carbon atoms here means only the number of carbon atoms constituting a cyclic skeleton of the pentaor higher-cyclic condensed ring excluding a substituent, and when the penta- or higher-cyclic condensed ring is a heteroring, the number of carbon atoms does not include the number of heteroatoms constituting the heteroring.

X and Y are the same or different from each other and represent a -CR³¹R³²-group, and R³¹ and R³² are the same or different from each other and represent a hydrogen atom or a hydrocarbon group having 1 to 6 carbon atoms. The hydrocarbon group is preferably a linear, branched, or cyclic aliphatic hydrocarbon group.

"x" and "y" represent the numbers of X and Y, respectively, and each independently represent 0 or 1.

[Chem. 48] *-Xₓ

is bonded to any one carbon atom of the non-aromatic single ring of Z (when x=1), which is referred to as a "carbon atom 1", or extends from the carbon atom 1 (when x=0),

[Chem. 49] Y_{y}-*

is bonded to any one carbon atom of the non-aromatic single ring of Z (when y=1), which is referred to as a "carbon atom 2", or extends from the carbon atom 2 (when y=0), and
the carbon atom 1 and the carbon atom 2 may be identical or different from each other, and when the carbon atom 1 and the carbon atom 2 are different, the carbon atom 1 and the carbon atom 2 may be contained in an identical non-aromatic single ring or may be contained in different non-aromatic single rings.

In the formula (B3), another linkage carbon atom is optionally contained in addition to the carbon atom 1 and the carbon atom 2 [see (IIA-2-4-2), described later].

When Z represents a tri- or higher-cyclic condensed ring, the sequential positional relationship between one or two non-aromatic single rings in which the carbon atoms 1 and 2 are each contained and the remaining single rings in the condensed ring in the formula (B3) may be arbitrary. When the carbon atom 1 and the carbon atom 2 are each contained in different non-aromatic single rings (referred to as "non-aromatic single ring 1" and "non-aromatic single ring 2" respectively), a sequential positional relationship between the non-aromatic single ring 1 and the non-aromatic single ring 2 in the condensed ring may also be arbitrary.

(IIA-2-4-1)
As with the (IIA-2-2-2) about the formula (B1), two or three of the structures of the formula (B3), which are the same or different from each other, may be bonded to a divalent or trivalent linking group to form a dimer or trimer structure.

(IIA-2-4-2)
Some specific examples of the organic group having the structure represented by the formula (B3) include the followings. The bonding site to the unit structure A is not particularly limited. Needless to say, the structure may be a structure having the exemplified structure as a part of the entirety.

Examples having more than two bonding sites (*) are included, and the excess bonding site may be used for bonding, crosslinking, or the like to an aromatic ring in another polymer chain.

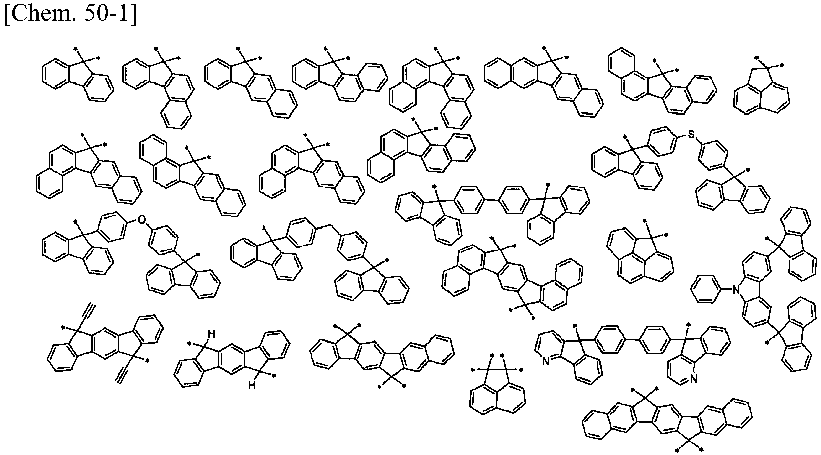

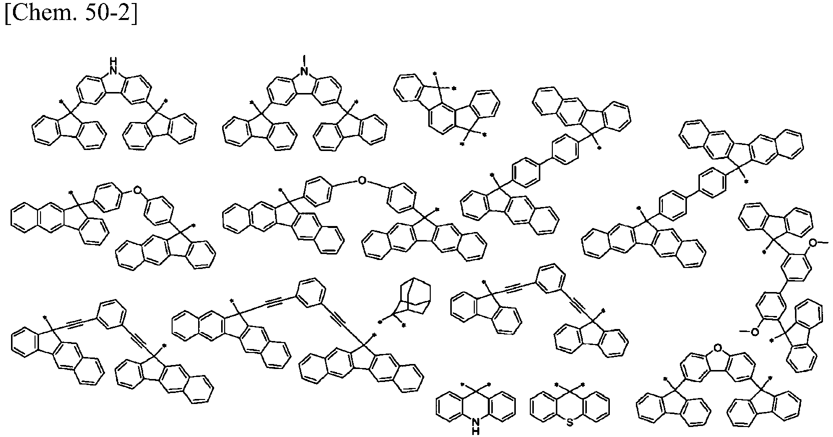

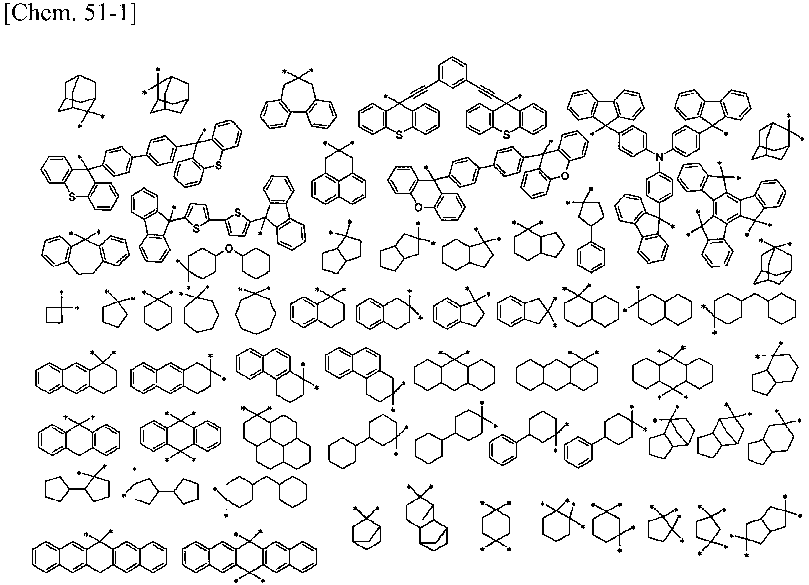

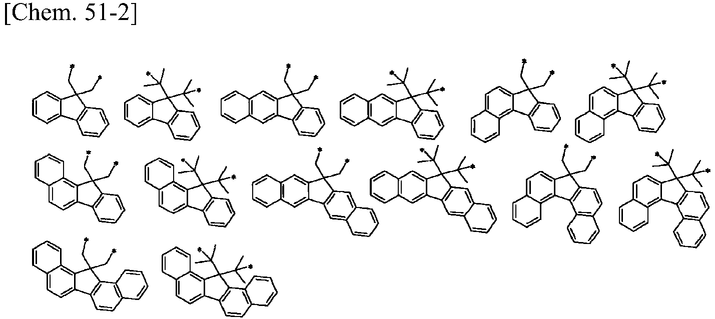

(IIA-2-4-3)
When Z in the formula (B3) has an aromatic ring, the aromatic ring [see Ar¹ in the following formula (B32), for example] may be additionally bonded to another unit structure B.

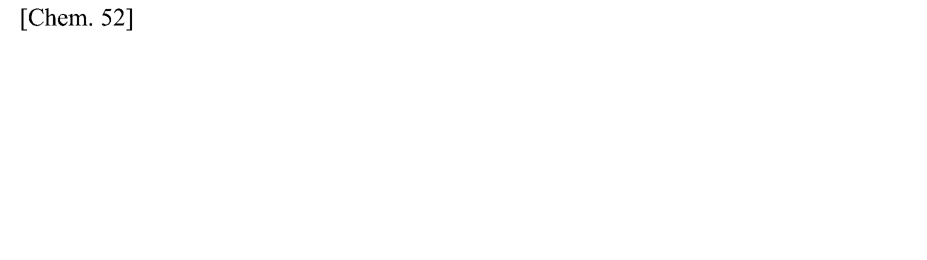

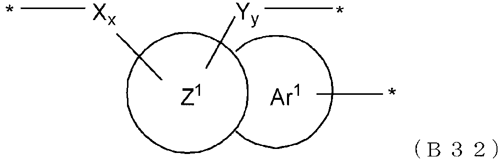

In the formula (B32),
Z¹ represents at least one non-aromatic single ring, Ar¹ represents at least one aromatic single ring forming a condensed ring with the non-aromatic single ring of Z¹, and Z¹ and Ar¹ constitute a bicyclic, tricyclic, tetracyclic, or pentacyclic condensed ring having 8 to 25 carbon atoms and optionally having a substituent, as an entirety. The number of carbon atoms here means only the number of carbon atoms constituting a cyclic skeleton of the bicyclic, tricyclic, tetracyclic, or pentacyclic condensed ring excluding a substituent, and when the bicyclic, tricyclic, tetracyclic, or pentacyclic condensed ring is a heteroring, the number of carbon atoms does not include the number of heteroatoms constituting the heteroring.

The bicyclic, tricyclic, tetracyclic, or pentacyclic condensed ring may further form a condensed ring with one or more aromatic rings, and specifically form a hexa- or higher-cyclic condensed ring. The number of carbon atoms in the hexa- or higher-cyclic condensed ring is preferably 40 or less. The number of carbon atoms here means only the number of carbon atoms constituting a cyclic skeleton of the hexa- or higher-cyclic condensed ring excluding a substituent, and when the hexa- or higher-cyclic condensed ring is a heteroring, the number of carbon atoms does not include the number of heteroatoms constituting the heteroring.

The sequential positional relationship between one or more non-aromatic single rings contained in Z¹ and one or more aromatic single rings contained in Ar¹ in the cyclic organic group encompasses arbitrary relationships. For example, when two or more non-aromatic single rings contained in Z¹ and two or more aromatic single rings contained in Ar¹ are present, the non-aromatic single rings contained in Z¹ and the aromatic single rings contained in Ar¹ may be alternately arranged to form the condensed ring.

X, Y, "x", and "y" have the same definitions as in the formula (B3).

In this case, as in the following formula (C3): 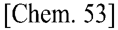 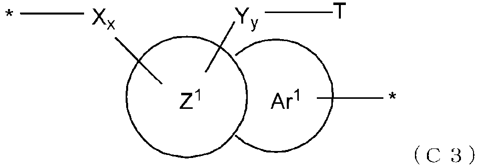 in the formula (C3),
Z¹, Ar¹, X, Y, "x", and "y" have the same definitions as in the formula (B32), and
T represents a polymer terminal,
when one bonding site of a linkage carbon atom is bonded to the polymer terminal T (such as a hydrogen atom; various functional groups such as a hydroxy group and an unsaturated aliphatic hydrocarbon group; a terminal unit structure A; and the unit structure A in another polymer chain), the structure may be considered a unit structure C equivalent to the composite unit structure A-B and can replace at least one composite unit structure A-B. Specifically, the polymer chain may be extended by bonding between the aromatic ring in the formula (C3) [Ar¹ in the formula (C3)] and the other unit structure B and also by bonding to the aromatic ring in the unit structure A via a bonding site from the remaining linkage carbon atom shown in the formula (C3).

(IIA-2-4-4)
A more specific structure of the formula (C3) is, for example, a structure represented by the following formula (C31). In the following formula (C31), T in the formula (C3) is a hydrogen atom as the terminal group, and among "p", k₁ and k₂, each of which can be a bonding site, "p" and k₁ or "p" and k₂ form one unit structure C equivalent to the composite unit structure A-B.

The structure can function also as the unit structure A through k₁ and k₂.

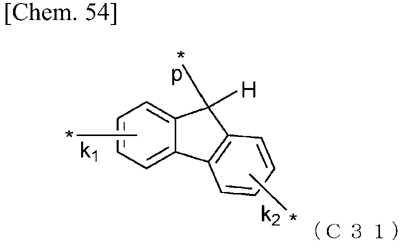

The following formula (C32) represents an example in which T in the formula (C3) represents a phenyl group. In this example, among "p", k₁, k₂, and "m", each of which can be a bonding site, "p" and k₁, "p" and k₂, or "p" and "m" form one unit structure C equivalent to the composite unit structure A-B.

The structure can function also as the unit structure A through k₁ and k₂, k₁ and "m", or k₂ and "m".

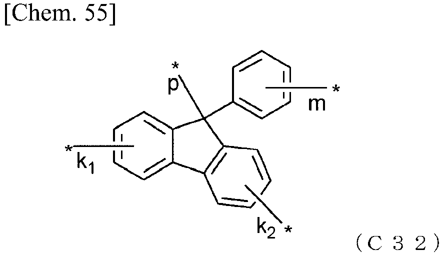

Various more specific examples of the unit structure C of the formula (C3) (one unit structure equivalent to the composite unit structure A-B) include the followings. "*" represents a bonding site to the unit structure A.

In the unit structure C, a bonding site to be bonded to the unit structure B separately extends from an aromatic ring in these structures, but such a bonding site is omitted in the following specific examples. Needless to say, the structure may be a unit structure having the exemplified structure as a part of the entirety.

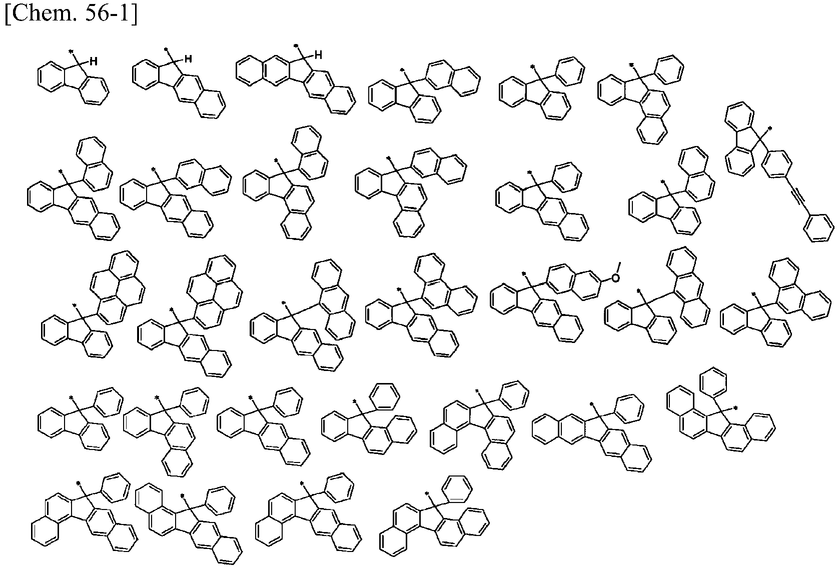

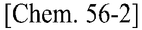

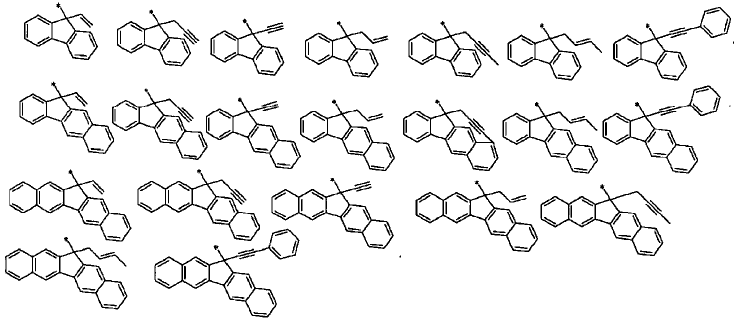

The specific examples may be specific examples of the polymer terminal when the bonding site from the aromatic ring is absent.

(IIA-3)
The novolac resin having the structure represented by the formula (AB) can be prepared by a known method. For example, the novolac resin can be prepared by condensation between a ring-containing compound represented by H-A-H and an oxygen-containing compound represented by OHC-B, O=C-B, RO-B-OR, RO-CH₂-B-CH₂-OR, or the like. Here, A and B in the formula have the same definitions as above. R represents a hydrogen atom, a halogen, or an alkyl group having about 1 to 3 carbon atoms.

The ring-containing compounds may be used singly, or may be used in combination of two or more thereof, and the same applies to the oxygen-containing compound. In this condensation reaction, the oxygen-containing compound may be used at a ratio of 0.1 to 10 mol, preferably 0.1 to 2 mol, relative to 1 mol of the ring-containing compound.

As a catalyst used in the condensation reaction, for example, a mineral acid such as sulfuric acid, phosphoric acid, and perchloric acid; an organic sulfonic acid such as p-toluenesulfonic acid, p-toluenesulfonic acid monohydrate, methanesulfonic acid, and trifluoromethanesulfonic acid; a carboxylic acid such as formic acid and oxalic acid; mercaptopropionic acid may be used. The amount of the catalyst used varies depending on the type of the used catalyst, and is typically 0.001 to 10,000 parts by mass, preferably 0.01 to 1,000 parts by mass, and more preferably 0.05 to 100 parts by mass, per 100 parts by mass of the ring-containing compound (a case of a plurality types thereof, the sum thereof).

The condensation reaction is typically performed by using a solvent, though it may be performed without a solvent. The solvent is not particularly limited as long as the solvent can dissolve the reaction substrates and does not inhibit the reaction. Examples thereof include 1,2-dimethoxyethane, diethylene glycol dimethyl ether, propylene glycol monomethyl ether, propylene glycol monomethyl ether acetate, tetrahydrofuran, tetrahydropyran, dioxane, dichloromethane, 1,2-dichloroethane, toluene, N-methylpyrrolidone, and dimethylformamide. The temperature for the condensation reaction is typically 40°C to 200°C, and preferably 100°C to 180°C. The reaction time varies depending on the reaction temperature, and is typically 5 minutes to 50 hours, and preferably 5 minutes to 24 hours.

The weight-average molecular weight of the novolac resin according to one aspect of the present invention is typically 500 to 100,000, and preferably 600 to 50,000, 700 to 10,000, or 800 to 8,000.

(IIB) Solvent
The resist underlayer film-forming composition of one aspect of the present invention contains a solvent.

The solvent is not particularly limited as long as the solvent can dissolve the specific novolac resin and other optional components added as necessary.

(IIB-1)
Examples of the solvent include methyl cellosolve acetate, ethyl cellosolve acetate, propylene glycol, propylene glycol monomethyl ether, propylene glycol monoethyl ether, propylene glycol monopropyl ether, methyl isobutyl carbinol, propylene glycol monobutyl ether, propylene glycol monomethyl ether acetate, propylene glycol monoethyl ether acetate, propylene glycol monopropyl ether acetate, propylene glycol monobutyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethylene glycol monomethyl ether, ethylene glycol monoethyl ether, ethylene glycol monopropyl ether, ethylene glycol monobutyl ether, ethylene glycol monomethyl ether acetate, ethylene glycol monoethyl ether acetate, ethylene glycol monopropyl ether acetate, ethylene glycol monobutyl ether acetate, diethylene glycol monomethyl ether, diethylene glycol monoethyl ether, diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, propylene glycol dibutyl ether, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, methyl 2-hydroxy-2-methylpropionate, ethyl 2-hydroxy-2-methylpropionate, methyl 3-methoxy-2-methylpropionate, methyl 2-hydroxy-3-methylbutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, toluene, xylene, methyl ethyl ketone, methyl propyl ketone, methyl butyl ketone, 2-heptanone, 3-heptanone, 4-heptanone, cyclohexanone, N,N-dimethylformamide, N-methylacetamide, N,N-dimethylacetamide, N-methylpyrrolidone, 4-methyl-2-pentanol, and γ-butyrolactone. These solvents may be used singly, or in combination of two or more thereof.

(IIB-2)
A solvent having a boiling point of 160°C or higher may be contained in combination with a solvent having a boiling point of lower than 160°C.

As such a high-boiling-point solvent, the following compounds described in WO 2018/131562 A1 may be preferably used, for example.

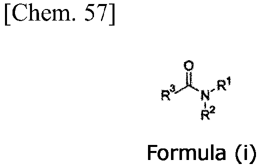

In the formula (i), R¹, R², and R³ each represent a hydrogen atom; or an alkyl group having 1 to 20 carbon atoms and optionally interrupted by an oxygen atom, a sulfur atom, or an amide bond, and may be the same or different from each other and be bonded to each other to form a cyclic structure.

Alternatively, 1,6-diacetoxyhexane (boiling point: 260°C) and tripropylene glycol monomethyl ether (boiling point: 242°C), which are described in JP 2021-84974 A, and other various high-boiling-point solvents described in paragraph 0082 of this Patent Publication may be preferably used.

Alternatively, dipropylene glycol monomethyl ether acetate (boiling point: 213°C), diethylene glycol monoethyl ether acetate (boiling point: 217°C), diethylene glycol monobutyl ether acetate (boiling point: 247°C), dipropylene glycol dimethyl ether (boiling point: 171°C), dipropylene glycol monomethyl ether (boiling point: 187°C), dipropylene glycol monobutyl ether (boiling point: 231°C), tripropylene glycol monomethyl ether (boiling point: 242°C), γ-butyrolactone (boiling point: 204°C), benzyl alcohol (boiling point: 205°C), propylene carbonate (boiling point: 242°C), tetraethylene glycol dimethyl ether (boiling point: 275°C), 1,6-diacetoxyhexane (boiling point: 260°C), dipropylene glycol (boiling point: 230°C), and 1,3-butylene glycol diacetate (boiling point: 232°C), which are described in JP 2019-20701 A, and other various high-boiling-point solvents described in paragraphs 0023 to 0031 in this Patent Publication may be preferably used.

### (IIC) Acid and/or Salt Thereof, and/or Acid Generator

The resist underlayer film-forming composition of one aspect of the present invention may contain an acid and/or a salt thereof, and/or an acid generator.

(IIC-1)
Examples of the acid include p-toluenesulfonic acid, trifluoromethanesulfonic acid, salicylic acid, 5-sulfosalicylic acid, 4-phenolsulfonic acid, camphorsulfonic acid, 4-chlorobenzenesulfonic acid, benzenedisulfonic acid, 1-naphthalenesulfonic acid, citric acid, benzoic acid, hydroxybenzoic acid, and naphthalenecarboxylic acid.

As a salt, a salt of the aforementioned acid may be used. The salt is not particularly limited, and an ammonia derivative salt such as a trimethylamine salt and a triethylamine salt, a pyridine derivative salt, a morpholine derivative salt, and the like may be suitably used.

The acids and/or the salts thereof may be used singly, or may be used in combination of two or more thereof. The content is typically 0.0001 to 20 mass%, preferably 0.0005 to 10 mass%, and further preferably 0.01 to 5 mass% relative to the total solid content.

(IIC-2)
Examples of the acid generator include a thermal acid generator and a photoacid generator.

(IIC-2-1)
Examples of the thermal acid generator include 2,4,4,6-tetrabromocyclohexadienone, benzoin tosylate, 2-nitrobenzyl tosylate, K-PURE (registered trademark) series: CXC-1612, CXC-1614, TAG-2172, TAG-2179, TAG-2678, TAG-2689, and TAG-2700 (manufactured by King Industries, Inc.), SI-45, SI-60, SI-80, SI-100, SI-110, and SI-150 (manufactured by SANSHIN CHEMICAL INDUSTRY CO., LTD.), and other organic sulfonic acid alkyl esters.

(IIC-2-2)
The photoacid generator generates an acid when the resist is exposed. Thus, the acidity of the underlayer film can be regulated. This is one method for adjusting the acidity of the underlayer film to the acidity of the resist as an upper layer. Regulating the acidity of the underlayer film can regulate the pattern shape of the resist to be formed in the upper layer.

Examples of the photoacid generator contained in the resist underlayer film-forming composition of the present invention include an onium salt compound, a sulfonimide compound, and a disulfonyldiazomethane compound.

Examples of the onium salt compound include: an iodonium salt compound such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate; and a sulfonium salt compound such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Examples of the disulfonyldiazomethane compound include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

(IIC-2-3)
The acid generators may be used singly, or may be used in combination of two or more thereof.

When the acid generator is used, the amount thereof is 0.01 to 10 parts by mass, 0.1 to 8 parts by mass, or 0.5 to 5 parts by mass, per 100 parts by mass of the solid content of the resist underlayer film-forming composition.

### (IID) Other Optional Components

The resist underlayer film-forming composition of one aspect of the present invention may contain a crosslinker, a surfactant, a light absorber, a rheology adjuster, an adhesive auxiliary, and the like, in addition to the above, as necessary.

### (IID-1) Crosslinker

Representative examples of the crosslinker include an aminoplast crosslinker and a phenoplast crosslinker.

As the crosslinker, a crosslinker having high heat resistance may be used. As the crosslinker having high heat resistance, a compound containing a substituent that can form crosslink and having an aromatic ring (for example, a benzene ring or a naphthalene ring) in the molecule may be preferably used.

(IID-1-1)
Examples of the aminoplast crosslinker include a highly alkylated, alkoxylated, or alkoxyalkylated melamine, benzoguanamine, glycoluril, or urea, and a polymer thereof. The aminoplast crosslinker is preferably a crosslinker having at least two substituents that can form crosslink, and is a compound such as methoxymethylated glycoluril, butoxymethylated glycoluril, methoxymethylated melamine, butoxymethylated melamine, methoxymethylated benzoguanamine, butoxymethylated benzoguanamine, methoxymethylated urea, butoxymethylated urea, methoxymethylated thiourea, or butoxymethylated thiourea. A condensate of these compounds may also be used.

The aminoplast crosslinker is preferably at least one selected from the group consisting of tetramethoxymethylglycoluril and hexamethoxymethylmelamine.

Some specific examples thereof include the followings.

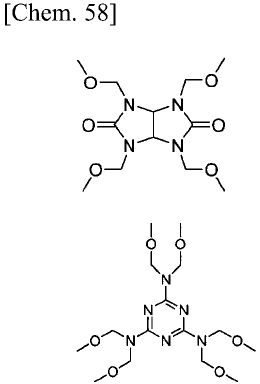

(IID-1-2)
Examples of the phenoplast crosslinker include a highly alkylated, alkoxylated, or alkoxyalkylated aromatic compound and a polymer thereof. The phenoplast crosslinker is preferably a crosslinker having, in one molecule, at least two substituents that can form crosslink, and is a compound such as 2,6-dihydroxymethyl-4-methylphenol, 2,4-dihydroxymethyl-6-methylphenol, bis(2-hydroxy-3-hydroxymethyl-5-methylphenyl)methane, bis(4-hydroxy-3-hydroxymethyl-5-methylphenyl)methane, 2,2-bis(4-hydroxy-3,5-dihydroxymethylphenyl)propane, bis(3-formyl-4-hydroxyphenyl)methane, bis(4-hydroxy-2,5-dimethylphenyl)formylmethane, and α,α-bis(4-hydroxy-2,5-dimethylphenyl)-4-formyltoluene. A condensate of these compounds may also be used.

In addition to the above, other examples of such a compound include a compound having a partial structure of the following formula (4), and a polymer or oligomer having a repeating unit of the following formula (5).

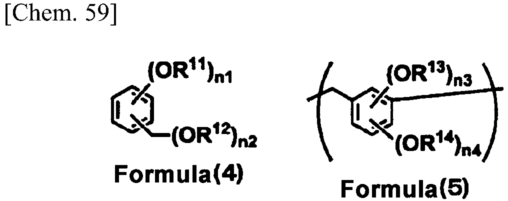

The R¹¹, R¹², R¹³, and R¹⁴ represent a hydrogen atom or an alkyl group having 1 to 10 carbon atoms, and these alkyl groups may be any of the aforementioned example. n1 represents an integer of 1 to 4, n2 represents an integer of 1 to (5-n1), and (n1+n2) represents an integer of 2 to 5. n3 represents an integer of 1 to 4, n4 represents 0 to (4-n3), and (n3+n4) represents an integer of 1 to 4. The oligomer and the polymer that can be used have the number of repeating unit structures within a range of 2 to 100, or 2 to 50.

Some specific examples include the followings.

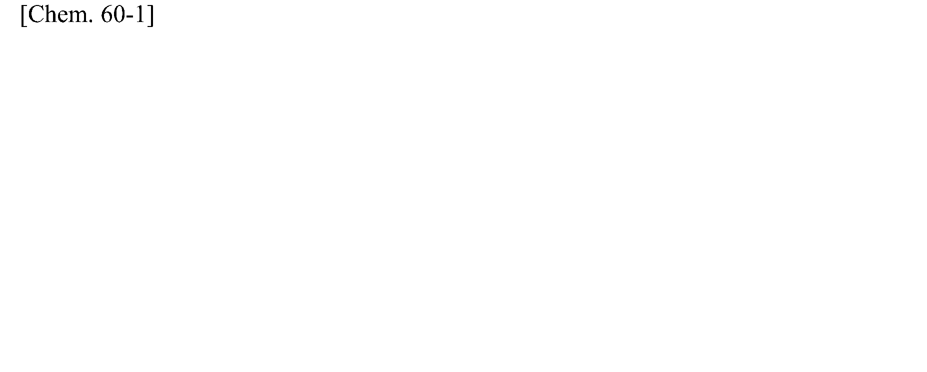

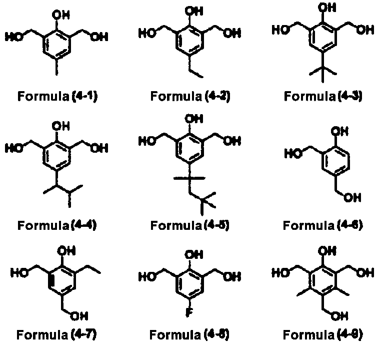

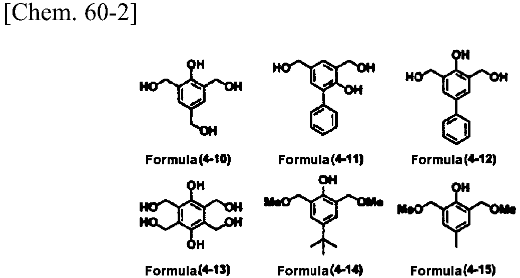

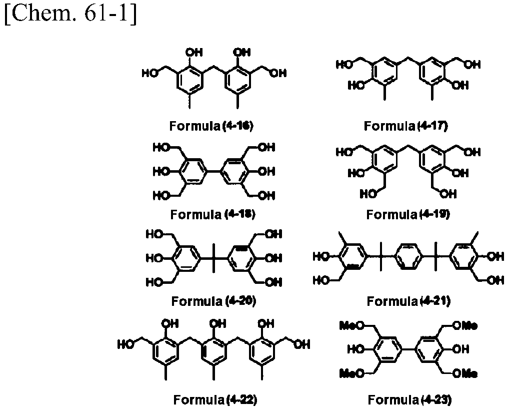

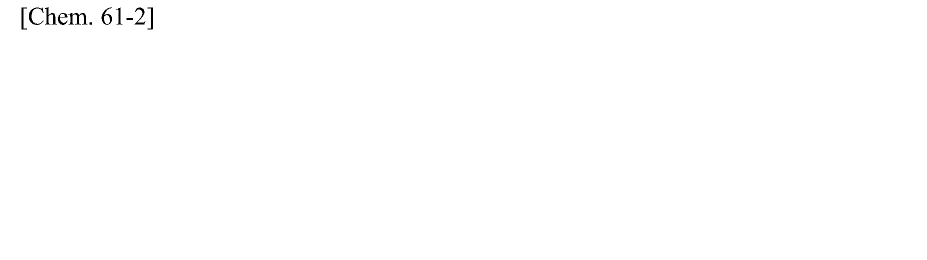

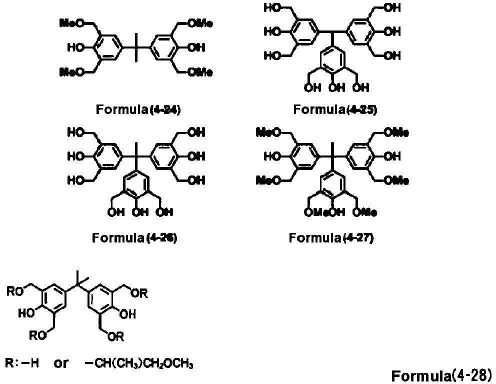

(IID-1-3)
The crosslinkers such as the aminoplast crosslinkers and the phenoplast crosslinkers, may be used singly, or may be used in combination of two or more thereof. The aminoplast crosslinker and the phenoplast crosslinker can be manufactured by a known method or a method equivalent thereto, or a commercially available product thereof may be used.

The amount of the crosslinker used, such as the aminoplast crosslinker and the phenoplast crosslinker, varies depending on the coating solvent used, the base substrate used, a required solution viscosity, a required film shape, and the like, and is 0.001 mass% or more, 0.01 mass% or more, 0.05 mass% or more, 0.5 mass% or more, or 1.0 mass% or more, and 80 mass% or less, 50 mass% or less, 40 mass% or less, 20 mass% or less, or 10 mass% or less, relative to a total solid content of the resist underlayer film-forming composition according to the present invention.

### (IID-2) Surfactant

In the resist underlayer film-forming composition according to the present invention, a surfactant may be incorporated to avoid generation of pinholes and striations and to further improve coating properties against surface unevenness.

Examples of the surfactant include: a nonionic surfactant such as: a polyoxyethylene alkyl ether such as polyoxyethylene lauryl ether, polyoxyethylene stearyl ether, polyoxyethylene cetyl ether, and polyoxyethylene oleyl ether; a polyoxyethylene alkylaryl ether such as polyoxyethylene octylphenol ether and polyoxyethylene nonylphenol ether; a polyoxyethylene-polyoxypropylene block copolymer; a sorbitan fatty acid ester such as sorbitan monolaurate, sorbitan monopalmitate, sorbitan monostearate, sorbitan monooleate, sorbitan trioleate, and sorbitan tristearate; a polyoxyethylene sorbitan fatty acid ester such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate;
a fluorine surfactant such as EFTOP series EF301, EF303, and EF352 (manufactured by Tohkem Products Corporation, bland names), MEGAFACE (registered trademark) series F171, F173, R-30, and R-40 (manufactured by DIC Corporation, bland names), Fluorad series FC430 and FC431 (manufactured by Sumitomo 3M Limited, bland names), and Asahi Guard (registered trademark) AG710, Surflon series S-382, SC101, SC102, SC103, SC104, SC105, and SC106 (manufactured by AGC, Inc., bland names); and
organosiloxane polymer KP341 (manufactured by Shin-Etsu Chemical Co., Ltd.).

The amount of the surfactant incorporated is typically 2.0 mass% or less, and preferably 1.0 mass% or less, relative to the total solid content of the resist underlayer film-forming composition according to the present invention. These surfactants may be added singly, or may be added in combination of two or more thereof.

### (IID-3) Other Additives

As the light absorber, commercially available light absorbers described in "Technology and Market of Industrial Dyes" (CMC Publishing Co., Ltd.) and "Dye Handbook" (edited by The Society of Synthetic Organic Chemistry, Japan) may be suitably used, including C.I. Disperse Yellow 1, 3, 4, 5, 7, 8, 13, 23, 31, 49, 50, 51, 54, 60, 64, 66, 68, 79, 82, 88, 90, 93, 102, 114, and 124; C.I. Disperse Orange 1, 5, 13, 25, 29, 30, 31, 44, 57, 72, and 73; C.I. Disperse Red 1, 5, 7, 13, 17, 19, 43, 50, 54, 58, 65, 72, 73, 88, 117, 137, 143, 199, and 210; C.I. Disperse Violet 43; C.I. Disperse Blue 96; C.I. Fluorescent Brightening Agent 112, 135, and 163; C.I. Solvent Orange 2 and 45; C.I. Solvent Red 1, 3, 8, 23, 24, 25, 27, and 49; C.I. Pigment Green 10; and C.I. Pigment Brown 2. The light absorber is incorporated in an amount of typically 10 mass% or less, and preferably 5 mass% or less, relative to the total solid content of the resist underlayer film-forming composition according to the present invention.

The rheology adjuster is added mainly for a purpose of increasing flowability of the resist underlayer film-forming composition to enhance the uniformity of the film thickness of the resist underlayer film and to improve the filling properties of the resist underlayer film-forming composition inside holes particularly in a baking process. Specific examples thereof include: a phthalate derivative such as dimethyl phthalate, diethyl phthalate, diisobutyl phthalate, dihexyl phthalate, and butyl isodecyl phthalate; an adipate derivative such as dinormalbutyl adipate, diisobutyl adipate, diisooctyl adipate, and octyl decyl adipate; a maleate derivative such as di(n-butyl) maleate, diethyl maleate, and dinonyl maleate; an oleate derivative such as methyl oleate, butyl oleate, and tetrahydrofurfuryl oleate; or a stearate derivative such as n-butyl stearate and glyceryl stearate. The rheology adjuster is incorporated in an amount of typically less than 30 mass% relative to the total solid content of the resist underlayer film-forming composition according to the present invention.

The adhesive auxiliary is added mainly for a purpose of increasing adhesiveness between the substrate or the resist and the coating formed of the resist underlayer film-forming composition to prevent peeling of the resist particularly in development. Specific examples thereof include: a chlorosilane such as trimethylchlorosilane, dimethylvinylchlorosilane, methyldiphenylchlorosilane, and chloromethyldimethylchlorosilane; an alkoxysilane such as trimethylmethoxysilane, dimethyldiethoxysilane, methyldimethoxysilane, dimethylvinylethoxysilane, diphenyldimethoxysilane, and phenyltriethoxysilane; a silazane such as hexamethyldisilazane, N,N'-bis(trimethylsilyl)urea, dimethyltrimethylsilylamine, and trimethylsilylimidazole; a silane such as vinyltrichlorosilane, γ-chloropropyltrimethoxysilane, γ-aminopropyltriethoxysilane, and γ-glycidoxypropyltrimethoxysilane; a heterocyclic compound such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, and mercaptopyrimidine; and a urea or thiourea compound such as 1,1-dimethylurea and 1,3-dimethylurea. The adhesive auxiliary is incorporated in an amount of typically less than 5 mass%, and preferably less than 2 mass%, relative to the total solid content of the resist underlayer film-forming composition according to the present invention.

The solid content of the resist underlayer film-forming composition according to the present invention is 0.1 to 70 mass%, or 0.1 to 60 mass%. The solid content refers to the content of all the components excluding the solvent from the resist underlayer film-forming composition. The solid content may contain the crosslinkable resin at a proportion of 1 to 99.9 mass%, 50 to 99.9 mass%, 50 to 95 mass%, or 50 to 90 mass%.

### [III. Resist Underlayer Film]

One aspect of the present invention is a resist underlayer film on a semiconductor substrate, which is a baked product of a coating film comprising the resist underlayer film-forming composition according to the present invention. The resist underlayer film can be formed, for example, using the resist underlayer film-forming composition according to the present invention as follows.

The resist underlayer film-forming composition of one aspect of the present invention is applied on a substrate used for manufacturing a semiconductor device (for example, a silicon wafer substrate, a silicon dioxide coated substrate (a SiO₂ substrate), a silicon nitride substrate (a SiN substrate), a silicon oxynitride substrate (a SiON substrate), a titanium nitride substrate (a TiN substrate), a tungsten substrate (a W substrate), a glass substrate, an ITO substrate, a polyimide substrate, a low dielectric constant material (low-k material) coated substrate, and the like. Hereinafter, this will be also referred to as a semiconductor substrate.), by an appropriate applying method such as a spinner and a coater, and then the composition is baked by using a heating means such as a hotplate to form the resist underlayer film. The baking condition is appropriately selected from a baking temperature of 80°C to 800°C and a baking time of 0.3 to 60 minutes. The baking temperature is preferably 150°C to 500°C, and the baking time is preferably 0.5 to 2 minutes. As an atmosphere gas during the baking, air may be used, and inert gas such as nitrogen and argon may also be used. In one aspect, the oxygen concentration is particularly preferably 1% or less. Here, the film thickness of the underlayer film to be formed is, for example, 10 to 1000 nm, or may be 20 to 500 nm, 30 to 400 nm, or 50 to 300 nm. Furthermore, if a quartz substrate is used as a substrate, a replica of the quartz imprint mold (a mold replica) can be produced.

On the resist underlayer film of an aspect of the present invention, an adhesion layer and/or a silicon-containing layer containing 99 mass% or less or 50 mass% or less of Si can be formed by coating or vapor deposition. For example, such layers can be formed by a method in which a composition for forming an adhesion layer, described in JP 2013-202982 A or JP 5827180 B2, or a silicon-containing resist underlayer film (an inorganic resist underlayer film), described in WO 2009/104552 A1, is applied by spin-coating to form a layer, or a Si-based inorganic material film can be formed by a CVD method or the like.

The resist underlayer film-forming composition of one aspect of the present invention can be applied to a semiconductor substrate having a portion having a step and a portion having no step (a so-called stepped substrate) and baked to thereby reduce the step between the portion having a step and the portion having no step.

Another aspect of the present invention is a method for manufacturing a laminate of two or more layers including a semiconductor substrate and a resist underlayer film, the method including: a step of applying the resist underlayer film-forming composition on at least one surface of the semiconductor substrate; and a step of baking the resulting coating film to form the resist underlayer film. In the laminate, a resist film may be stacked on the surface of the resist underlayer film opposite from the semiconductor substrate (stacked in an order of the semiconductor substrate / the resist underlayer film / the resist film). Another aspect of the present invention is a use of the resist underlayer film-forming composition for forming a resist underlayer film on a semiconductor substrate.

Another aspect of the present invention is a laminate of two or more layers including a semiconductor substrate and a resist underlayer film. Still another aspect of the present invention is a laminate in which the resist underlayer film and a resist film are stacked in this order on at least one surface of a semiconductor substrate. Still another aspect of the present invention is a use of the resist underlayer film-forming composition in manufacturing such laminates or semiconductor devices.

### [IV. Method for Manufacturing Semiconductor Device]

(IVA) A method for manufacturing a semiconductor device of one aspect of the present invention includes:
a step of forming a resist underlayer film from the resist underlayer film-forming composition of one aspect of the present invention on a semiconductor substrate;
optionally a step of forming a hard mask on the resist underlayer film;
a step of forming a resist film on the resist underlayer film or the hard mask; and
a step of forming a resist pattern in the resist film by irradiation with light or electron beam and development.

Specifically, the method for manufacturing a semiconductor device is as follows.
(i) A method for manufacturing a semiconductor device of one aspect of the present invention includes:
   a step of forming a resist underlayer film from the resist underlayer film-forming composition of one aspect of the present invention on a semiconductor substrate;
   a step of forming a resist film on the resist underlayer film;
   a step of forming a resist pattern in the resist film by irradiation with light or electron beam and development;
   a step of etching and patterning the resist underlayer film through the resist pattern; and
   a step of processing the semiconductor substrate through the patterned resist underlayer film.
(ii) A method for manufacturing a semiconductor device of one aspect of the present invention includes:
   a step of forming a resist underlayer film from the resist underlayer film-forming composition of one aspect of the present invention on a semiconductor substrate;
   a step of forming a hard mask on the resist underlayer film;
   a step of forming a resist film on the hard mask;
   a step of forming a resist pattern in the resist film by irradiation with light or electron beam and development;
   a step of etching and patterning the hard mask through the resist pattern;
   a step of etching and patterning the resist underlayer film through the patterned hard mask; and
   a step of processing the semiconductor substrate through the patterned resist underlayer film.
(iii) A method for manufacturing a semiconductor device of one aspect of the present invention includes:
   a step of forming a resist underlayer film from the resist underlayer film-forming composition of one aspect of the present invention on a semiconductor substrate;
   a step of forming a hard mask on the resist underlayer film;
   a step of forming a resist film on the hard mask;
   a step of forming a resist pattern in the resist film by irradiation with light or electron beam and development;
   a step of etching and patterning the hard mask through the resist pattern;
   a step of etching and patterning the resist underlayer film through the patterned hard mask;
   a step of removing the hard mask; and
   a step of processing the semiconductor substrate through the patterned resist underlayer film.
(iv) A method for manufacturing a semiconductor device of one aspect of the present invention includes:
   a step of forming a resist underlayer film from the resist underlayer film-forming composition of one aspect of the present invention on a semiconductor substrate;
   a step of forming a hard mask on the resist underlayer film;
   a step of forming a resist film on the hard mask;
   a step of forming a resist pattern in the resist film by irradiation with light or electron beam and development;
   a step of etching and patterning the hard mask through the resist pattern;
   a step of etching and patterning the resist underlayer film through the patterned hard mask;
   a step of removing the hard mask;
   a step of forming a deposited film (a spacer) on the resist underlayer film cleaned of the hard mask;
   a step of processing the deposited film (the spacer) by etching;
   a step of removing the resist underlayer film having been patterned while leaving the deposited film (the spacer) having been patterned and
   a step of processing the semiconductor substrate through the deposited film (the spacer) having been patterned.

The semiconductor substrate can be processed using the manufacturing methods (i) to (iv) above. Another aspect of the present invention is a method for forming a resist pattern used for manufacturing a semiconductor, wherein the method comprises a step of applying the resist underlayer film-forming composition according to the present invention onto a semiconductor substrate; and a step of then baking the composition to form a resist underlayer film. Still another aspect of the present invention is a semiconductor device having a resist underlayer film, which is a baked product of a coating film of the resist underlayer film-forming composition, on at least one surface of a semiconductor substrate. The resist underlayer film may be patterned according to circuit wiring.

(IVB)
The step of forming a resist underlayer film from the resist underlayer film-forming composition of one aspect of the present invention is as described in the [III. Resist Underlayer Film].

On the resist underlayer film formed in the above step, a hard mask such as a silicon-containing film may be formed as a second resist underlayer film, and the resist pattern may be formed thereon (the (IVA) (ii) to (iv)).

The hard mask may be a coating film formed of an inorganic substance or the like, or may be a vapor-deposited film of an inorganic substance or the like formed by a vapor deposition method such as CVD and PVD. Examples thereof include a SiON film, a SiN film, and a SiO₂ film. That is, the hard mask is preferably formed by coating a composition containing an inorganic substance or by vapor deposition of an inorganic substance.

Furthermore, on the hard mask, an anti-reflective film (BARC) may be formed, or a resist-shape correcting film having no anti-reflective ability may be formed.

The resist film is formed on the resist underlayer film or the hard mask. The resist film is not particularly limited as long as it is a material that can be patterned by irradiation with light or electron beam, and can be formed, for example, by applying a resist film-forming composition onto the resist underlayer film or the hard mask and baking it. As the resist film-forming composition, a positive resist, a negative resist, etc. can be used.

In the step of forming the resist pattern, exposure is performed through a mask (a reticle) for forming a predetermined pattern or with direct writing. As an exposure light source, g-line, i-line, KrF excimer laser, ArF excimer laser, EUV, or electron beam may be used, for example. After the exposure, post exposure baking (PEB) is performed as necessary. Thereafter, development is performed with a developing liquid (for example, a 2.38 mass% tetramethylammonium hydroxide aqueous solution and butyl acetate), followed by rinsing with a rinsing liquid or pure water, and the used developing liquid is removed. Thereafter, the post baking is preferably performed to dry the resist pattern and increase adhesiveness to the base.

The etching step for the resist underlayer film and the hard mask performed after the formation of the resist pattern, and the processing step for the semiconductor substrate is preferably performed by dry etching.

For processing the hard mask (the silicon-containing layer), the resist underlayer film, and the substrate, the following gas: CF₄, CHF₃, CH₂F₂, CH₃F, C₄F₆, C₄F₈, O₂, N₂O, NO₂, H₂, He, or the like may be used. These gases may be used singly, or two or more thereof may be mixed and used. Furthermore, with any of these gases, argon, nitrogen, carbon dioxide, carbonyl sulfide, sulfur dioxide, neon, nitrogen trifluoride, or the like may be mixed and used.

(IVC)
The resist film may be pattern-formed by a nanoimprinting method or a directed self-assembly method. That is, the step of forming the resist pattern in the resist film may be performed by a nanoimprinting method or a directed self-assembly method.

In the nanoimprinting method, a resist composition is molded by using a mold that is transparent to irradiation light and that has a formed pattern. In the directed self-assembly method, a patten is formed by using a directed self-assembly film of, for example, a diblock polymer (such as polystyrene-polymethyl methacrylate) that naturally forms a regular structure with a nanometer order.

In the nanoimprinting method, a silicon-containing layer (a hard mask layer) may be optionally formed on the resist underlayer film by coating or vapor deposition before applying a curable composition for forming a resist film, and an adhesion layer may be further formed on the resist underlayer film or on the silicon-containing layer (the hard mask layer) by coating or vapor deposition. The curable composition for forming a resist film may be applied on the adhesion layer.

(IVD)
For a purpose of simplifying the process steps and reducing damage to the substrate to be processed, a wet etching treatment may be performed. This leads to reduction in variation in the size after processing and pattern roughness, and therefore can process the substrate with a good yield. Thus, in the (IVA) (iii) to (iv), the hard mask can be removed with any one of etching or an alkaline chemical reagent. Particularly when the alkaline chemical reagent is used, the following material is preferably contained as an alkali component, though components are not limited.

Examples of the alkali component include tetramethylammonium hydroxide, tetraethylammonium hydroxide, tetrapropylammonium hydroxide, tetrabutylammonium hydroxide, methyltripropylammonium hydroxide, methyltributylammonium hydroxide, ethyltrimethylammonium hydroxide, dimethyldiethylammonium hydroxide, benzyltrimethylammonium hydroxide, hexadecyltrimethylammonium hydroxide, (2-hydroxyethyl)trimethylammonium hydroxide, monoethanolamine, diethanolamine, triethanolamine, 2-(2-aminoethoxy)ethanol, N,N-dimethylethanolamine, N,N-diethylethanolamine, N,N-dibutylethanolamine, N-methylethanolamine, N-ethylethanolamine, N-butylethanolamine, N-methyldiethanolamine, monoisopropanolamine, diisopropanolamine, triisopropanolamine, tetrahydrofurfurylamine, N-(2-aminoethyl)piperazine, 1,8-diazabicyclo[5.4.0]undecene-7, 1,4-diazabicyclo[2.2.2]octane, hydroxyethylpiperazine, piperazine, 2-methylpiperazine, trans-2,5-dimethylpiperazine, cis-2,6-dimethylpiperazine, 2-piperidinemethanol, cyclohexylamine, and 1,5-diazabicyclo[4.3.0]nonene-5. In view of operability, tetramethylammonium hydroxide and tetraethylammonium hydroxide are particularly preferable, and an inorganic base may be used in combination with the quaternary ammonium hydroxide. As the inorganic base, a hydroxide of an alkali metal such as potassium hydroxide, sodium hydroxide, or rubidium hydroxide is preferable, and potassium hydroxide is more preferable.

In the (IVA) (iv), the method further includes a step of forming a deposited film (a spacer) on the resist underlayer film cleaned of the hard mask; a step of processing the deposited film (the spacer) by etching; a step of removing the resist underlayer film having been patterned while leaving the deposited film (the spacer) having been patterned and a step of processing the semiconductor substrate through the deposited film (the spacer) having been patterned.

By forming a deposited film (a spacer) on the resist underlayer film after removing the hard mask, a sidewall can be created on the resist underlayer film. Films of SiO₂, SiN, SiON, TiN, W, metals, etc.; other oxide films, vapor deposition films, and the like, can be used as materials for the deposited film (the spacer). The deposited film (the spacer) can be formed by a vapor deposition process such as CVD (chemical vapor deposition) or ALD (atomic layer deposition).

The step of etching for the deposited film (the spacer) is preferably performed by dry etching. Thereafter, the patterned resist underlayer film is removed to leave the patterned deposited film (the spacer), and the semiconductor substrate is processed through the patterned deposited film (the spacer), thereby manufacturing a semiconductor device.

### Examples

### o Synthesis of Polymer

Compounds A, compounds B, compounds C, catalysts D, solvents E, reprecipitation solvents F, and separation solvents G shown below were used for synthesizing polymers of structural formulae (S1) to (S21) and (S'1) to (S'9) used for resist underlayer films and synthesizing polymers of structural formulae (SS1) to (SS2) for Comparative Examples.

### o Compounds A to C

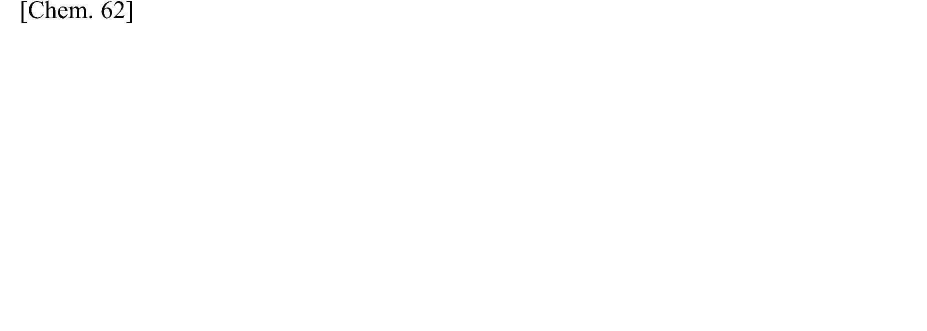

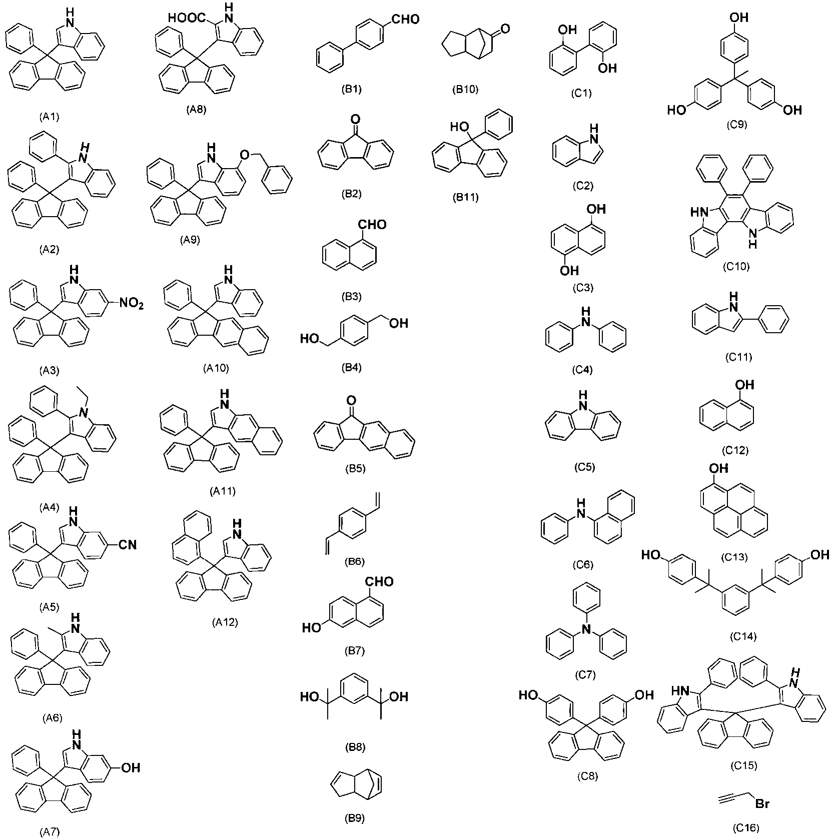

### o Catalysts D, Solvents E, Reprecipitation Solvents F, and Separation solvents G

Methanesulfonic acid: D1
Mercaptopropionic acid: D2
Tetrabutylammonium iodide: D3
Propylene glycol monomethyl ether acetate (=PGMEA): E1
Tetrahydrofuran (=THF): E2
25% Sodium hydroxide aqueous solution: E3
Methanol: F1
Methanol/Ammonia aqueous solution: F2
Butyl acetate/Water: G1

### [Synthesis Example 1] Synthesis of Resin S1

Into a flask, 15.0 g of A1, 7.7 g of B1, 4.0 g of D1, and 62.3 g of E1 were added. Thereafter, the mixture was heated to reflux under nitrogen and allowed to react for about 14 hours. After the reaction was terminated, the product was reprecipitated in F1, and the resin was dried to obtain (S1). The weight-average molecular weight Mw in terms of polystyrene measured by GPC was about 1,200. The obtained resin was dissolved in cyclohexanone (=CYH) to obtain a target compound solution.

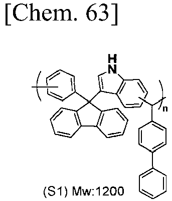

### [Synthesis Examples 2 to 21] Synthesis of Resins S2 to S21

Resins (S2) to (S21) in the quantitative ratio shown in the following Table 1 were synthesized in the same manner as in Synthesis Example 1, except for the solvent for redissolving the obtained resin was appropriately changed to PGMEA in consideration of the solubility of the polymer. In addition, after dissolving the resin in a solvent, ion exchange was performed for 4 hours by using a cation-exchange resin and an anion-exchange resin as necessary.

**[Table 1-1]**

| (Table 1) | | | | | | |
|---|---|---|---|---|---|---|
| Synthesis Example | Structural formula | Compound | Catalyst | Solvent | Temperature / Time | Reprecipitation |
| 1 | S1 | A1/B1 | D1 | E1 | 150°C/ | F1 |
| | | 15.0 g/7.7 g | 4.0 g | 62.3 g | 14 hours | |
| 2 | S2 | A1/B2 | D1/D2 | E1 | 100°C/ | F1 |
| | | 15.0 g/7.6 g | 4.0 g/ 2.2 g | 62.1 g | 14 hours | |
| 3 | S3 | A1/B3/B4 | D1 | E1 | 150°C/ | F1 |
| | | 10.0 g/3.1 g/1.2 g | 2.7 g | 36.7 g | 1 hour | |
| 4 | S4 | A1/B2/C1/C2 | D1/D2 | E1 | 100°C/ | F1 |
| | | 10.0 g/8.4 g/1.7 g/1.1 g | 4.5 g/2.5 g | 60.0 g | 14 hours | |
| 5 | S5 | A1/B2/C3/C4 | D1/D2 | E1 | 100°C/ | F1 |
| | | 10.0 g/8.4 g/1.9 g/1.2 g | 4.5 g/2.5 g | 48.4 g | 14 hours | |
| 6 | S6 | A1/B2/C5/C6 | D1/D2 | E1 | 100°C/ 14 hours | F1 |
| | | 10.0 g/8.4 g/2.0 g/1.5 g | 4.5 g/2.5 g | 61.6 g | | |
| 7 | S7 | A1/B2/C7/C8 | D1/D2 | E1 | 100°C/ 15 hours | F1 |
| | | 10.0 g/8.4 g/1.7 g/4.1 g | 4.5 g/2.5 g | 67.0 g | | |
| 8 | S8 | A1/B2/C9/C10 | D1/D2 | E1 | 100°C/ 15 hours | F1 |
| | | 10.0 g/8.4 g/2.9 g/3.8 g | 4.5 g/2.5 g | 69.0 g | | |
| 9 | S9 | A1/B2/C11/C12 | D1/D2 | E1 | 100°C/ 15 hours | F1 |
| | | 10.0 g/8.4 g/1.8 g/1.4 g | 4.5 g/2.5 g | 67.0 g | | |
| 10 | S10 | A1/A2/A3/B2 | D1/D2 | E1 | 100°C/ 14 hours | F1 |
| | | 8.0 g/4.9 g/3.0 g/6.7 g | 3.6 g/2.0 g | 61.0 g | | |
| 11 | S11 | A1/A4/A5/B2 | D1/D2 | E1 | 100°C/ 14 hours | F1 |
| | | 8.0 g/5.2 g/2.9 g/6.7 g | 3.6 g/2.0 g | 61.4 g | | |

**[Table 1-2]**

| | | | | | | |
|---|---|---|---|---|---|---|
| 12 | S12 | A1/A6/A7/B2 | D1/D2 | E1 | 100°C/ 14 hours | F1 |
| | | 8.0 g/2.8 g/4.1 g/6.7 g | 3.6 g/2.0 g | 58.9 g | | |
| 13 | S13 | A1/A8/A9/B2 | D1/D2 | E1 | 100°C/ 14 hours | F1 |
| | | 8.0 g/4.2 g/3.5 g/6.7 g | 3.6 g/2.0 g | 60.5 g | | |
| 14 | S14 | A1/B1/B5/C13 | D1/D2 | E1 | 100°C/ 14 hours | F1 |
| | | 10.0 g/5.1 g/2.8 g/2.6 g | 3.8 g/2.1 g | 56.7 g | | |
| 15 | S15 | A1/B6/B7/C7 | D1 | E1 | 100°C/ 14 hours | F1 |
| | | 10.0 g/1.4 g/4.2 g/1.7 g | 3.4 g | 48.2 g | | |
| 16 | S16 | A2/B1/B8/C14 | D1 | E1 | 100°C/ 14 hours | F1 |
| | | 10.0 g/4.2 g/1.1 g/2.0 g | 2.8 g | 46.9 g | | |
| 17 | S17 | A1/B1/B9/C4 | D1 | E1 | 100°C/ 14 hours | F1 |
| | | 10.0 g/5.1 g/1.6 g/2.0 g | 3.8 g | 42.1 g | | |
| 18 | S18 | A1/B2/C3/C15 | D1/D2 | E1 | 100°C/ 14 hours | F1 |
| | | 10.0 g/8.4 g/1.5 g/5.1 g | 4.5 g/2.5 g | 68.9 g | | |
| 19 | S19 | A1/B2/B10/B11 | D1/D2 | E1 | 100°C/ 21 hours | F1 |
| | | 10.0 g/3.0 g/0.8 g/2.9 g | 3.2 g/0.9 g | 46.6 g | | |
| 20 | S20 | A1/A10/B2 | D1/D2 | E1 | 100°C/ 21 hours | F1 |
| | | =10.0 g/4.9 g/7.2 g | 3.8 g/2.1 g | 60.5 g | | |
| 21 | S21 | A1/A11/A12/B2 | D1/D2 | E1 | 100°C/ 21 hours | F1 |
| | | =10.0 g/2.1 g/2.1 g/6.3 g | 3.8 g/2.1 g | 60.5 g | | |

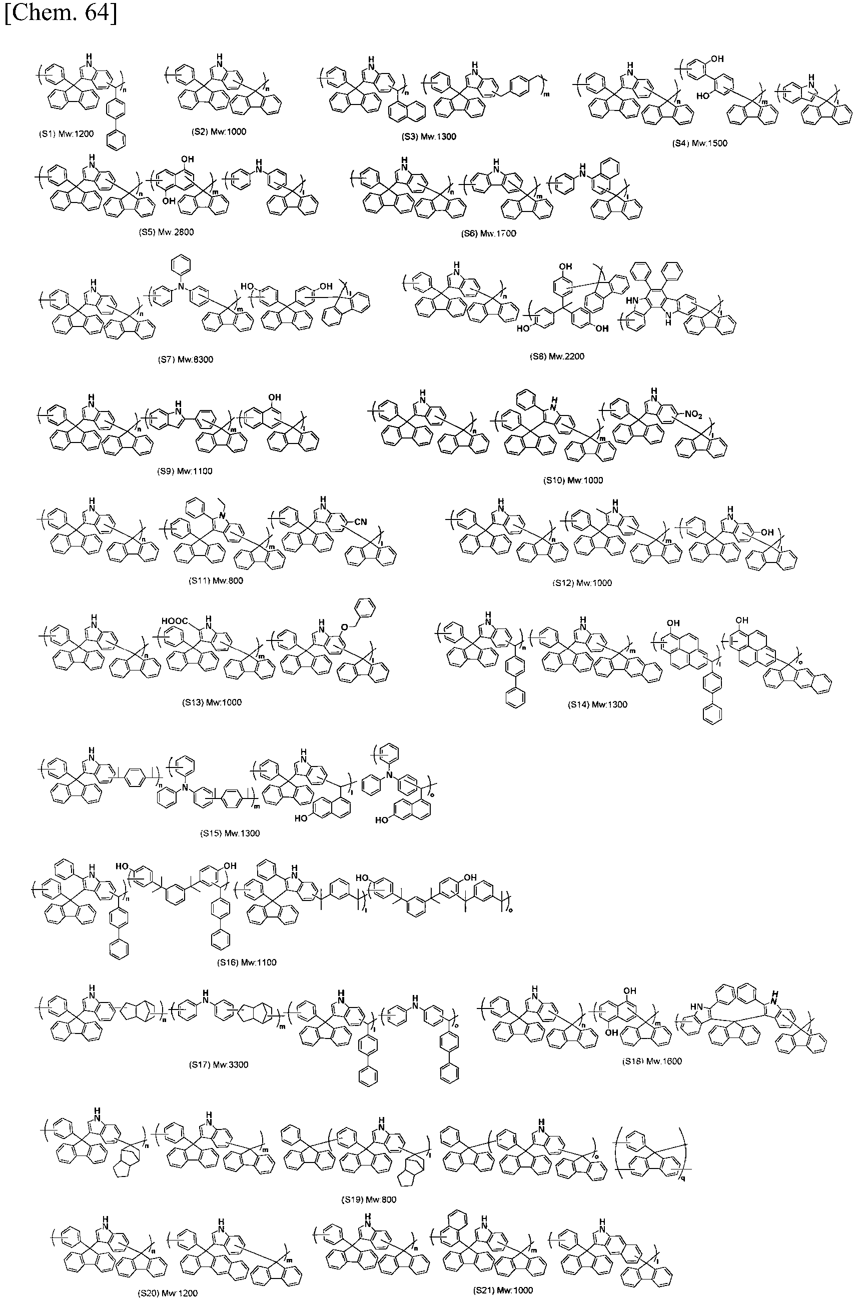

### [Synthesis Example 1'] Synthesis of Resin S'1

Into a flask, 7.0 g of S1, 4.7 g of C16, 0.2 g of D3, 17.8 g of E2 and 8.0 g of E3 were added. Thereafter, the mixture was heated to 55°C under nitrogen and allowed to react for about 18 hours. After the reaction was terminated, fractionation with G1 was repeated, and the organic layer was condensed. The condensed product was reprecipitated in F1, and the resultant was dried to obtain a resin (S'1). The weight-average molecular weight Mw in terms of polystyrene measured by GPC was about 1,700. The obtained resin was dissolved in PGMEA, and ion exchange was performed for 4 hours by using a cation-exchange resin and an anion-exchange resin to obtain a target compound solution.

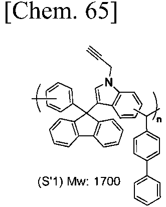

### [Synthesis Examples 2' to 9'] Synthesis of Resins S'2 to S'9

Resins S'2 to S'9 were synthesized in the same manner as in Synthesis Example 1' in the quantitative ratio shown in Table 2 below.

### [Table 2]

**(Table 2)**

| Synthesis Example | Structural formula | Compound | Catalyst | Solvent | Temperature / Time | Separation solvent | Reprecipitation |
|---|---|---|---|---|---|---|---|
| 1' | S'1 | S1/C16 | D3 | E2/E3 | 55°C/ 18 hours | G1 | F1 |
| | | 70 g/4.7 g | 0.2 g | 17.8 g/8.0 g | | | |
| 2' | S'2 | S2/C16 | D3 | E2/E3 | 55°C/ 18 hours | G1 | F1 |
| | | 10.0 g/6.9 g | 0.4 g | 25.8 g/11.6 g | | | |
| 3' | S'3 | S4/C16 | D3 | E2/E3 | 55°C/ 18 hours | G1 | F1 |
| | | 10.0 g/12.0 g | 0.6 g | 34.0 g/15.3 g | | | |
| 4' | S'4 | S6/C16 | D3 | E2/E3 | 55°C/ 18 hours | G1 | F1 |
| | | 10.0 g/10.3 g | 0.5 g | 31.3 g/14.1 g | | | |
| 5' | S'5 | S7/C16 | D3 | E2/E3 | 55°C/ 18 hours | G1 | F1 |
| | | 10.0 g/8.4 g | 0.4 g | 28.3 g/12.7 g | | | |
| 6' | S'6 | S8/C16 | D3 | E2/E3 | 55°C/ 18 hours | G1 | F1 |
| | | 10.0 g/7.2 g | 0.4 g | 26.3 g/11.9 g | | | |
| 7' | S'7 | S12/C16 | D3 | E2/E3 | 55°C/ 18 hours | G1 | F1 |
| | | 7.0 g/4.8 g | 0.3 g | 18.1 g/8.1 g | | | |
| 8' | S'8 | S14/C16 | D3 | E2/E3 | 55°C/ 18 hours | G1 | F1 |
| | | 10.0 g/9.3 g | 0.5 g | 29.7 g/13.4 g | | | |
| 9' | S'9 | S18/C16 | D3 | E2/E3 | 55°C/ 18 hours | G1 | F1 |
| | | 10.0 g/11.0 g | 0.6 g | 32.4 g/14.6 g | | | |

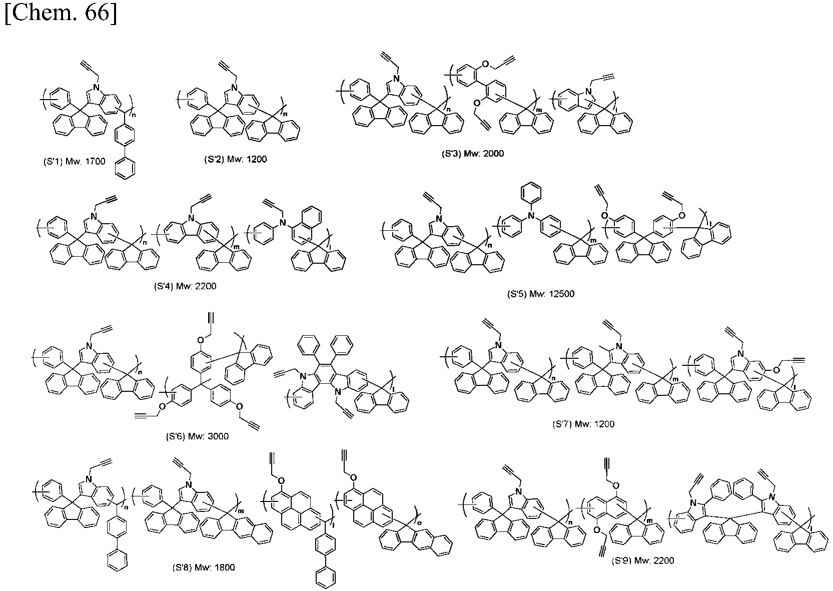

### [Comparative Synthesis Example 1]

Comparative Resins SS1 to SS2 were synthesized in the same manner as in Synthesis Example 1 in the quantitative ratio shown in Table 3 below.

### [Table 3]

**(Table 3)**

| Comparative Synthesis Example | Structural formula | Compound | Catalyst | Solvent | Temperature / Time | Reprecipitation |
|---|---|---|---|---|---|---|
| 1 | SS1 | C11/B3 | D1 | E1 | 120°C/ 5 hours | F2 |
| | | 15.0 g/12.1 g | 1.5 g | 42.9 g | | |
| 2 | SS2 | C2/B3 | D1 | E1 | 120°C/ | F2 |
| | | 15.0 g/23.1 g | 3.7 g | 62.7 g | 5 hours | |

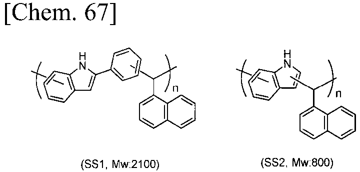

### ∘ Preparation of Material for Resist Underlayer Film

The polymers (S1) to (S21), (S'1) to (S'9) and (SS1) to (SS2), crosslinkers (CL1 to CL2), acid generators (Ad1 to Ad2), solvents (propylene glycol monomethyl ether acetate (PGMEA), propylene glycol monomethyl ether (PGME), and cyclohexanone (CYH)), and MEGAFACE (registered trademark) R-40 (manufactured by DIC Corporation, H1) as a surfactant were mixed at a ratio shown in the following Table 4, and the mixture was filtered through a micro-filter made of polytetrafluoroethylene with 0.1 µm to prepare a material for a resist underlayer film (M1 to M22, M'1 to M'9 and Comparative M1 to Comparative M3).

In Table 4, the numerical values for the crosslinkers, the acid generators, and the surfactant refer to the relative mass of each of the crosslinkers, the acid generators, and the surfactant when the polymer mass is taken as 100; and the numerical value for each solvent refers to the relative mass of each solvent when the total solvent mass is taken as 100.

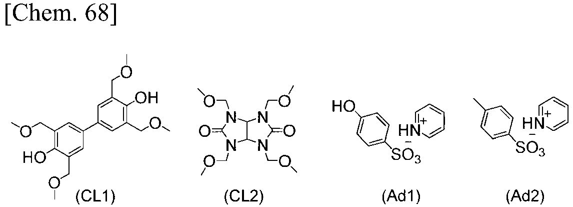

**[Table 4-1]**

| (Table 4) | | | | | | | |
|---|---|---|---|---|---|---|---|
| Composition | Polymer | Crosslinker | Acid generator | Surfactant | Solvent (100 in total) | | |
| M1 | S1 | CL1 | Ad1 | H1 | PGMEA | PGME | CYH |
| | 100 | - | - | - | 40 | 20 | 40 |
| M2 | S1 | CL1 | Ad1 | H1 | PGMEA | PGME | CYH |
| | 100 | 20 | 3.0 | 0.1 | 40 | 20 | 40 |
| M3 | S2 | CL1 | Ad1 | H1 | PGMEA | PGME | CYH |
| | 100 | 20 | 3.0 | 0.1 | 70 | 30 | 0 |
| M4 | S3 | CL1 | Ad1 | H1 | PGMEA | PGME | CYH |
| | 100 | 20 | 3.0 | 0.1 | 40 | 20 | 40 |
| M5 | S4 | CL1 | Ad1 | H1 | PGMEA | PGME | CYH |
| | 100 | 20 | 3.0 | 0.1 | 70 | 30 | 0 |
| M6 | S5 | CL1 | Ad1 | H1 | PGMEA | PGME | CYH |
| | 100 | 20 | 3.0 | 0.1 | 50 | 10 | 40 |
| M7 | S6 | CL1 | Ad1 | H1 | PGMEA | PGME | CYH |
| | 100 | 20 | 3.0 | 0.1 | 70 | 30 | 0 |
| M8 | S7 | CL1 | Ad1 | H1 | PGMEA | PGME | CYH |
| | 100 | 20 | 3.0 | 0.1 | 50 | 10 | 40 |
| M9 | S8 | CL1 | Ad1 | H1 | PGMEA | PGME | CYH |
| | 100 | 20 | 3.0 | 0.1 | 70 | 30 | 0 |
| M10 | S9 | CL1 | Ad1 | H1 | PGMEA | PGME | CYH |
| | 100 | 20 | 3.0 | 0.1 | 70 | 30 | 0 |
| M11 | S10 | CL1 | Ad1 | H1 | PGMEA | PGME | CYH |
| | 100 | 20 | 3.0 | 0.1 | 70 | 30 | 0 |
| M12 | S11 | CL1 | Ad1 | H1 | PGMEA | PGME | CYH |
| | 100 | 20 | 3.0 | 0.1 | 70 | 30 | 0 |
| M13 | S12 | CL1 | Ad1 | H1 | PGMEA | PGME | CYH |
| | 100 | 20 | 3.0 | 0.1 | 70 | 30 | 0 |
| M14 | S13 | CL2 | Ad2 | H1 | PGMEA | PGME | CYH |
| | 100 | 20 | 3.0 | 0.1 | 70 | 30 | 0 |

**[Table 4-2]**

| | | | | | | | |
|---|---|---|---|---|---|---|---|
| M15 | S14 | CL1 | Ad1 | H1 | PGMEA | PGME | CYH |
| | 100 | 20 | 3.0 | 0.1 | 50 | 10 | 40 |
| M16 | S15 | CL1 | Ad1 | H1 | PGMEA | PGME | CYH |
| | 100 | 20 | 3.0 | 0.1 | 50 | 10 | 40 |
| M17 | S16 | CL1 | Ad1 | H1 | PGMEA | PGME | CYH |
| | 100 | 20 | 3.0 | 0.1 | 70 | 30 | 0 |
| M18 | S17 | CL1 | Ad1 | H1 | PGMEA | PGME | CYH |
| | 100 | 20 | 3.0 | 0.1 | 50 | 10 | 40 |
| M19 | S18 | CL1 | Ad1 | H1 | PGMEA | PGME | CYH |
| | 100 | 20 | 3.0 | 0.1 | 70 | 30 | 0 |
| M20 | S19 | CL1 | Ad1 | H1 | PGMEA | PGME | CYH |
| | 100 | 20 | 3.0 | 0.1 | 70 | 30 | 0 |
| M21 | S20 | CL1 | Ad1 | H1 | PGMEA | PGME | CYH |
| | 100 | 20 | 3.0 | 0.1 | 70 | 30 | 0 |
| M22 | S21 | CL1 | Ad1 | H1 | PGMEA | PGME | CYH |
| | 100 | 20 | 3.0 | 0.1 | 70 | 30 | 0 |
| M'1 | S'1 | - | - | H1 | PGMEA | PGME | CYH |
| | 100 | - | - | 0.1 | 60 | 0 | 40 |
| M'2 | S'2 | - | - | H1 | PGMEA | PGME | CYH |
| | 100 | - | - | 0.1 | 70 | 30 | 0 |
| M'3 | S'3 | - | - | H1 | PGMEA | PGME | CYH |
| | 100 | - | - | 0.1 | 70 | 30 | 0 |
| M'4 | S'4 | - | - | H1 | PGMEA | PGME | CYH |
| | 100 | - | - | 0.1 | 70 | 30 | 0 |
| M'5 | S'5 | - | - | H1 | PGMEA | PGME | CYH |
| | 100 | - | - | 0.1 | 60 | 0 | 40 |
| M'6 | S'6 | - | - | H1 | PGMEA | PGME | CYH |
| | 100 | - | - | 0.1 | 70 | 30 | 0 |
| M'7 | S'7 | - | - | H1 | PGMEA | PGME | CYH |
| | 100 | - | - | 0.1 | 70 | 30 | 0 |
| M'8 | S'8 | - | - | H1 | PGMEA | PGME | CYH |
| | 100 | - | - | 0.1 | 70 | 30 | 0 |

**[Table 4-3]**

| | | | | | | | |
|---|---|---|---|---|---|---|---|
| M'9 | S'9 | - | - | H1 | PGMEA | PGME | CYH |
| | 100 | - | - | 0.1 | 70 | 30 | 0 |
| Comparative M1 | SS1 | - | - | H1 | PGMEA | PGME | CYH |
| | 100 | - | - | 0.1 | 70 | 30 | 0 |
| Comparative M2 | SS2 | - | - | H1 | PGMEA | PGME | CYH |
| | 100 | - | - | 0.1 | 70 | 30 | 0 |
| Comparative M3 | SS1 | CL2 | Ad2 | H1 | PGMEA | PGME | CYH |
| | 100 | 20 | 3.0 | 0.1 | 70 | 30 | 0 |

### [Test for Elution to Resist Solvent (Composition containing a crosslinker and curing catalyst)]

The resist underlayer film materials were each applied by using a spin coater to a silicon wafer, and baked in the atmosphere at a predetermined temperature for a predetermined time shown in Table 5 to form a resist underlayer film with a film thickness of about 130 nm (Examples 1 to 22 and Comparative Example 3 in Table 5). The formed resist underlayer film was immersed in a mixed solvent of PGME/PGMEA=7/3, which was a common thinner, for 60 seconds, then spin-dried, and baked at 100°C for 30 seconds. Resistance to the solvent was confirmed by comparing the film thickness before and after immersion in the thinner. In addition, the above underlayer film materials were each applied by using ACT-8, manufactured by Tokyo Electron Ltd. to a silicon wafer, and baked in the nitrogen atmosphere at a predetermined temperature for a predetermined time shown in Table 5 to form a resist underlayer film with a film thickness of 130 nm. In the same manner as above, the formed resist underlayer film was immersed in a mixed solvent of PGME/PGMEA=7/3 for 60 seconds, then spin-dried, and baked at 100°C for 30 seconds. Resistance to the solvent was confirmed by comparing the film thickness before and after immersion in the thinner. A case where the decreasing rate in the film thickness before and after the immersion in the thinner was the same as that of Comparative Example 3 was graded as "o", and a case where the decreasing rate was larger than that of Comparative Example 3 was graded as "×" (Table 5). If the decreasing rate was equivalent to that of Comparative Example 3, the resist underlayer film can be used in the same way as a normal resist underlayer film.

### [Table 5]

**(Table 5)**

| Example / Comparative Example | Composition | Baking temperature | Solvent resistance under air | Baking temperature | Solvent resistance under nitrogen |
|---|---|---|---|---|---|
| Example 1 | M1 | 400°C/60 seconds | ○ | 400°C/60 seconds | ○ |
| Example 2 | M2 | 400°C/60 seconds | ○ | 400°C/60 seconds | ○ |
| Example 3 | M3 | 400°C/60 seconds | ○ | 400°C/60 seconds | ○ |
| Example 4 | M4 | 400°C/60 seconds | ○ | 400°C/60 seconds | ○ |
| Example 5 | M5 | 400°C/60 seconds | ○ | 400°C/60 seconds | ○ |
| Example 6 | M6 | 400°C/60 seconds | ○ | 400°C/60 seconds | ○ |
| Example 7 | M7 | 400°C/60 seconds | ○ | 400°C/60 seconds | ○ |
| Example 8 | M8 | 400°C/60 seconds | ○ | 400°C/60 seconds | ○ |
| Example 9 | M9 | 400°C/60 seconds | ○ | 400°C/60 seconds | ○ |
| Example 10 | M10 | 400°C/60 seconds | ○ | 400°C/60 seconds | ○ |
| Example 11 | M11 | 400°C/60 seconds | ○ | 400°C/60 seconds | ○ |
| Example 12 | M12 | 400°C/60 seconds | ○ | 400°C/60 seconds | ○ |
| Example 13 | M13 | 400°C/60 seconds | ○ | 400°C/60 seconds | ○ |
| Example 14 | M14 | 400°C/60 seconds | ○ | 400°C/60 seconds | ○ |
| Example 15 | M15 | 400°C/60 seconds | ○ | 400°C/60 seconds | ○ |
| Example 16 | M16 | 400°C/60 seconds | ○ | 400°C/60 seconds | ○ |
| Example 17 | M17 | 400°C/60 seconds | ○ | 400°C/60 seconds | ○ |
| Example 18 | M18 | 400°C/60 seconds | ○ | 400°C/60 seconds | ○ |
| Example 19 | M19 | 400°C/60 seconds | ○ | 400°C/60 seconds | ○ |
| Example 20 | M20 | 400°C/60 seconds | ○ | 400°C/60 seconds | ○ |
| Example 21 | M21 | 400°C/60 seconds | ○ | 400°C/60 seconds | ○ |
| Example 22 | M22 | 400°C/60 seconds | ○ | 400°C/60 seconds | ○ |
| Comparative Example 3 | Comparative M3 | 400°C/60 seconds | ○ | 400°C/60 seconds | ○ |

### [Test for Elution to Resist Solvent (Composition containing no crosslinker and curing catalyst)]

The resist underlayer film materials were each applied by using a spin coater to a silicon wafer, and baked in the atmosphere at a predetermined temperature for a predetermined time shown in Table 6 to form a resist underlayer film with a film thickness of about 130 nm (Examples 23 to 31 and Comparative Examples 1 to 2 in Table 6). The formed resist underlayer film was immersed in a mixed solvent of PGME/PGMEA=7/3, which was a common thinner, for 60 seconds, then spin-dried, and baked at 100°C for 30 seconds. Resistance to the solvent was confirmed by comparing the film thickness before and after immersion in the thinner. In addition, the above underlayer film materials were each applied by using ACT-8, manufactured by Tokyo Electron Ltd. to a silicon wafer, and baked in the nitrogen atmosphere at a predetermined temperature for a predetermined time shown in Table 6 to form a resist underlayer film with a film thickness of 130 nm. In the same manner as above, the formed resist underlayer film was immersed in a mixed solvent of PGME/PGMEA=7/3 for 60 seconds, then spin-dried, and baked at 100°C for 30 seconds. Resistance to the solvent was confirmed by comparing the film thickness before and after immersion in the thinner. A case where the decreasing rate in the film thickness before and after the immersion in the thinner was smaller than that of Comparative Example 2 was graded as "o", and a case where the decreasing rate was the same as or larger than that of Comparative Example 2 was graded as "×" (Table 6).

### [Table 6]

**(Table 6)**

| Example / Comparative Example | Composition | Baking temperature | Solvent resistance under air | Baking temperature | Solvent resistance under nitrogen |
|---|---|---|---|---|---|
| Example 23 | M'1 | 400°C/60 seconds | ○ | 400°C/60 seconds | ○ |
| Example 24 | M'2 | 400°C/60 seconds | ○ | 400°C/60 seconds | ○ |
| Example 25 | M'3 | 400°C/60 seconds | ○ | 400°C/60 seconds | ○ |
| Example 26 | M'4 | 400°C/60 seconds | ○ | 400°C/60 seconds | ○ |
| Example 27 | M'5 | 400°C/60 seconds | ○ | 400°C/60 seconds | ○ |
| Example 28 | M'6 | 400°C/60 seconds | ○ | 400°C/60 seconds | ○ |
| Example 29 | M'7 | 400°C/60 seconds | ○ | 400°C/60 seconds | ○ |
| Example 30 | M'8 | 400°C/60 seconds | ○ | 400°C/60 seconds | ○ |
| Example 31 | M'9 | 400°C/60 seconds | ○ | 400°C/60 seconds | ○ |
| Comparative Example 1 | Comparative M1 | 400°C/60 seconds | ○ | 400°C/60 seconds | × |
| Comparative | Comparative | 400°C/60 seconds | × | 400°C/60 seconds | × |
| Example 2 | M2 | | | | |

From Tables 5 and 6, it can be seen that the normal resist underlayer film does not exhibit solvent resistance under baking conditions in a nitrogen atmosphere when it does not contain a crosslinker and a curing catalyst (Comparative Examples 1-2). On the other hand, the resist underlayer film into which the propargyl group is introduced (Examples 23-31) has self-crosslinking properties, so that even if it does not contain a crosslinker and a curing catalyst, it can obtain solvent resistance not only under baking conditions in an air atmosphere but also under those in a nitrogen atmosphere. In addition, the resist underlayer film (Examples 1-22) using a polymer without a propargyl group can also be cured under any atmosphere, in the same way as the normal resist underlayer film (Comparative Example 3), by using a crosslinker agent and a curing catalyst. Note that Comparative Example 2 cannot be used as a resist underlayer film because it does not obtain solvent resistance under the general baking conditions, that is, under those in an air atmosphere. Therefore, it was excluded from the following evaluations.

### [Etching rate measurement]

The resist underlayer film materials were each applied by using a spin coater to a silicon wafer (Examples 1 to 31 and Comparative Examples 1 and 3 in Table 7). The resultant coatings were baked on a hot plate at a predetermined temperature for a predetermined time shown in Table 7 to form a resist underlayer film with a film thickness of 130 nm. Dry etching rates were measured using O₂/N₂ gas or CF₄ gas as an etching gas. The etching rate was confirmed by comparing the film thickness before and after the etching process. A case where the etching rate was slower than that of any of Comparative Examples 1 and 3 was graded as "∘", and a case where the etching rate was faster than that of any of Comparative Examples 1 and 3 was graded as "×" (Table 7).

The etching measurement involved the following etcher and etching gases:

| | |
|---|---|
| RIE-200NL (manufactured by Samco Inc.): CF₄ | 50 sccm |
| RIE-200NL (manufactured by Samco Inc.): O₂/N₂ | 10 sccm/200 sccm |

### [Optical constant measurement]

The resist underlayer film materials of M1 to M22, M'1 to M'9 and Comparative M1 and M3 were each applied by using a spin coater to a silicon wafer (Examples 1 to 31 and Comparative Examples 1 and 3 in Table 7). The resultant coatings were baked on a hot plate at a predetermined temperature for a predetermined time shown in Table 7 to form a resist underlayer film (with a film thickness of 50 nm). These resist underlayer films were analyzed with a spectroscopic ellipsometer to measure the refractive index (n value) and the optical absorption coefficient (k value, also called the attenuation coefficient) at a wavelength of 193 nm (Table 7).

### [Coating properties measurement]

The resist underlayer film materials of M1 to M22, M'1 to M'9 and Comparative M1 and M3 were each applied by using a 12-inch coater, manufactured by Tokyo Electron Ltd., to a silicon wafer (Examples 1 to 31 and Comparative Examples 1 and 3 in Table 7). The resultant coatings were baked in the atmosphere at a predetermined temperature for a predetermined time shown in Table 7 to form a resist underlayer film with a film thickness of 130 nm. For the formed resist underlayer film, the film thickness of the entire wafer was measured at 49 points on a circumference to evaluate uniformity of the in-plane film thickness of the wafer. A case where a ratio of the variation of the film thickness (the maximum film thickness - the minimum film thickness) to the average film thickness was smaller than that in any of Comparative Examples 1 and 3 was graded as "∘", and a case where the ratio of the variation was larger than that in any of Comparative Examples 1 and 3 was graded as "×". Note that a smaller ratio of the variation in the film thickness means higher uniformity of the in-plane film thickness of the wafer (Table 7).

**[Table 7-1]**

| (Table 7) | | | | | | |
|---|---|---|---|---|---|---|
| Example / Comparative Example | Composition | Baking temperature | Etching resistance | | n/k @193 nm | Uniformity of film thickness |
| | | | CF₄ | O₂/N₂ | | |
| Example 1 | M1 | 400°C/60 seconds | ○ | ○ | 1.45/0.61 | ○ |
| Example 2 | M2 | 400°C/60 seconds | ○ | ○ | 1.45/0.60 | ○ |
| Example 3 | M3 | 400°C/60 seconds | ○ | ○ | 1.42/0.59 | ○ |
| Example 4 | M4 | 400°C/60 seconds | ○ | ○ | 1.42/0.59 | ○ |
| Example 5 | M5 | 400°C/60 seconds | ○ | ○ | 1.41/0.56 | ○ |
| Example 6 | M6 | 400°C/60 seconds | ○ | ○ | 1.40/0.57 | ○ |
| Example 7 | M7 | 400°C/60 seconds | ○ | ○ | 1.40/0.56 | ○ |
| Example 8 | M8 | 400°C/60 seconds | ○ | ○ | 1.42/0.59 | ○ |
| Example 9 | M9 | 400°C/60 seconds | ○ | ○ | 1.44/0.60 | ○ |
| Example 10 | M10 | 400°C/60 seconds | ○ | ○ | 1.43/0.57 | ○ |
| Example 11 | M11 | 400°C/60 seconds | ○ | ○ | 1.45/0.59 | ○ |
| Example 12 | M12 | 400°C/60 seconds | ○ | ○ | 1.44/0.57 | ○ |
| Example 13 | M13 | 400°C/60 seconds | ○ | ○ | 1.42/0.58 | ○ |
| Example 14 | M14 | 400°C/60 seconds | ○ | ○ | 1.43/0.59 | ○ |
| Example 15 | M15 | 400°C/60 seconds | ○ | ○ | 1.45/0.59 | ○ |
| Example 16 | M16 | 400°C/60 seconds | ○ | ○ | 1.44/0.53 | ○ |
| Example 17 | M17 | 400°C/60 seconds | ○ | ○ | 1.49/0.62 | ○ |
| Example 18 | M18 | 400°C/60 seconds | ○ | ○ | 1.45/0.57 | ○ |
| Example 19 | M19 | 400°C/60 seconds | ○ | ○ | 1.44/0.55 | ○ |
| Example 20 | M20 | 400°C/60 seconds | ○ | ○ | 1.50/0.49 | ○ |
| Example 21 | M21 | 400°C/60 seconds | ○ | ○ | 1.45/0.58 | ○ |
| Example 22 | M22 | 400°C/60 seconds | ○ | ○ | 1.45/0.60 | ○ |
| Example 23 | M'1 | 400°C/60 seconds | ○ | ○ | 1.46/0.59 | ○ |
| Example 24 | M'2 | 400°C/60 seconds | ○ | ○ | 1.45/0.62 | ○ |
| Example 25 | M'3 | 400°C/60 seconds | ○ | ○ | 1.44/0.58 | ○ |
| Example 26 | M'4 | 400°C/60 seconds | ○ | ○ | 1.43/0.57 | ○ |
| Example 27 | M'5 | 400°C/60 seconds | ○ | ○ | 1.44/0.60 | ○ |
| Example 28 | M'6 | 400°C/60 seconds | ○ | ○ | 1.46/0.60 | ○ |

**[Table 7-2]**

| | | | | | | |
|---|---|---|---|---|---|---|
| Example 29 | M'7 | 400°C/60 seconds | ○ | ○ | 1.45/0.60 | ○ |
| Example 30 | M'8 | 400°C/60 seconds | ○ | ○ | 1.45/0.57 | ○ |
| Example 31 | M'9 | 400°C/60 seconds | ○ | ○ | 1.45/0.56 | ○ |
| Comparative Example 1 | Comparative M1 | 400°C/60 seconds | × | × | 1.42/0.50 | × |
| Comparative Example 3 | Comparative M3 | 400°C/60 seconds | × | × | 1.46/0.49 | × |

### [Measurement of sublimates amount]

The amount of sublimates was measured using the sublimate amount measuring apparatus described in WO 2007/111147 A1. The resist underlayer film materials were each prepared so that the film thickness would be 130 nm after baking at 400°C for 60 seconds (Examples 1 to 3, 5 to 14, 16 to 17 and 19 to 31 and Comparative Examples 1 and 3). The resultant compositions were applied to a silicon wafer, and each of the amount of sublimates during baking at 300°C was measured. A case where the amount of sublimates was less than that in any of Comparative Examples 1 and 3 was graded as "∘", and a case where the amount of sublimates was more than that in any of Comparative Examples 1 and 3 was graded as "×" (Table 8).

### [Table 8]

**(Table 8)**

| Example / Comparative Example | Composition | Baking temperature | Amount of sublimates |
|---|---|---|---|
| Example 1 | M1 | 300°C/60 seconds | ○ |
| Example 2 | M2 | 300°C/60 seconds | ○ |
| Example 3 | M3 | 300°C/60 seconds | ○ |
| Example 5 | M5 | 300°C/60 seconds | ○ |
| Example 6 | M6 | 300°C/60 seconds | ○ |
| Example 7 | M7 | 300°C/60 seconds | ○ |
| Example 8 | M8 | 300°C/60 seconds | ○ |
| Example 9 | M9 | 300°C/60 seconds | ○ |
| Example 10 | M10 | 300°C/60 seconds | ○ |
| Example 11 | M11 | 300°C/60 seconds | ○ |
| Example 12 | M12 | 300°C/60 seconds | ○ |
| Example 13 | M13 | 300°C/60 seconds | ○ |
| Example 14 | M14 | 300°C/60 seconds | ○ |
| Example 16 | M16 | 300°C/60 seconds | ○ |
| Example 17 | M17 | 300°C/60 seconds | ○ |
| Example 19 | M19 | 300°C/60 seconds | ○ |
| Example 20 | M20 | 300°C/60 seconds | ○ |
| Example 21 | M21 | 300°C/60 seconds | ○ |
| Example 22 | M22 | 300°C/60 seconds | ○ |
| Example 23 | M'1 | 300°C/60 seconds | ○ |
| Example 24 | M'2 | 300°C/60 seconds | ○ |
| Example 25 | M'3 | 300°C/60 seconds | ○ |
| Example 26 | M'4 | 300°C/60 seconds | ○ |
| Example 27 | M'5 | 300°C/60 seconds | ○ |
| Example 28 | M'6 | 300°C/60 seconds | ○ |
| Example 29 | M'7 | 300°C/60 seconds | ○ |
| Example 30 | M'8 | 300°C/60 seconds | ○ |
| Example 31 | M'9 | 300°C/60 seconds | ○ |
| Comparative Example 1 | Comparative M1 | 300°C/60 seconds | × |
| Comparative Example 3 | Comparative M3 | 300°C/60 seconds | × |

### [Test of coating properties and covering performance on stepped substrates]

A 200 nm thick SiO₂ substrate was used as a coating test for a stepped substrate. In the case of a stepped substrate, the coating properties of the resist underlayer film may be worse comparing to a silicon wafer without steps. Therefore, a test was conducted to see if the resist underlayer film could be coated evenly on the stepped substrate. A case where it could be coated evenly in checking visually was graded as "∘".

The flattening properties were evaluated in a wide trench area with a trench width of 800 nm present in the above substrate. The coating thickness of the wide trench area was compared with that of an area (an open area) where no pattern was formed. After coating each resist underlayer film material on the above substrate, the resultant coatings were baked on a hot plate at a predetermined temperature for a predetermined time shown in Table 9 to form a resist underlayer film with a film thickness of 130 nm (Examples 1 to 31 and Comparative Example 3 in Table 9). These substrates were observed using a scanning electron microscope (S-4800) manufactured by Hitachi High-Tech Corporation to evaluate the flattening properties, by measuring the film thickness difference between the wide trench area (the patterned area) and the open area (the pattern-free area) of the stepped substrate (the coating step between the wide trench area and the open area, which is called a bias). Here, good flattening properties mean that there is a small difference in the film thickness of the coating present on the upper part between the part where the pattern is present and the part where the pattern is not present. A case where the bias was improved compared to Comparative Example 3 was graded as "∘", and a case where the bias was not improved was graded as "×" (Table 9).

**[Table 9-1]**

| (Table 9) | | | | | | |
|---|---|---|---|---|---|---|
| Example / Comparative Example | Composition | Film thickness | Baking temperature | Type of substrate | Stepped substrate coatability | Flattening properties |
| Example 1 | M1 | 130 nm | 400°C/60 seconds | SiO₂ | ○ | ○ |
| Example 2 | M2 | 130 nm | 400°C/60 seconds | SiO₂ | ○ | ○ |
| Example 3 | M3 | 130 nm | 400°C/60 seconds | SiO₂ | ○ | ○ |
| Example 4 | M4 | 130 nm | 400°C/60 seconds | SiO₂ | ○ | ○ |
| Example 5 | M5 | 130 nm | 400°C/60 seconds | SiO₂ | ○ | ○ |
| Example 6 | M6 | 130 nm | 400°C/60 seconds | SiO₂ | ○ | ○ |
| Example 7 | M7 | 130 nm | 400°C/60 seconds | SiO₂ | ○ | ○ |
| Example 8 | M8 | 130 nm | 400°C/60 seconds | SiO₂ | ○ | ○ |
| Example 9 | M9 | 130 nm | 400°C/60 seconds | SiO₂ | ○ | ○ |
| Example 10 | M10 | 130 nm | 400°C/60 seconds | SiO₂ | ○ | ○ |
| Example 11 | M11 | 130 nm | 400°C/60 seconds | SiO₂ | ○ | ○ |
| Example 12 | M12 | 130 nm | 400°C/60 seconds | SiO₂ | ○ | ○ |
| Example 13 | M13 | 130 nm | 400°C/60 seconds | SiO₂ | ○ | ○ |
| Example 14 | M14 | 130 nm | 400°C/60 seconds | SiO₂ | ○ | ○ |
| Example 15 | M15 | 130 nm | 400°C/60 seconds | SiO₂ | ○ | ○ |
| Example 16 | M16 | 130 nm | 400°C/60 seconds | SiO₂ | ○ | ○ |
| Example 17 | M17 | 130 nm | 400°C/60 seconds | SiO₂ | ○ | ○ |
| Example 18 | M18 | 130 nm | 400°C/60 seconds | SiO₂ | ○ | ○ |
| Example 19 | M19 | 130 nm | 400°C/60 seconds | SiO₂ | ○ | ○ |
| Example 20 | M20 | 130 nm | 400°C/60 seconds | SiO₂ | ○ | ○ |
| Example 21 | M21 | 130 nm | 400°C/60 seconds | SiO₂ | ○ | ○ |
| Example 22 | M22 | 130 nm | 400°C/60 seconds | SiO₂ | ○ | ○ |
| Example 23 | M'1 | 130 nm | 400°C/60 seconds | SiO₂ | ○ | ○ |
| Example 24 | M'2 | 130 nm | 400°C/60 seconds | SiO₂ | ○ | ○ |
| Example 25 | M'3 | 130 nm | 400°C/60 seconds | SiO₂ | ○ | ○ |
| Example 26 | M'4 | 130 nm | 400°C/60 seconds | SiO₂ | ○ | ○ |
| Example 27 | M'5 | 130 nm | 400°C/60 seconds | SiO₂ | ○ | ○ |
| Example 28 | M'6 | 130 nm | 400°C/60 seconds | SiO₂ | ○ | ○ |

**[Table 9-2]**

| | | | | | | |
|---|---|---|---|---|---|---|
| Example 29 | M'7 | 130 nm | 400°C/60 seconds | SiO₂ | ○ | ○ |
| Example 30 | M'8 | 130 nm | 400°C/60 seconds | SiO₂ | ○ | ○ |
| Example 31 | M'9 | 130 nm | 400°C/60 seconds | SiO₂ | ○ | ○ |
| Comparative Example 3 | Comparative M1 | 130 nm | 400°C/60 seconds | SiO₂ | ○ | × |

As described above, the novolac resin having a unit structure derived from a compound of the formula (A0) containing fluorene and indole skeletons has high heat resistance, so the amount of sublimates during baking is small, and it can suppress equipment contamination, and can be said to be a material with a small process load. In addition, in-plane uniformity of film thickness when it was applied to a silicon wafer without steps is not only very high, but also it also shows good coating properties on a stepped substrate having a deposited film. Furthermore, it has high etching resistance and good flattening properties, and by changing the monomer during polymer synthesis, it can be adjusted to an optical constant that can suppress reflection during exposure depending on the device. A self-crosslinking group such as an alkynyl group including a propargyl group can also be introduced onto the nitrogen atom in the novolac resin having a unit structure derived from a compound of the formula (A0) containing fluorene and indole skeletons, which allows it to be used as a resist underlayer film under air and nitrogen atmospheres without the need for a crosslinker or curing catalyst, making it a material that can be applied to a wider range of processes than before. Of course, the introduction of a self-crosslinking group such as an alkynyl group including a propargyl group does not impair the properties of the novolac resin having a unit structure derived from a compound of the formula (A0) containing fluorene and indole skeletons described above. Therefore, the novolac resin according to the present invention is expected to be a material that can be widely applied to diversifying semiconductor manufacturing processes.

## Claims

1. A resist underlayer film-forming composition comprising:
a novolac resin and a solvent,
the novolac resin comprises a unit structure A having an aromatic ring,
the unit structure A comprises a unit structure derived from a compound represented by the following formula (A0): 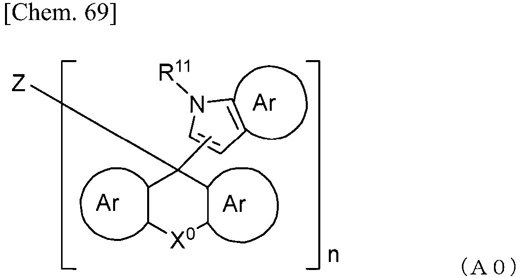
in the formulae (A0),
R¹¹ each independently represents:
(i) a hydrogen atom or a methylol group;
(ii) an aryl group having 6 to 30 carbon atoms; or
(iii) a linear, branched, or cyclic alkoxymethyl group having 2 to 20 carbon atoms; a linear, branched, or cyclic alkyl group having 1 to 20 carbon atoms; an alkenyl group having 2 to 10 carbon atoms; or an alkynyl group having 2 to 10 carbon atoms,
provided in the (ii) and (iii), a hydrogen atom in these groups is optionally further substituted with an oxygen-atom-containing substituent, a sulfur-atom-containing substituent, a nitrogen-atom-containing substituent, an aryl group, or a halo group, and in the (iii), a hydrocarbon chain moiety is optionally further interrupted by an oxygen-atom-containing substituent, a sulfur-atom-containing substituent, a nitrogen-atom-containing substituent, or an arylene group,
Ar is an aromatic ring moiety constituting a condensed ring, each of which is independently the same or different and comprises 1 to 3 benzene rings in the basic skeleton of the aromatic ring moiety, and may optionally have a substituent,
X⁰ represents a single bond, -O-, -S-, -NR¹²- or -CR¹³R¹⁴-, R¹² is the same as or different from R¹¹, and is the same as the definition of R¹¹, and R¹³ and R¹⁴ each independently represent a hydrogen atom, or a hydrocarbon group having 1 to 6 carbon atoms,
n is 1 or 2
when n is 1, Z represents a monovalent organic group, and when n is 2, Z represents a divalent organic group.

2. The resist underlayer film-forming composition according to claim 1, wherein the formula (A0) is represented by the following formula (A01): 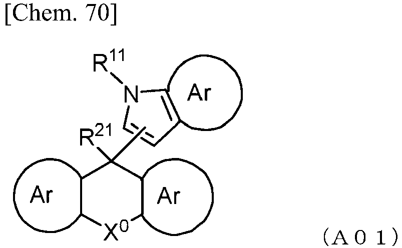
in the formula (A01), R¹¹, Ar and X⁰ are the same as defined in claim 1,
R²¹ is an aryl group having 6 to 30 carbon atoms; an alkenyl group having 2 to 10 carbon atoms; or an alkynyl group having 2 to 10 carbon atoms.

3. The resist underlayer film-forming composition according to claim 1, wherein the Ar and the pyrrole ring moiety in the formula (A0) is optionally substituted with:
(iv) a hydroxy group, a nitro group, a cyano group, a carboxyl group, a trifluoromethyl group, an amino group, a monosubstituted amino group, a disubstituted amino group, or a halo group;
(v) an aryloxy group having 6 to 15 carbon atoms; an arylalkoxy carbonyl group having 8 to 15 carbon atoms; an aryloxycarbonyl group having 7 to 15 carbon atoms; or an aryl group having 6 to 30 carbon atoms, or
(vi) an acyl group having 1 to 15 carbon atoms; an alkoxy group having 1 to 15 carbon atoms; an arylalkoxy group having 7 to 15 carbon atoms; an alkoxycarbonyl group having 1 to 15 carbon atoms; a linear, branched, or cyclic alkyl group having 1 to 10 carbon atoms; an alkenyl group having 2 to 20 carbon atoms; or an alkynyl group having 2 to 10 carbon atoms,
provided in the (v) and (vi), a hydrogen atom in these groups is optionally further substituted with an oxygen-atom-containing substituent, a sulfur-atom-containing substituent, a nitrogen-atom-containing substituent, an aryl group, or a halo group, and in the (vi), a hydrocarbon chain moiety is optionally further interrupted by an oxygen-atom-containing substituent, a sulfur-atom-containing substituent, a nitrogen-atom-containing substituent, or an arylene group.

4. The resist underlayer film-forming composition according to claim 1, wherein the novolac resin has a composite unit structure A-B represented by the following formula (AB): 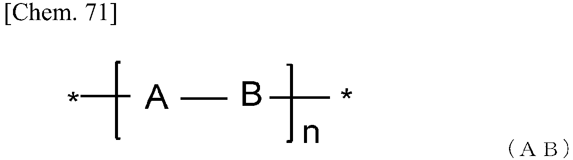 in the formula (AB),
"n" represents a number of the composite unit structure A-B,
a unit structure A has a unit structure derived from a compound represented by the formula (A0) defined in claim 1,
a unit structure B has one or more unit structures having a structure represented by the following formula (B1), (B2), or (B3), and
"*" represents a bonding site, 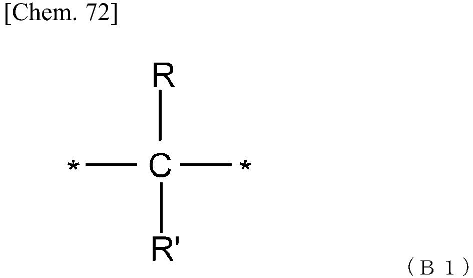
in the formula (B1),
R and R' each independently represent a hydrogen atom, an aromatic ring residue having 6 to 30 carbon atoms and optionally having a substituent; a heteroring residue having 3 to 30 carbon atoms and optionally having a substituent; or a linear, branched, or cyclic alkyl group having 10 or less carbon atoms and optionally having a substituent and
"*" represents a bonding site,
[Chem. 73]
_{*}- J¹- Z⁰ -J²- _{*} (B 2)
in the formula (B2),
Z⁰ represents an aromatic ring residue or an aliphatic ring residue having 6 to 30 carbon atoms and optionally having a substituent; or an organic group in which two aromatic ring residues or aliphatic ring residues are linked via a single bond,
J¹ and J² each independently represent a direct bond or a divalent organic group optionally having a substituent, and
"*" represents a bonding site, 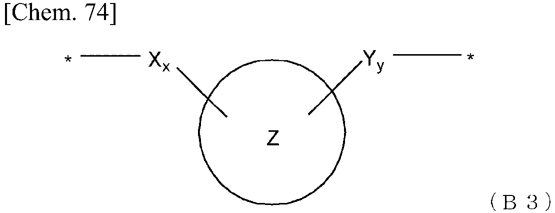
in the formula (B3),
Z represents a single ring or a bicyclic, tricyclic, or tetracyclic condensed ring having 4 to 25 carbon atoms and optionally having a substituent, the single ring being a non-aromatic single ring; at least one single ring constituting the bicyclic, tricyclic, or tetracyclic rings is a non-aromatic single ring while the other single ring or rings may be an aromatic single ring or a non-aromatic single ring; the single ring or the bicyclic, tricyclic, or tetracyclic condensed ring may further form a condensed ring with one or more aromatic rings to form a penta- or higher-cyclic condensed ring,
X and Y are the same or different from each other and represent a - CR³¹R³²- group, R³¹ and R³² are the same or different from each other and represent a hydrogen atom or a hydrocarbon group having 1 to 6 carbon atoms, and
"x" and "y" respectively represent numbers of X and Y, and each independently represent 0 or 1,
[Chem. 75] *-Xₓ
is bonded to any one carbon atom of the non-aromatic single ring of Z (when x=1), which is referred to as a "carbon atom 1", or extends from the carbon atom 1 (when x=0),
[Chem. 76] Y_{y}-_{*}
is bonded to any one carbon atom of the non-aromatic single ring of Z (when y=1), which is referred to as a "carbon atom 2", or extends from the carbon atom 2 (when y=0),
the carbon atom 1 and the carbon atom 2 may be identical or different from each other, and when the carbon atom 1 and the carbon atom 2 are different, the carbon atom 1 and the carbon atom 2 may be contained in an identical non-aromatic single ring or may be contained in different non-aromatic single rings, and
"*" represents a bonding site.

5. The resist underlayer film-forming composition according to claim 1, wherein when all the X⁰ are a single bond, -O-, -S- or -CR¹³R¹⁴-, at least a part of R¹¹; and when at least one X⁰ is -NR¹²-, at least a part of R¹¹ and R¹²; is the following alkynyl group: 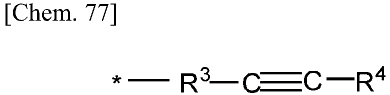 wherein "*" represents a bonding site,
R³ represents a single bond or a divalent organic group having 1 to 20 carbon atoms, and
R⁴ represents a hydrogen atom or a monovalent organic group having 1 to 20 carbon atoms.

6. The resist underlayer film-forming composition according to claim 1, wherein the solvent contains a solvent having a boiling point of 160°C or higher.

7. The resist underlayer film-forming composition according to claim 1, further comprising an acid and/or a salt thereof, and/or an acid generator.

8. The resist underlayer film-forming composition according to claim 1, further comprising a crosslinker.

9. The resist underlayer film-forming composition according to claim 8, wherein the crosslinker is an aminoplast crosslinker or a phenoplast crosslinker.

10. The resist underlayer film-forming composition according to claim 1, further comprising a surfactant.

11. A resist underlayer film on a semiconductor substrate, wherein the resist underlayer film is a baked product of a coating film comprising the resist underlayer film-forming composition according to any one of claims 1 to 10.

12. A method for forming a resist pattern used for manufacturing a semiconductor, the method comprising: a step of applying the resist underlayer film-forming composition according to any one of claims 1 to 10 onto a semiconductor substrate; and a step of then baking the composition to form a resist underlayer film.

13. A method for manufacturing a semiconductor device, the method comprising:
a step of forming a resist underlayer film from the resist underlayer film-forming composition according to claim 1 on a semiconductor substrate;
a step of forming a resist film on the resist underlayer film;
a step of forming a resist pattern in the resist film by irradiation with light or electron beam and development;
a step of etching the resist underlayer film through the resist pattern; and
a step of processing the semiconductor substrate through the patterned resist underlayer film.

14. A method for manufacturing a semiconductor device, the method comprising:
a step of forming a resist underlayer film from the resist underlayer film-forming composition according to claim 1 on a semiconductor substrate;
a step of forming a hard mask on the resist underlayer film;
a step of forming a resist film on the hard mask;
a step of forming a resist pattern in the resist film by irradiation with light or electron beam and development;
a step of etching the hard mask through the resist pattern;
a step of etching the resist underlayer film through the patterned hard mask; and
a step of processing the semiconductor substrate through the patterned resist underlayer film.

15. A method for manufacturing a semiconductor device, the method comprising:
a step of forming a resist underlayer film from the resist underlayer film-forming composition according to claim 1 on a semiconductor substrate;
a step of forming a hard mask on the resist underlayer film;
a step of forming a resist film on the hard mask;
a step of forming a resist pattern in the resist film by irradiation with light or electron beam and development;
a step of etching the hard mask through the resist pattern;
a step of etching the resist underlayer film through the patterned hard mask;
a step of removing the hard mask; and
a step of processing the semiconductor substrate through the patterned resist underlayer film.

16. A method for manufacturing a semiconductor device, the method comprising:
a step of forming a resist underlayer film from the resist underlayer film-forming composition according to claim 1 on a semiconductor substrate;
a step of forming a hard mask on the resist underlayer film;
a step of forming a resist film on the hard mask;
a step of forming a resist pattern in the resist film by irradiation with light or electron beam and development;
a step of etching the hard mask through the resist pattern;
a step of etching the resist underlayer film through the patterned hard mask;
a step of removing the hard mask;
a step of forming a deposited film (a spacer) on the resist underlayer film cleaned of the hard mask;
a step of processing the deposited film (the spacer) by etching;
a step of removing the resist underlayer film having been patterned while leaving the deposited film (the spacer) having been patterned; and
a step of processing the semiconductor substrate through the deposited film (the spacer) having been patterned.

17. The method for manufacturing a semiconductor device according to any one of claims 14 to 16, wherein the hard mask is formed by applying a composition comprising an inorganic substance or by depositing an inorganic substance.

18. The method for manufacturing a semiconductor device according to any one of claims 13 to 16, wherein the step of forming a resist pattern in the resist film is performed by a nanoimprinting method or a directed self-assembly method.

19. The method for manufacturing a semiconductor device according to claim 15 or 16, wherein the hard mask is removed by etching or with an alkaline chemical solution.
